# EUROPEAN PATENT APPLICATION

(11) **EP 4 827 021 A1**
(43) Date of publication of application: **21.10.2026**
(21) Application number: 24910591.7
(22) Date of filing: 04.12.2024
(51) Int. Cl.: H04L 1/00, H03M 13/11

(54) **CODING METHOD AND APPARATUS, AND DECODING METHOD AND APPARATUS**

(30) Priority: 25.12.2023 CN 202311805346; 17.06.2024 CN 202410787720
(71) Applicant: Huawei Technologies Co., Ltd., Shenzhen, Guangdong 518129 (CN)
(72) Inventor: LIN, Wei, Shenzhen, Guangdong 518129 (CN); MONTORSI, Guido, 10131 (IT); BENEDETTO, Sergio, 10122 (IT); GAN, Ming, Shenzhen, Guangdong 518129 (CN); XIN, Yan, Shenzhen, Guangdong 518129 (CN)
(74) Representative: Huawei European IPR
(86) International application number: PCT/CN2024/136771
(87) International publication number: WO 2025/139659

(57) **Abstract**

An encoding method, a decoding method, and an apparatus are provided, allowing for support of a next-generation Wi-Fi protocol of IEEE 802.11ax (for example, 802.11be, Wi-Fi 7, or EHT), a next-generation Wi-Fi protocol of IEEE 802.11be (for example, 802.11bn, Wi-Fi 8, or UHR), Wi-Fi AI, a millimeter wave (MMW), an ultra-wideband (UWB), sensing, or the like. After obtaining an information bit sequence, a first communication apparatus performs LDPC encoding on the information bit sequence based on a parity-check matrix to obtain an encoded sequence, and outputs the sequence. A length of the sequence is N₁, Ni is n times 1944, and n is an integer greater than or equal to 2. Z of the parity-check matrix may be equal to 81. After obtaining to-be-decoded information, a second communication apparatus performs LDPC decoding based on the parity-check matrix to obtain the information bit sequence. The method can improve decoding performance.

## Description

This application claims priorities to Chinese Patent Application No. 202311805346.4, filed with the China National Intellectual Property Administration on December 25, 2023 and entitled "ENCODING METHOD, DECODING METHOD, AND APPARATUS", and to Chinese Patent Application No. 202410787720.0, filed with the China National Intellectual Property Administration on June 17, 2024 and entitled "ENCODING METHOD, DECODING METHOD, AND APPARATUS", both of which are incorporated herein by reference in their entireties.

### TECHNICAL FIELD

This application relates to the field of communication technologies, and in particular, to an encoding method, a decoding method, and an apparatus.

### BACKGROUND

Transmission standards of wireless local area networks (wireless local area network, WLAN) such as Institute of Electrical and Electronics Engineers (Institute of Electrical and Electronics Engineers) 802.11n/ac/ax/be mainly study improvements in user experience in a large bandwidth (for example, 60 gigahertz (GHz)) scenario, including increasing an average user throughput and improving energy usage efficiency of battery-powered devices. In a large bandwidth scenario, high-speed and reliable transmission of services such as data and videos on limited frequency and power resources needs to be supported. Therefore, a highly reliable and efficient channel encoding/decoding scheme is required.

In the field of channel encoding, concatenated code (such as Turbo code) and low-density parity-check (low-density parity-check, LDPC) code are two most mature and widely used channel encoding methods currently, and both have performance close to the Shannon (Shannon) limit. Compared with the concatenated code, the LDPC code may have the following advantages: Good bit error performance can be obtained without a deep interleaver; better frame error rate performance is provided; an error floor is greatly reduced; decoding is not based on a trellis; and parallel decoding is supported, a decoding latency is low, and the like. Therefore, the LDPC code has become a standard channel encoding scheme for low-frequency short-distance WLAN communication systems such as IEEE 802.11n/ac/ax.

How to further improve decoding performance of the LDPC code needs to be urgently resolved.

### SUMMARY

Embodiments of this application provide an encoding method, a decoding method, and an apparatus, to support an LDPC code with a longer code length, and improve decoding performance.

According to a first aspect, an embodiment of this application provides an encoding method. The method is applied to a first communication apparatus, the first communication apparatus includes a Wi-Fi device, or a Wi-Fi chip, a functional module, or the like that is disposed in the Wi-Fi device, and the method includes:
obtaining an information bit sequence; performing low-density parity-check LDPC encoding on the information bit sequence based on a parity-check matrix to obtain an encoded sequence, where a length of the encoded sequence is N₁, N₁ is n times 1944, n is an integer greater than or equal to 2, and the parity-check matrix has an expansion factor Z=81; and outputting the encoded sequence.

In the embodiment of this application, the parity-check matrix may be applicable to an information bit sequence whose code length is n times of 1944, where n is an integer greater than or equal to 2. Therefore, transmission reliability of a system can be improved, and decoding performance can be improved. Generally, a longer applicable code length indicates better reliability of the parity-check matrix and better decoding performance.

According to a second aspect, an embodiment of this application provides a decoding method. The method is applied to a second communication apparatus, the second communication apparatus includes a Wi-Fi device, or a Wi-Fi chip, a functional module, or the like that is disposed in the Wi-Fi device, and the method includes:
obtaining to-be-decoded information, where a length of the to-be-decoded information is N₁, N₁ is n times 1944, and n is an integer greater than or equal to 2; and performing low-density parity-check LDPC decoding on the to-be-decoded information based on a parity-check matrix to obtain an information bit sequence, where the parity-check matrix has an expansion factor Z=81.

With reference to the first aspect or the second aspect, in a possible implementation, the parity-check matrix is obtained after diagonal extension or anti-diagonal extension is performed on an element in an x^{th} row and a y^{th} column in a matrix prototype of a basic parity-check matrix, a code length N₀ corresponding to the basic parity-check matrix is less than or equal to 1944, a coding rate corresponding to the basic parity-check matrix is the same as a coding rate corresponding to the parity-check matrix, and the element in the x^{th} row and the j^{th} column is greater than or equal to 0, and both x and y are positive integers.

With reference to the first aspect or the second aspect, in a possible implementation, that the parity-check matrix is obtained after diagonal extension or anti-diagonal extension is performed on the element in the x^{th} row and the y^{th} column in the matrix prototype of the basic parity-check matrix includes: the matrix prototype of the parity-check matrix is determined based on the matrix prototype of the basic parity-check matrix and an extension indication matrix, a size of the extension indication matrix is the same as a size of the matrix prototype of the basic parity-check matrix, and an element in the x^{th} row and the y^{th} column of the extension indication matrix indicate that a square matrix in a corresponding location in the matrix prototype of the parity-check matrix is obtained after diagonal extension or anti-diagonal extension is performed on the element in the x^{th} row and the y^{th} column in the matrix prototype of the basic parity-check matrix.

With reference to the first aspect or the second aspect, in a possible implementation, a first column and a second column in a matrix corresponding to a parity bit in a matrix prototype of the parity-check matrix are obtained after diagonal extension or anti-diagonal extension is performed on both a first element and a last element in a first column in a matrix corresponding to the parity bit in a matrix prototype of a basic parity-check matrix.

Generally, in the matrix prototype of the basic parity-check matrix, the first column in the matrix corresponding to the parity bit is of a "1-0-1" structure, that is, a first row and a last row in the first column are all 1 from top to bottom, and remaining rows are all 0. Therefore, in this embodiment of this application, a first element (for example, 1) and a last element (for example, 1) in the first column in the matrix corresponding to the parity bit in the matrix prototype of the basic parity-check matrix may be extended in a same manner, and an element at a corresponding location in the first column and the second column in the matrix corresponding to the parity bit in the matrix prototype of the parity-check matrix may be obtained in the same extension manner, so that the matrix corresponding to the parity bit may still maintain a similar structure (for example, the first element or the second element in the first column is 1, and the last element or a penultimate element in the first column is 1), to ensure a fast and efficient encoding algorithm of the LDPC code.

With reference to the first aspect or the second aspect, in a possible implementation, elements other than elements in the first column and the second column in the matrix corresponding to the parity bit in the matrix prototype of the parity-check matrix are obtained after diagonal extension is performed on elements 0 other than elements in the first column in the matrix corresponding to the parity bit in the matrix prototype of the basic parity-check matrix.

In this embodiment of this application, extension manners of elements other than the elements in the first column in the matrix corresponding to the parity bit in the matrix prototype of the basic parity-check matrix are all diagonal extension. The parity-check matrix obtained in the foregoing extension manner can not only ensure fast and efficient encoding, but also reduce implementation complexity due to the same extension manners.

For example, a code length corresponding to the matrix prototype of the basic parity-check matrix is 1944 bits. LDPC codes at different coding rates whose code lengths are 1944 bits in a WLAN system are used as a basic matrix for extension, to obtain parity-check matrices whose code lengths are 3888 bits at corresponding coding rates. Therefore, an original WLAN LDPC code encoding/decoding architecture may be reused as much as possible, so that modifications to an LDPC encoding module and an LDPC decoding module are as small as possible, to reduce implementation complexity.

With reference to the first aspect or the second aspect, in a possible implementation, a matrix corresponding to an information bit in the matrix prototype of the parity-check matrix is obtained after diagonal extension or anti-diagonal extension is performed on an element in an x^{th} row and a y^{th} column in a matrix corresponding to the information bit in the matrix prototype of the basic parity-check matrix.

With reference to the first aspect or the second aspect, in a possible implementation, when a coding rate R of the information bit sequence is 1/2, the matrix prototype of the parity-check matrix is the following matrix 1: 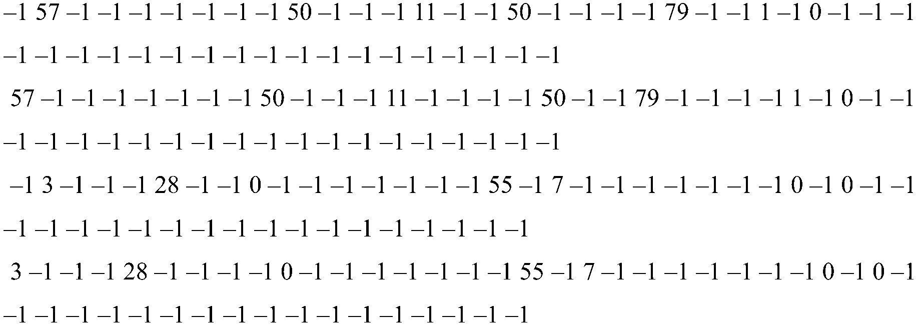 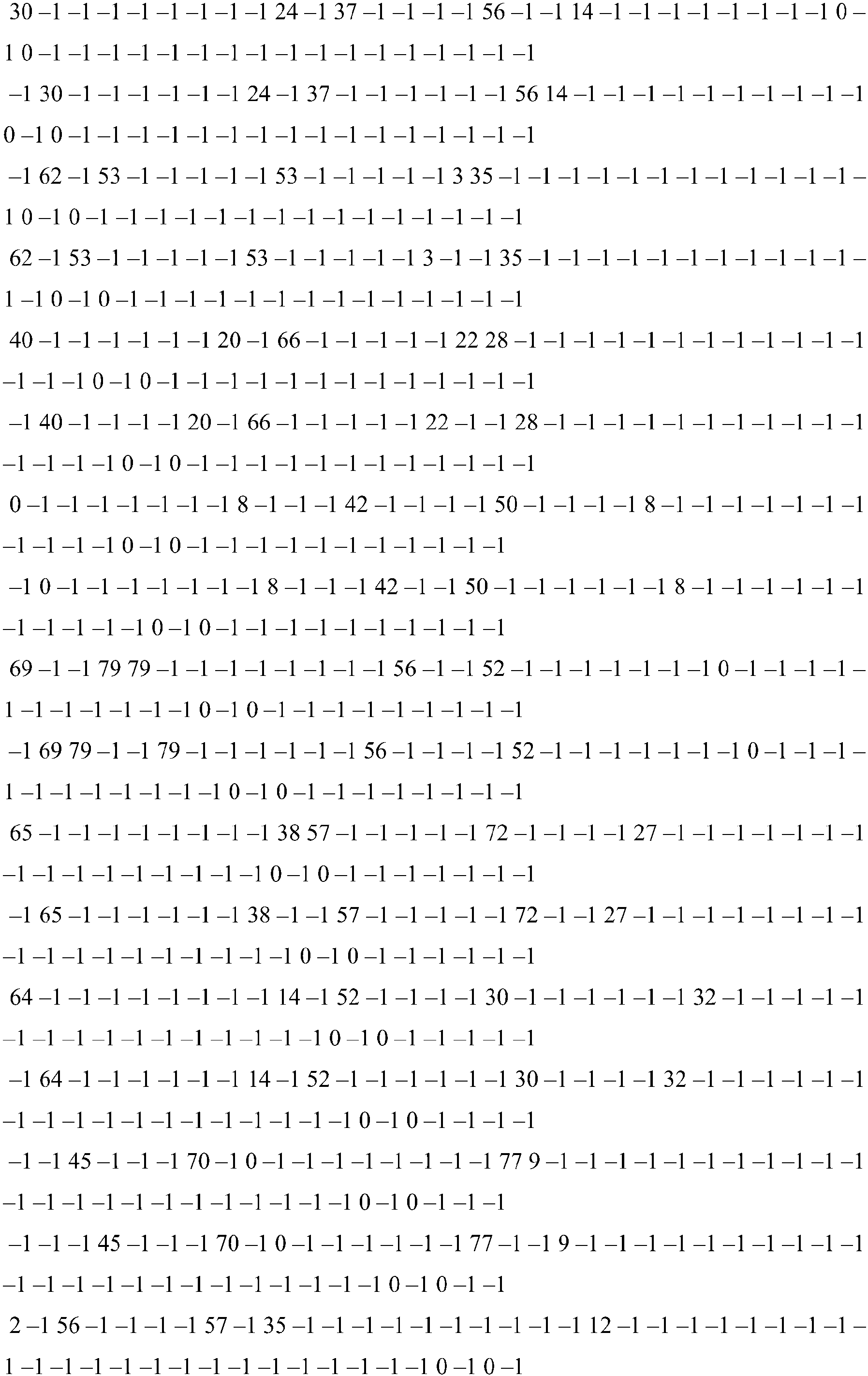 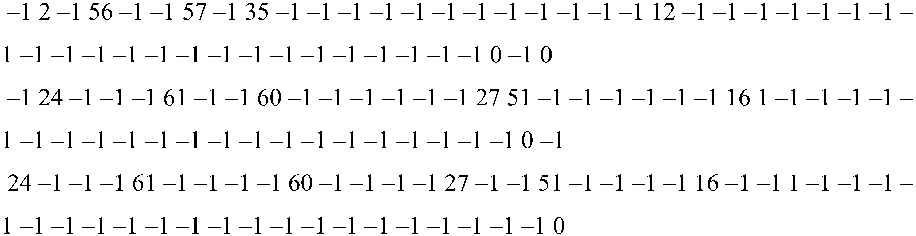 where -1 represents a Z*Z all-zero matrix, 0 represents a Z*Z unit matrix, and an element greater than 0 represents a circulant permutation matrix CPM of the Z*Z unit matrix.

In this embodiment of this application, "1" in the matrix 1 or "2" in a matrix 2 is used to distinguish between different matrices and facilitate subsequent reference.

With reference to the first aspect or the second aspect, in a possible implementation, an extension indication matrix corresponding to the matrix 1 is: $\begin{matrix}1 & - 1 & - 1 & - 1 & 1 & - 1 & 1 & - 1 & 0 & - 1 & 1 & - 1 & 0 & 0 & - 1 & - 1 & - 1 & - 1 & - 1 & - 1 & - 1 & - 1 & - 1 & - 1 \\ 1 & - 1 & 1 & - 1 & 0 & - 1 & - 1 & - 1 & 0 & 0 & - 1 & - 1 & - 1 & 0 & 0 & - 1 & - 1 & - 1 & - 1 & - 1 & - 1 & - 1 & - 1 & - 1 \\ 0 & - 1 & - 1 & - 1 & 1 & 1 & - 1 & - 1 & 0 & 1 & - 1 & - 1 & - 1 & - 1 & 0 & 0 & - 1 & - 1 & - 1 & - 1 & - 1 & - 1 & - 1 & - 1 \\ 1 & 1 & - 1 & - 1 & 1 & - 1 & - 1 & 1 & 0 & - 1 & - 1 & - 1 & - 1 & - 1 & - 1 & 0 & 0 & - 1 & - 1 & - 1 & - 1 & - 1 & - 1 & - 1 \\ 0 & - 1 & - 1 & 1 & 1 & - 1 & - 1 & 1 & 0 & - 1 & - 1 & - 1 & - 1 & - 1 & - 1 & - 1 & 0 & 0 & - 1 & - 1 & - 1 & - 1 & - 1 & - 1 \\ 0 & - 1 & - 1 & - 1 & 0 & - 1 & 0 & - 1 & 1 & - 1 & - 1 & 0 & - 1 & - 1 & - 1 & - 1 & - 1 & 0 & 0 & - 1 & - 1 & - 1 & - 1 & - 1 \\ 0 & 1 & 0 & - 1 & - 1 & - 1 & 1 & - 1 & 0 & - 1 & - 1 & - 1 & 0 & - 1 & - 1 & - 1 & - 1 & - 1 & 0 & 0 & - 1 & - 1 & - 1 & - 1 \\ 0 & - 1 & - 1 & - 1 & 1 & 0 & - 1 & - 1 & 0 & - 1 & 1 & - 1 & - 1 & - 1 & - 1 & - 1 & - 1 & - 1 & - 1 & 0 & 0 & - 1 & - 1 & - 1 \\ 0 & - 1 & - 1 & - 1 & 1 & 1 & - 1 & - 1 & 0 & - 1 & - 1 & 1 & - 1 & - 1 & - 1 & - 1 & - 1 & - 1 & - 1 & - 1 & 0 & 0 & - 1 & - 1 \\ - 1 & 0 & - 1 & 0 & 0 & - 1 & - 1 & - 1 & 1 & 0 & - 1 & - 1 & - 1 & - 1 & - 1 & - 1 & - 1 & - 1 & - 1 & - 1 & - 1 & 0 & 0 & - 1 \\ 0 & 0 & - 1 & 1 & 1 & - 1 & - 1 & - 1 & - 1 & - 1 & 0 & - 1 & - 1 & - 1 & - 1 & - 1 & - 1 & - 1 & - 1 & - 1 & - 1 & - 1 & 0 & 0 \\ 1 & - 1 & 1 & - 1 & 0 & - 1 & - 1 & 1 & 0 & - 1 & - 1 & 1 & 0 & - 1 & - 1 & - 1 & - 1 & - 1 & - 1 & - 1 & - 1 & - 1 & - 1 & 0\end{matrix}$
where -1 indicates that an element at a corresponding location in the matrix prototype of the parity-check matrix is obtained after an element j₁ in the matrix prototype of the basic parity-check matrix is extended to the 2*2 all-zero matrix; 0 indicates that the element at the corresponding location in the matrix prototype of the parity-check matrix is obtained after diagonal extension is performed on an element j₂ in the matrix prototype of the basic parity-check matrix; and 1 indicates that the element at the corresponding location in the matrix prototype of the parity-check matrix is obtained after anti-diagonal extension is performed on an element j₃ in the matrix prototype of the basic parity-check matrix. Descriptions of elements in the matrix prototype are also applicable to the matrix 2 to a matrix 14 shown below. Details are not described below again.

With reference to the first aspect or the second aspect, in a possible implementation, when a coding rate R of the information bit sequence is 1/2, the matrix prototype of the parity-check matrix is the following matrix 2:

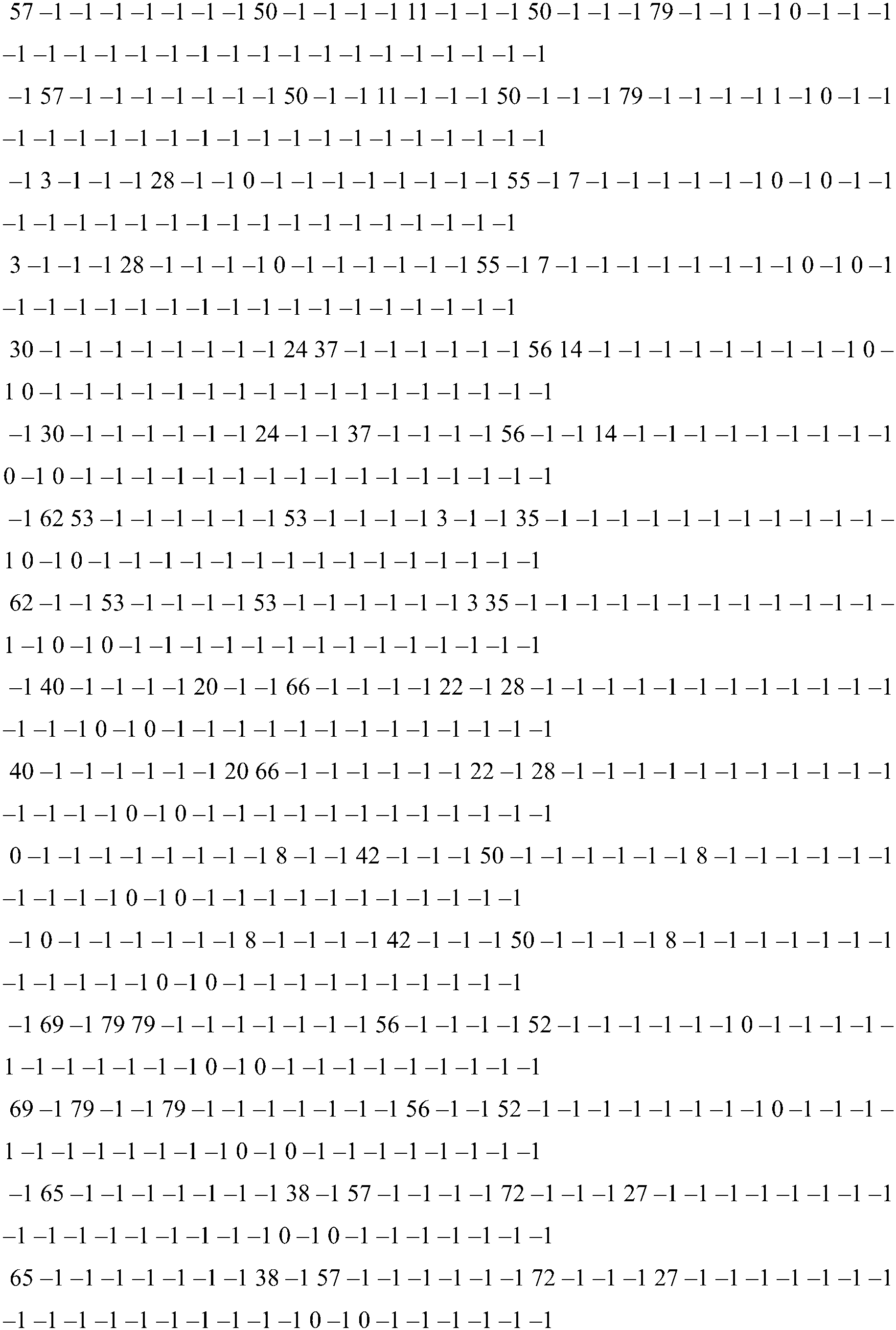

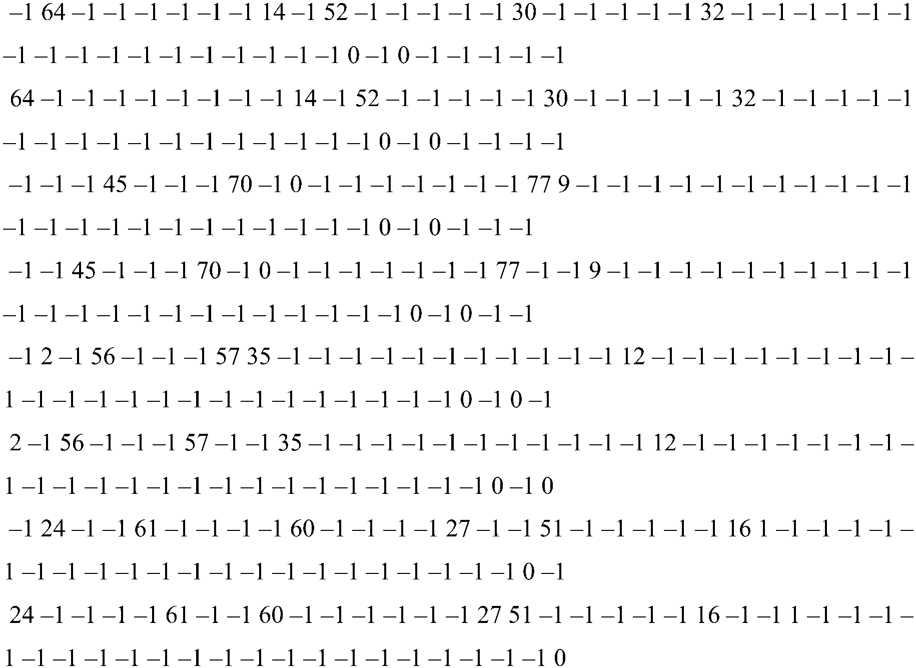

With reference to the first aspect or the second aspect, in a possible implementation, an extension indication matrix corresponding to the matrix 2 is: $\begin{matrix}0 & - 1 & - 1 & - 1 & 0 & - 1 & 1 & - 1 & 1 & - 1 & 1 & - 1 & 0 & 0 & - 1 & - 1 & - 1 & - 1 & - 1 & - 1 & - 1 & - 1 & - 1 & - 1 \\ 1 & - 1 & 1 & - 1 & 0 & - 1 & - 1 & - 1 & 1 & 1 & - 1 & - 1 & - 1 & 0 & 0 & - 1 & - 1 & - 1 & - 1 & - 1 & - 1 & - 1 & - 1 & - 1 \\ 0 & - 1 & - 1 & - 1 & 1 & 0 & - 1 & - 1 & 1 & 0 & - 1 & - 1 & - 1 & - 1 & 0 & 0 & - 1 & - 1 & - 1 & - 1 & - 1 & - 1 & - 1 & - 1 \\ 1 & 0 & - 1 & - 1 & 1 & - 1 & - 1 & 0 & 1 & - 1 & - 1 & - 1 & - 1 & - 1 & - 1 & 0 & 0 & - 1 & - 1 & - 1 & - 1 & - 1 & - 1 & - 1 \\ 1 & - 1 & - 1 & 0 & 1 & - 1 & - 1 & 0 & 0 & - 1 & - 1 & - 1 & - 1 & - 1 & - 1 & - 1 & 0 & 0 & - 1 & - 1 & - 1 & - 1 & - 1 & - 1 \\ 0 & - 1 & - 1 & - 1 & 1 & - 1 & 0 & - 1 & 0 & - 1 & - 1 & 1 & - 1 & - 1 & - 1 & - 1 & - 1 & 0 & 0 & - 1 & - 1 & - 1 & - 1 & - 1 \\ 1 & 1 & 0 & - 1 & - 1 & - 1 & 0 & - 1 & 1 & - 1 & - 1 & - 1 & 0 & - 1 & - 1 & - 1 & - 1 & - 1 & 0 & 0 & - 1 & - 1 & - 1 & - 1 \\ 1 & - 1 & - 1 & - 1 & 1 & 1 & - 1 & - 1 & 0 & - 1 & 0 & - 1 & - 1 & - 1 & - 1 & - 1 & - 1 & - 1 & - 1 & 0 & 0 & - 1 & - 1 & - 1 \\ 1 & - 1 & - 1 & - 1 & 0 & 0 & - 1 & - 1 & 0 & - 1 & - 1 & 0 & - 1 & - 1 & - 1 & - 1 & - 1 & - 1 & - 1 & - 1 & 0 & 0 & - 1 & - 1 \\ - 1 & 1 & - 1 & 1 & 1 & - 1 & - 1 & - 1 & 1 & 0 & - 1 & - 1 & - 1 & - 1 & - 1 & - 1 & - 1 & - 1 & - 1 & - 1 & - 1 & 0 & 0 & - 1 \\ 1 & 1 & - 1 & 1 & 0 & - 1 & - 1 & - 1 & - 1 & - 1 & 0 & - 1 & - 1 & - 1 & - 1 & - 1 & - 1 & - 1 & - 1 & - 1 & - 1 & - 1 & 0 & 0 \\ 1 & - 1 & 0 & - 1 & 1 & - 1 & - 1 & 0 & 1 & - 1 & - 1 & 1 & 0 & - 1 & - 1 & - 1 & - 1 & - 1 & - 1 & - 1 & - 1 & - 1 & - 1 & 0\end{matrix}$

With reference to the first aspect or the second aspect, in a possible implementation, when a coding rate R of the information bit sequence is 1/2, the matrix prototype of the parity-check matrix is the following matrix 3:

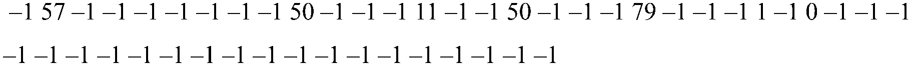

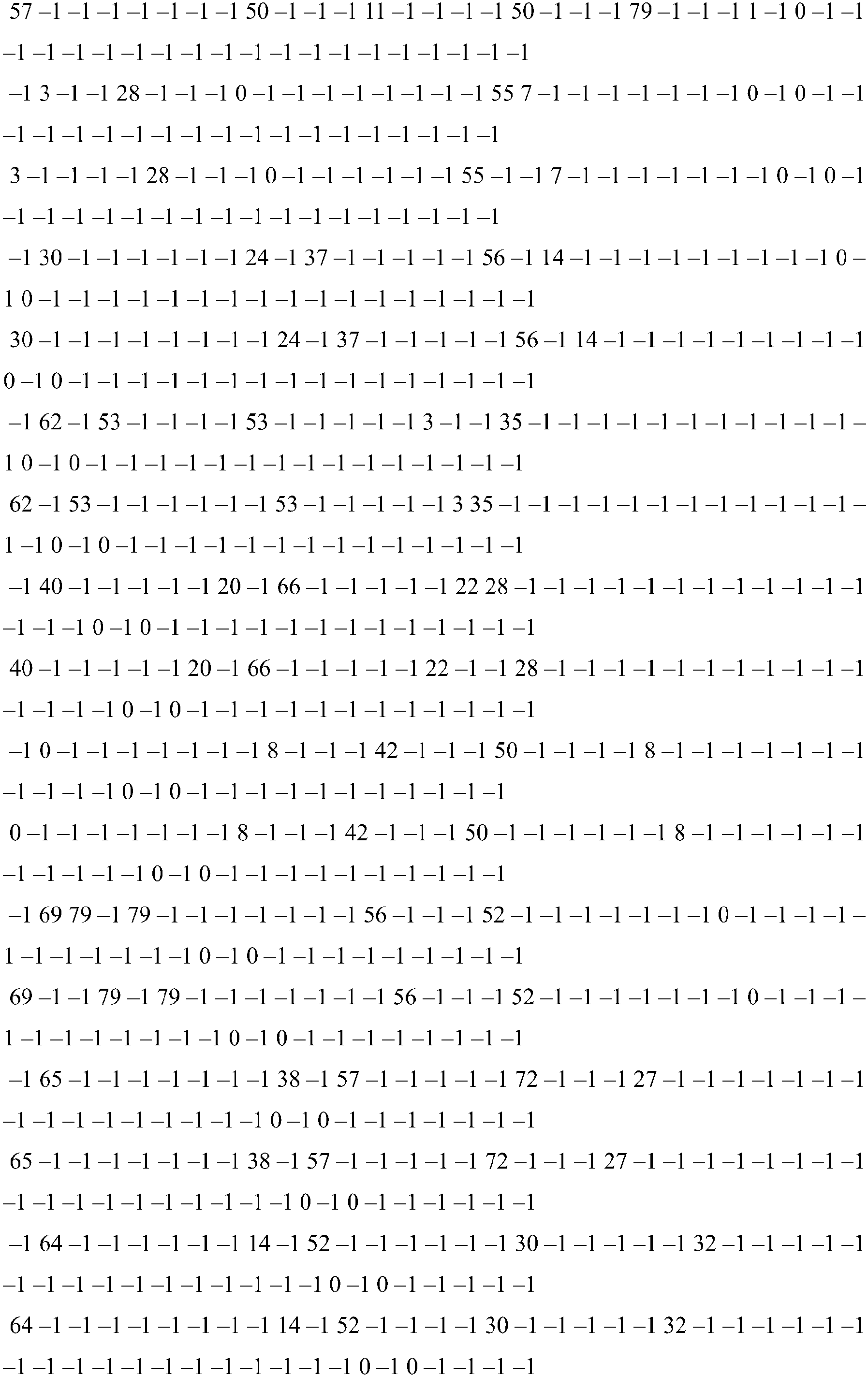

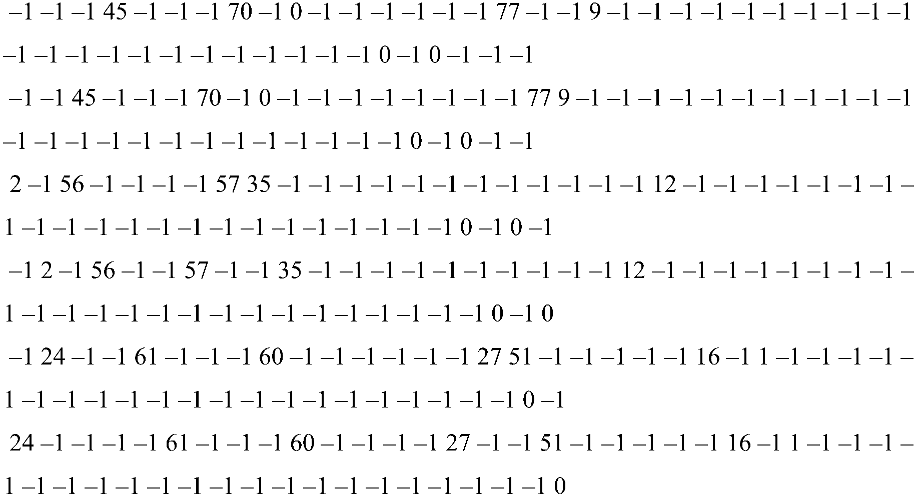

With reference to the first aspect or the second aspect, in a possible implementation, an extension indication matrix corresponding to the matrix 3 is: $\begin{matrix}1 & - 1 & - 1 & - 1 & 1 & - 1 & 1 & - 1 & 0 & - 1 & 0 & - 1 & 0 & 0 & - 1 & - 1 & - 1 & - 1 & - 1 & - 1 & - 1 & - 1 & - 1 & - 1 \\ 1 & - 1 & 0 & - 1 & 0 & - 1 & - 1 & - 1 & 1 & 0 & - 1 & - 1 & - 1 & 0 & 0 & - 1 & - 1 & - 1 & - 1 & - 1 & - 1 & - 1 & - 1 & - 1 \\ 1 & - 1 & - 1 & - 1 & 0 & 0 & - 1 & - 1 & 0 & 0 & - 1 & - 1 & - 1 & - 1 & 0 & 0 & - 1 & - 1 & - 1 & - 1 & - 1 & - 1 & - 1 & - 1 \\ 1 & 1 & - 1 & - 1 & 0 & - 1 & - 1 & 0 & 1 & - 1 & - 1 & - 1 & - 1 & - 1 & - 1 & 0 & 0 & - 1 & - 1 & - 1 & - 1 & - 1 & - 1 & - 1 \\ 1 & - 1 & - 1 & 1 & 1 & - 1 & - 1 & 1 & 0 & - 1 & - 1 & - 1 & - 1 & - 1 & - 1 & - 1 & 0 & 0 & - 1 & - 1 & - 1 & - 1 & - 1 & - 1 \\ 1 & - 1 & - 1 & - 1 & 1 & - 1 & 1 & - 1 & 1 & - 1 & - 1 & 0 & - 1 & - 1 & - 1 & - 1 & - 1 & 0 & 0 & - 1 & - 1 & - 1 & - 1 & - 1 \\ 1 & 0 & 0 & - 1 & - 1 & - 1 & 0 & - 1 & 0 & - 1 & - 1 & - 1 & 0 & - 1 & - 1 & - 1 & - 1 & - 1 & 0 & 0 & - 1 & - 1 & - 1 & - 1 \\ 1 & - 1 & - 1 & - 1 & 1 & 1 & - 1 & - 1 & 1 & - 1 & 1 & - 1 & - 1 & - 1 & - 1 & - 1 & - 1 & - 1 & - 1 & 0 & 0 & - 1 & - 1 & - 1 \\ 1 & - 1 & - 1 & - 1 & 0 & 0 & - 1 & - 1 & 1 & - 1 & - 1 & 1 & - 1 & - 1 & - 1 & - 1 & - 1 & - 1 & - 1 & - 1 & 0 & 0 & - 1 & - 1 \\ - 1 & 1 & - 1 & 1 & 1 & - 1 & - 1 & - 1 & 0 & 1 & - 1 & - 1 & - 1 & - 1 & - 1 & - 1 & - 1 & - 1 & - 1 & - 1 & - 1 & 0 & 0 & - 1 \\ 0 & 0 & - 1 & 1 & 0 & - 1 & - 1 & - 1 & - 1 & - 1 & 1 & - 1 & - 1 & - 1 & - 1 & - 1 & - 1 & - 1 & - 1 & - 1 & - 1 & - 1 & 0 & 0 \\ 1 & - 1 & 0 & - 1 & 0 & - 1 & - 1 & 1 & 0 & - 1 & - 1 & 0 & 0 & - 1 & - 1 & - 1 & - 1 & - 1 & - 1 & - 1 & - 1 & - 1 & - 1 & 0\end{matrix}$

With reference to the first aspect or the second aspect, in a possible implementation, when a coding rate R of the information bit sequence is 2/3, the matrix prototype of the parity-check matrix is the following matrix 4:

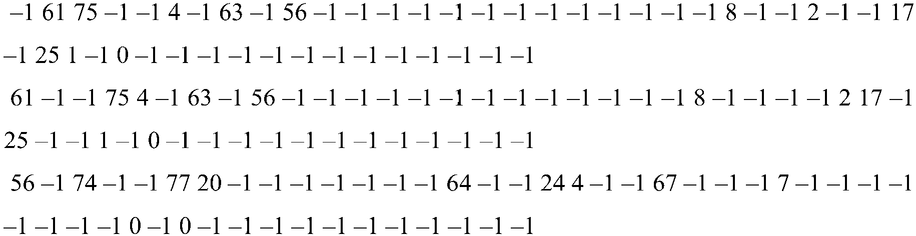

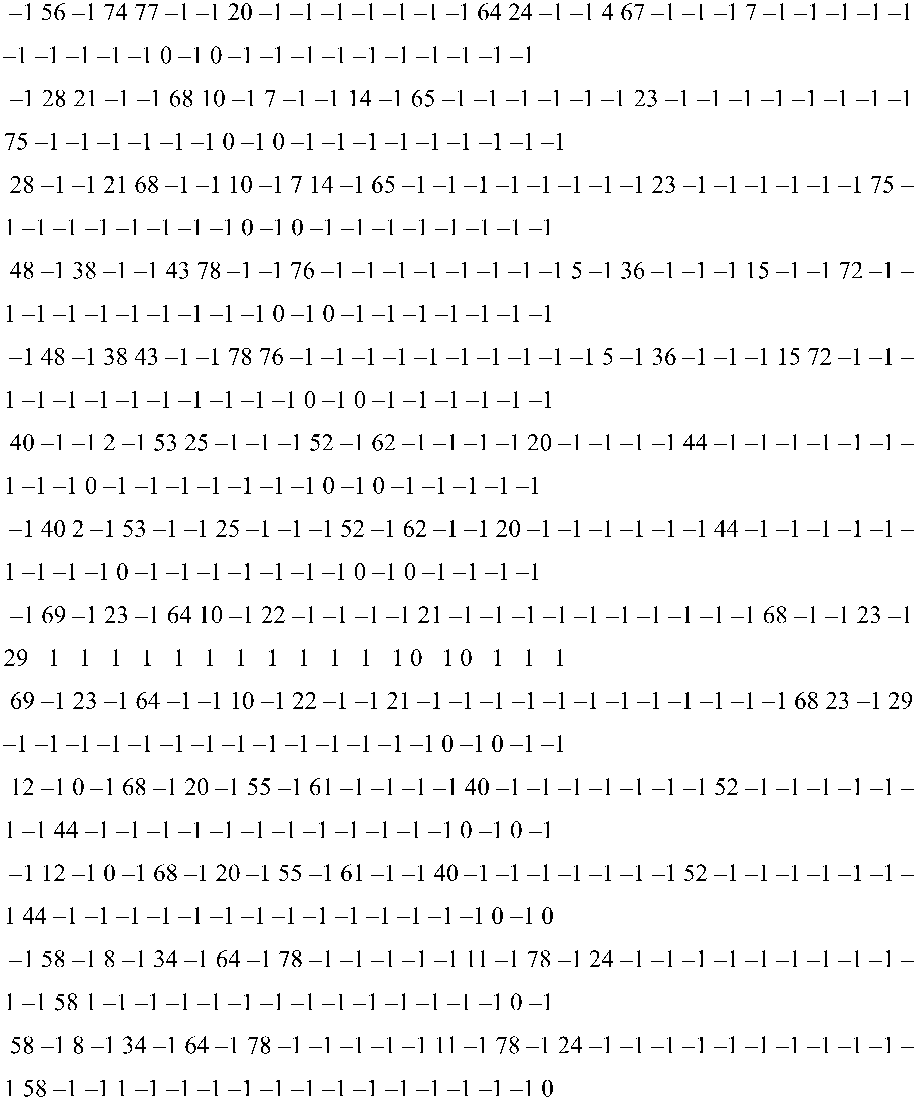

With reference to the first aspect or the second aspect, in a possible implementation, an extension indication matrix corresponding to the matrix 4 is: $\begin{matrix}1 & 0 & 1 & 1 & 1 & - 1 & - 1 & - 1 & - 1 & - 1 & - 1 & 1 & - 1 & 0 & 1 & 1 & 0 & 0 & - 1 & - 1 & - 1 & - 1 & - 1 & - 1 \\ 0 & 0 & 1 & 0 & - 1 & - 1 & - 1 & 0 & 1 & 0 & - 1 & 1 & - 1 & - 1 & - 1 & - 1 & - 1 & 0 & 0 & - 1 & - 1 & - 1 & - 1 & - 1 \\ 1 & 0 & 1 & 0 & 0 & 1 & 1 & - 1 & - 1 & - 1 & 0 & - 1 & - 1 & - 1 & 1 & - 1 & - 1 & - 1 & 0 & 0 & - 1 & - 1 & - 1 & - 1 \\ 0 & 0 & 1 & 0 & 1 & - 1 & - 1 & - 1 & - 1 & 0 & 0 & - 1 & 0 & 1 & - 1 & - 1 & - 1 & - 1 & - 1 & 0 & 0 & - 1 & - 1 & - 1 \\ 0 & 1 & 1 & 0 & - 1 & 0 & 0 & - 1 & 1 & - 1 & - 1 & 0 & 1 & 1 & - 1 & - 1 & - 1 & - 1 & - 1 & - 1 & 0 & 0 & - 1 & - 1 \\ 1 & 1 & 1 & 0 & 0 & - 1 & 1 & - 1 & - 1 & - 1 & - 1 & - 1 & 0 & 1 & 1 & - 1 & - 1 & - 1 & - 1 & - 1 & - 1 & 0 & 0 & - 1 \\ 0 & 0 & 0 & 0 & 0 & 0 & - 1 & 1 & - 1 & - 1 & - 1 & 1 & - 1 & - 1 & - 1 & 1 & - 1 & - 1 & - 1 & - 1 & - 1 & - 1 & 0 & 0 \\ 1 & 1 & 1 & 1 & 1 & - 1 & - 1 & 1 & 1 & 1 & - 1 & - 1 & - 1 & - 1 & - 1 & 1 & 0 & - 1 & - 1 & - 1 & - 1 & - 1 & - 1 & 0\end{matrix}$

With reference to the first aspect or the second aspect, in a possible implementation, when a coding rate R of the information bit sequence is 2/3, the matrix prototype of the parity-check matrix is the following matrix 5:

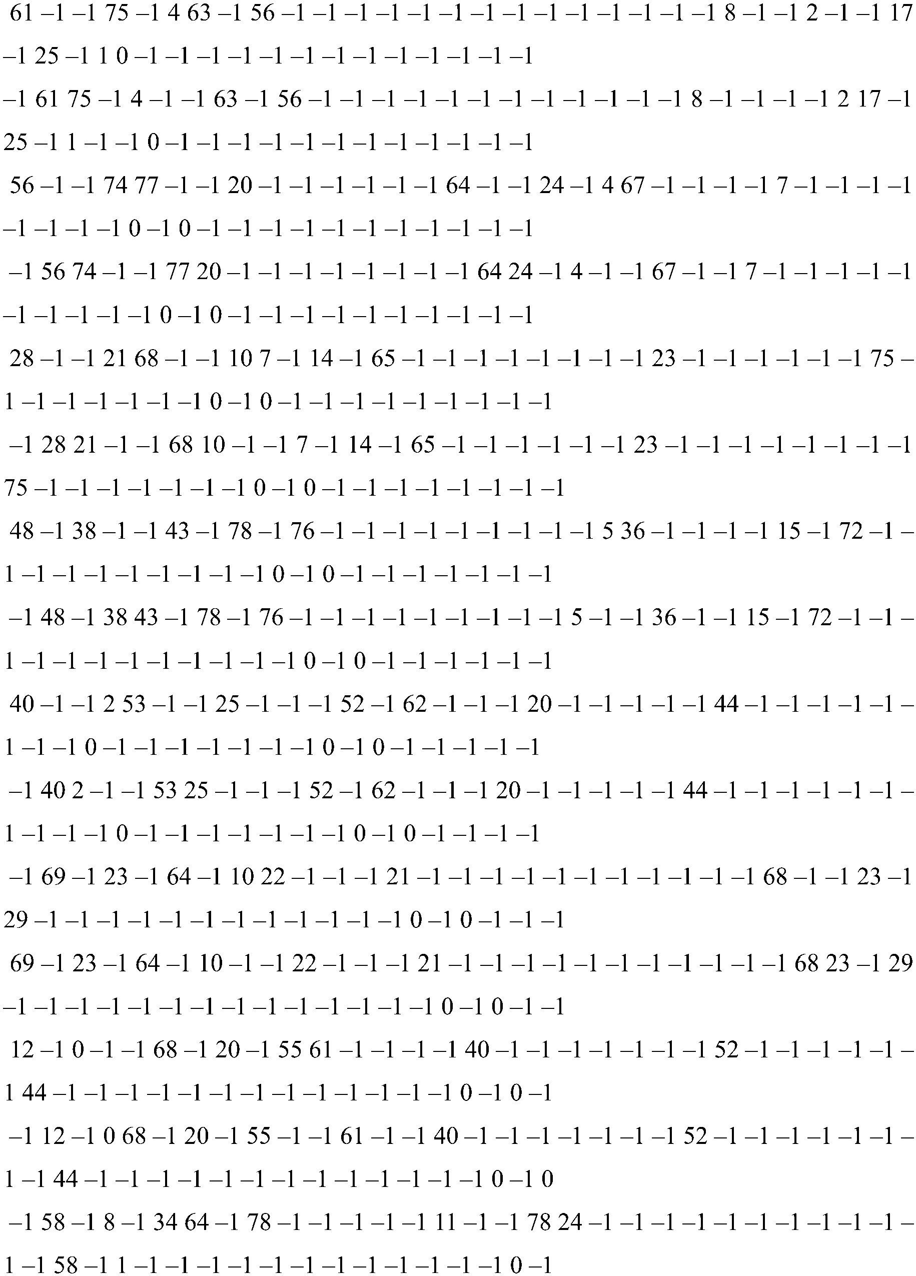

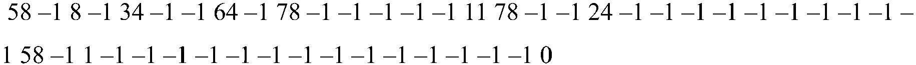

With reference to the first aspect or the second aspect, in a possible implementation, an extension indication matrix corresponding to the matrix 5 is: $\begin{matrix}0 & 1 & 1 & 0 & 0 & - 1 & - 1 & - 1 & - 1 & - 1 & - 1 & 1 & - 1 & 0 & 1 & 1 & 1 & 0 & - 1 & - 1 & - 1 & - 1 & - 1 & - 1 \\ 0 & 1 & 0 & 1 & - 1 & - 1 & - 1 & 0 & 1 & 1 & 0 & - 1 & 1 & - 1 & - 1 & - 1 & - 1 & 0 & 0 & - 1 & - 1 & - 1 & - 1 & - 1 \\ 0 & 1 & 0 & 1 & 0 & 0 & 0 & - 1 & - 1 & - 1 & 1 & - 1 & - 1 & - 1 & 0 & - 1 & - 1 & - 1 & 0 & 0 & - 1 & - 1 & - 1 & - 1 \\ 0 & 0 & 1 & 1 & 1 & - 1 & - 1 & - 1 & - 1 & 1 & 0 & - 1 & 1 & 1 & - 1 & - 1 & - 1 & - 1 & - 1 & 0 & 0 & - 1 & - 1 & - 1 \\ 0 & 1 & 0 & 1 & - 1 & 1 & 1 & - 1 & 1 & - 1 & - 1 & 1 & - 1 & - 1 & - 1 & - 1 & 0 & - 1 & - 1 & - 1 & 0 & 0 & - 1 & - 1 \\ 1 & 1 & 1 & 1 & 0 & - 1 & 0 & - 1 & - 1 & - 1 & - 1 & - 1 & 0 & 1 & 1 & - 1 & - 1 & - 1 & - 1 & - 1 & - 1 & 0 & 0 & - 1 \\ 0 & 0 & 1 & 1 & 1 & 0 & - 1 & 1 & - 1 & - 1 & - 1 & 1 & - 1 & - 1 & - 1 & 0 & - 1 & - 1 & - 1 & - 1 & - 1 & - 1 & 0 & 0 \\ 1 & 1 & 1 & 0 & 0 & - 1 & - 1 & 0 & 1 & 0 & - 1 & - 1 & - 1 & - 1 & - 1 & 1 & 1 & - 1 & - 1 & - 1 & - 1 & - 1 & - 1 & 0\end{matrix}$

With reference to the first aspect or the second aspect, in a possible implementation, when a coding rate R of the information bit sequence is 2/3, the matrix prototype of the parity-check matrix is the following matrix 6:

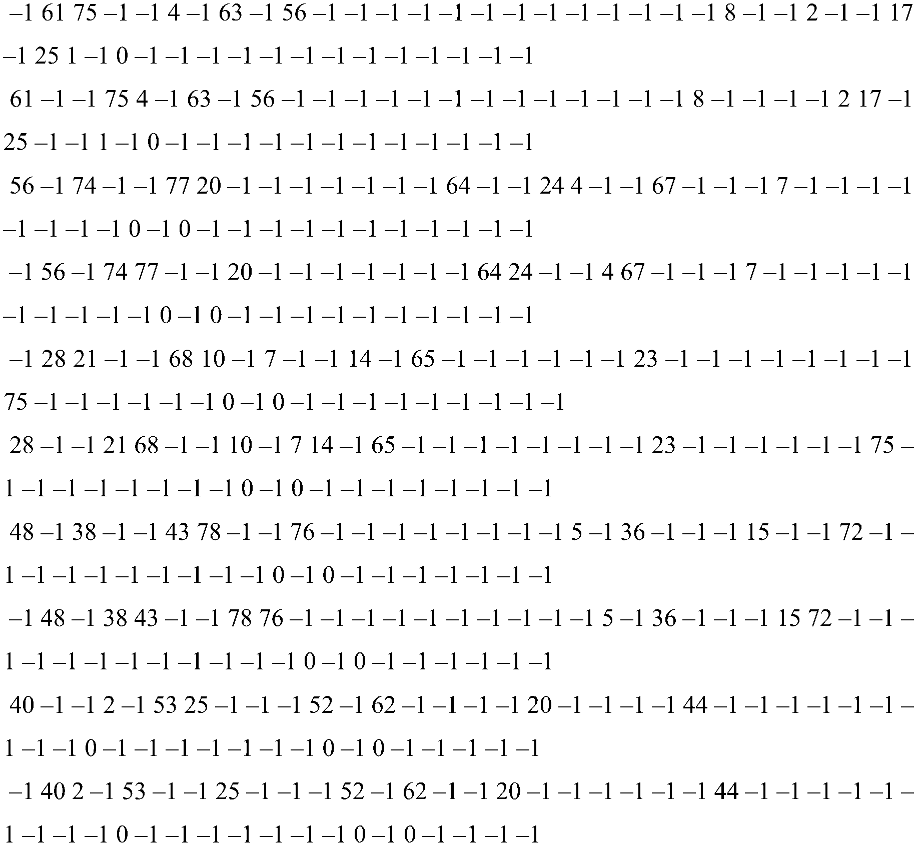

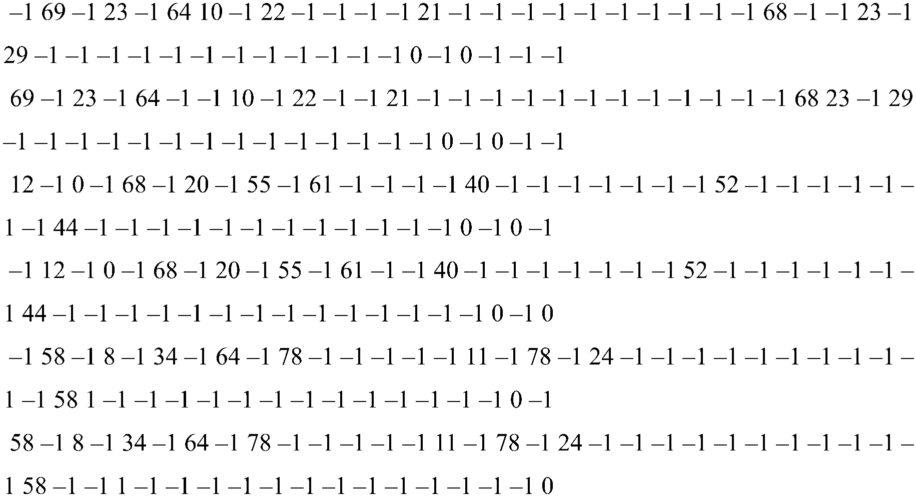

With reference to the first aspect or the second aspect, in a possible implementation, an extension indication matrix corresponding to the matrix 6 is: $\begin{matrix}1 & 0 & 1 & 1 & 1 & - 1 & - 1 & - 1 & - 1 & - 1 & - 1 & 1 & - 1 & 0 & 1 & 1 & 0 & 0 & - 1 & - 1 & - 1 & - 1 & - 1 & - 1 \\ 0 & 0 & 1 & 0 & - 1 & - 1 & - 1 & 0 & 1 & 0 & 1 & - 1 & 1 & - 1 & - 1 & - 1 & - 1 & 0 & 0 & - 1 & - 1 & - 1 & - 1 & - 1 \\ 1 & 0 & 1 & 0 & 0 & 1 & 1 & - 1 & - 1 & - 1 & 0 & - 1 & - 1 & - 1 & 1 & - 1 & - 1 & - 1 & 0 & 0 & - 1 & - 1 & - 1 & - 1 \\ 0 & 0 & 1 & 0 & 1 & - 1 & - 1 & - 1 & - 1 & 0 & 0 & - 1 & 0 & 1 & - 1 & - 1 & - 1 & - 1 & - 1 & 0 & 0 & - 1 & - 1 & - 1 \\ 0 & 1 & 1 & 0 & - 1 & 0 & 0 & - 1 & 1 & - 1 & - 1 & 0 & - 1 & - 1 & - 1 & - 1 & 0 & - 1 & - 1 & - 1 & 0 & 0 & - 1 & - 1 \\ 1 & 1 & 1 & 0 & 0 & - 1 & 1 & - 1 & - 1 & - 1 & - 1 & - 1 & 0 & 1 & 1 & - 1 & - 1 & - 1 & - 1 & - 1 & - 1 & 0 & 0 & - 1 \\ 0 & 0 & 0 & 0 & 0 & 0 & - 1 & 1 & - 1 & - 1 & - 1 & 1 & - 1 & - 1 & - 1 & 1 & - 1 & - 1 & - 1 & - 1 & - 1 & - 1 & 0 & 0 \\ 1 & 1 & 1 & 1 & 1 & - 1 & - 1 & 1 & 1 & 1 & - 1 & - 1 & - 1 & - 1 & - 1 & 1 & 0 & - 1 & - 1 & - 1 & - 1 & - 1 & - 1 & 0\end{matrix}$

With reference to the first aspect or the second aspect, in a possible implementation, when a coding rate R of the information bit sequence is 3/4, the matrix prototype of the parity-check matrix is the following matrix 7:

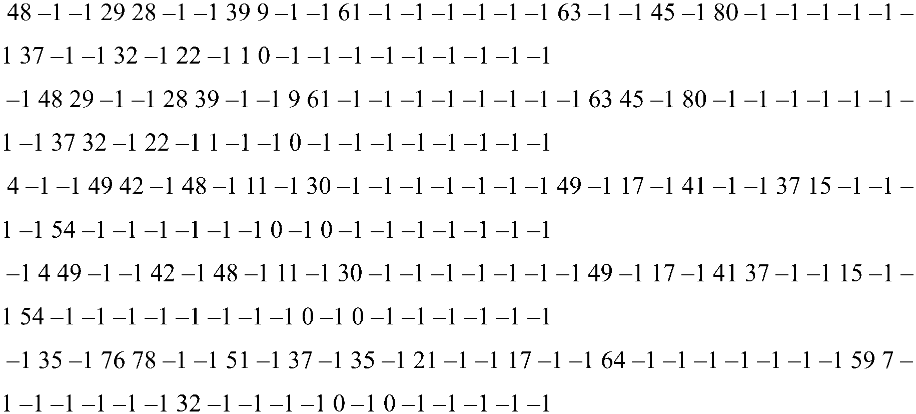

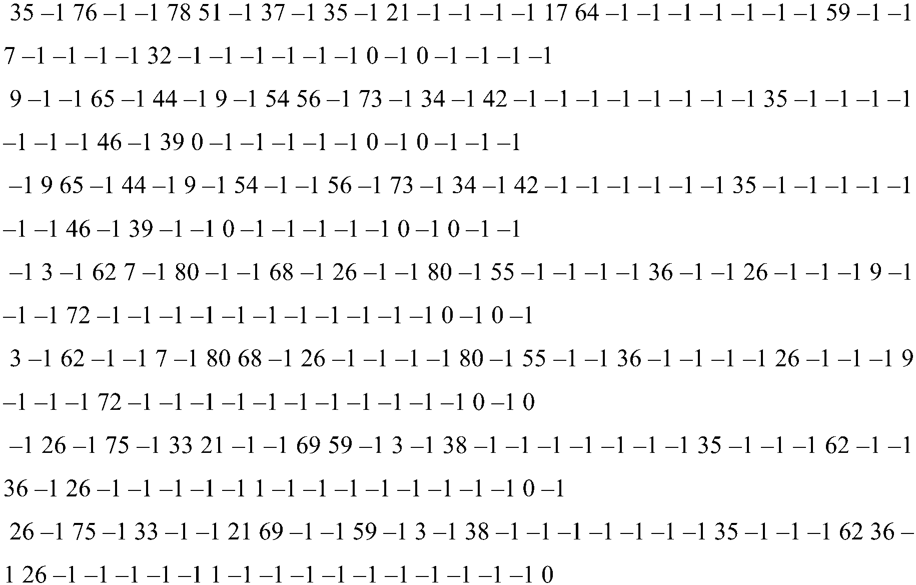

With reference to the first aspect or the second aspect, in a possible implementation, an extension indication matrix corresponding to the matrix 7 is: $\begin{matrix}0 & 1 & 0 & 1 & 0 & 1 & - 1 & - 1 & - 1 & 0 & 1 & 1 & - 1 & - 1 & - 1 & 0 & 1 & 1 & 1 & 0 & - 1 & - 1 & - 1 & - 1 \\ 0 & 1 & 0 & 0 & 0 & 0 & - 1 & - 1 & - 1 & 0 & 0 & 0 & 1 & 0 & - 1 & 0 & - 1 & - 1 & - 1 & 0 & 0 & - 1 & - 1 & - 1 \\ 1 & 1 & 0 & 1 & 1 & 1 & 1 & - 1 & 0 & 1 & - 1 & - 1 & - 1 & 1 & 0 & - 1 & - 1 & 1 & - 1 & - 1 & 0 & 0 & - 1 & - 1 \\ 0 & 1 & 1 & 1 & 1 & 0 & 0 & 0 & 0 & - 1 & - 1 & - 1 & 1 & - 1 & - 1 & - 1 & 1 & 1 & 0 & - 1 & - 1 & 0 & 0 & - 1 \\ 1 & 1 & 0 & 0 & 1 & 1 & - 1 & 0 & 0 & - 1 & 1 & - 1 & 0 & - 1 & 0 & - 1 & 0 & - 1 & - 1 & - 1 & - 1 & - 1 & 0 & 0 \\ 1 & 1 & 1 & 0 & 1 & 0 & 0 & 0 & - 1 & - 1 & - 1 & 0 & - 1 & 0 & 1 & 1 & - 1 & - 1 & 1 & - 1 & - 1 & - 1 & - 1 & 0\end{matrix}$

With reference to the first aspect or the second aspect, in a possible implementation, when a coding rate R of the information bit sequence is 3/4, the matrix prototype of the parity-check matrix is the following matrix 8:

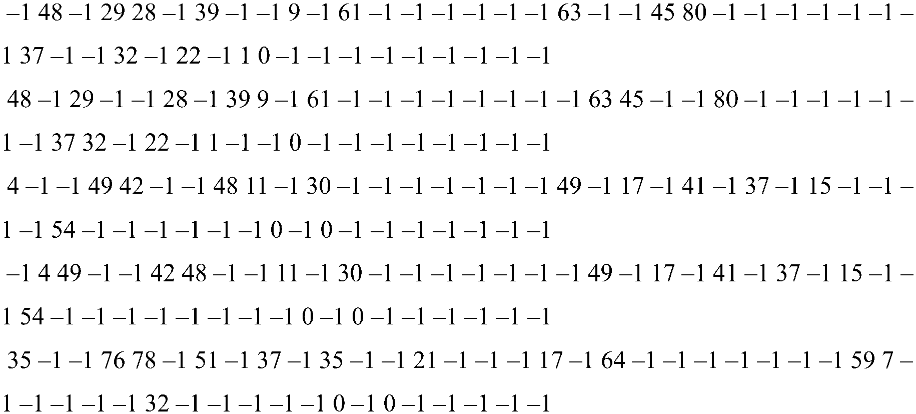

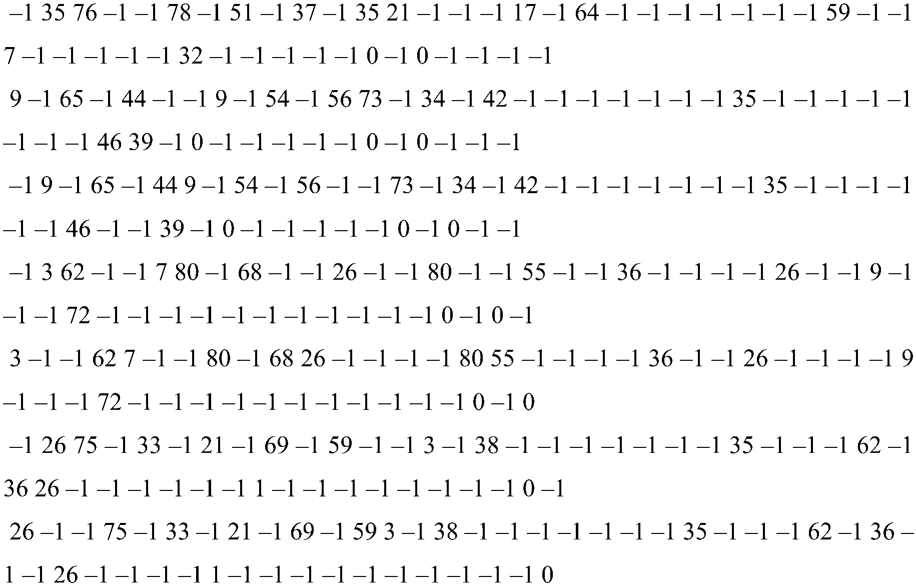

With reference to the first aspect or the second aspect, in a possible implementation, an extension indication matrix corresponding to the matrix 8 is: $\begin{matrix}1 & 1 & 0 & 0 & 1 & 1 & - 1 & - 1 & - 1 & 0 & 1 & 0 & - 1 & - 1 & - 1 & 0 & 1 & 1 & 1 & 0 & - 1 & - 1 & - 1 & - 1 \\ 0 & 1 & 0 & 1 & 0 & 0 & - 1 & - 1 & - 1 & 0 & 0 & 0 & 0 & 0 & - 1 & 1 & - 1 & - 1 & - 1 & 0 & 0 & - 1 & - 1 & - 1 \\ 0 & 1 & 0 & 0 & 0 & 0 & 1 & - 1 & 1 & 1 & - 1 & - 1 & - 1 & 1 & 0 & - 1 & - 1 & 0 & - 1 & - 1 & 0 & 0 & - 1 & - 1 \\ 0 & 0 & 0 & 1 & 1 & 1 & 0 & 0 & 0 & - 1 & - 1 & - 1 & 0 & - 1 & - 1 & - 1 & 1 & 0 & 0 & - 1 & - 1 & 0 & 0 & - 1 \\ 1 & 0 & 1 & 0 & 0 & 1 & - 1 & 0 & 1 & - 1 & 0 & - 1 & 1 & - 1 & 0 & - 1 & 0 & - 1 & - 1 & - 1 & - 1 & - 1 & 0 & 0 \\ 1 & 0 & 0 & 0 & 0 & 0 & 1 & 1 & - 1 & - 1 & - 1 & 1 & - 1 & 1 & 1 & 0 & - 1 & - 1 & 1 & - 1 & - 1 & - 1 & - 1 & 0\end{matrix}$

With reference to the first aspect or the second aspect, in a possible implementation, when a coding rate R of the information bit sequence is 3/4, the matrix prototype of the parity-check matrix is the following matrix 9:

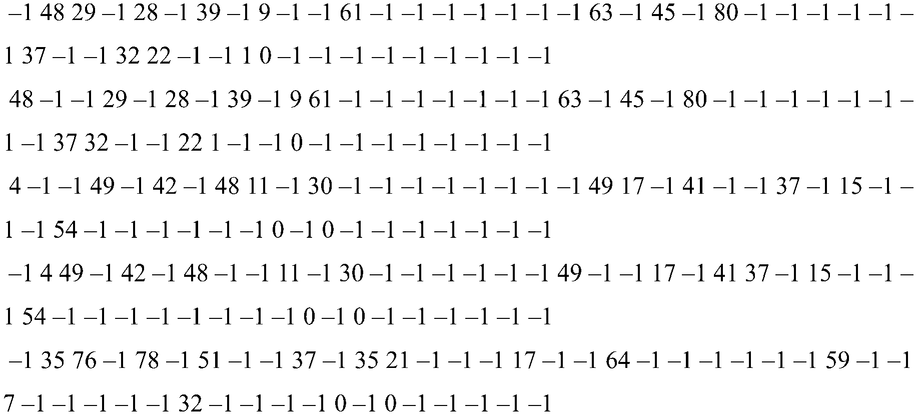

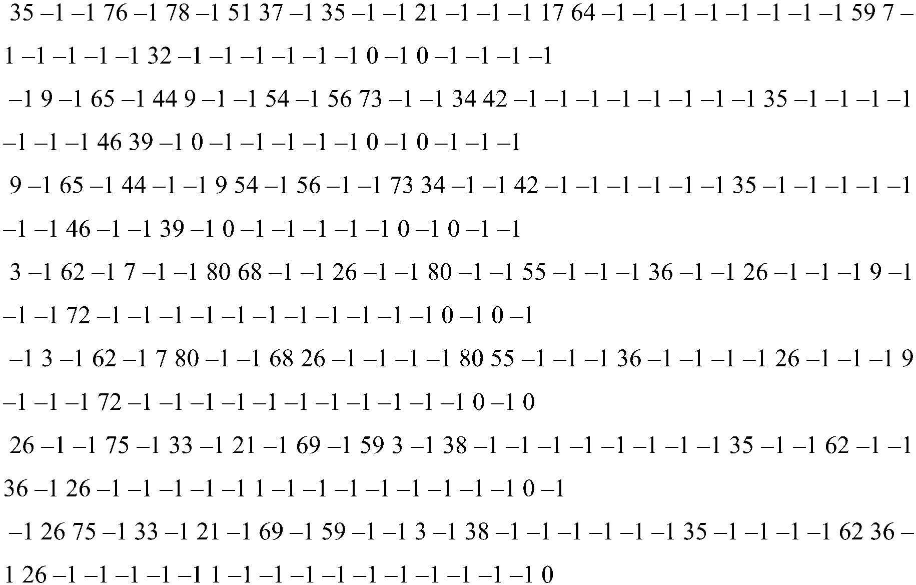

With reference to the first aspect or the second aspect, in a possible implementation, an extension indication matrix corresponding to the matrix 9 is: $\begin{matrix}1 & 0 & 0 & 0 & 0 & 1 & - 1 & - 1 & - 1 & 1 & 1 & 1 & - 1 & - 1 & - 1 & 0 & 1 & 0 & 1 & 0 & - 1 & - 1 & - 1 & - 1 \\ 0 & 1 & 1 & 1 & 0 & 0 & - 1 & - 1 & - 1 & 1 & 0 & 0 & 1 & 1 & - 1 & 1 & - 1 & - 1 & - 1 & 0 & 0 & - 1 & - 1 & - 1 \\ 1 & 0 & 0 & 0 & 1 & 1 & 0 & - 1 & 0 & 1 & - 1 & - 1 & - 1 & 0 & 1 & - 1 & - 1 & 1 & - 1 & - 1 & 0 & 0 & - 1 & - 1 \\ 1 & 1 & 1 & 0 & 1 & 1 & 0 & 1 & 0 & - 1 & - 1 & - 1 & 1 & - 1 & - 1 & - 1 & 1 & 0 & 0 & - 1 & - 1 & 0 & 0 & - 1 \\ 0 & 0 & 0 & 1 & 0 & 1 & - 1 & 0 & 1 & - 1 & 1 & - 1 & 0 & - 1 & 0 & - 1 & 0 & - 1 & - 1 & - 1 & - 1 & - 1 & 0 & 0 \\ 0 & 1 & 1 & 1 & 1 & 1 & 0 & 0 & - 1 & - 1 & - 1 & 1 & - 1 & 0 & 1 & 1 & - 1 & - 1 & 1 & - 1 & - 1 & - 1 & - 1 & 0\end{matrix}$

With reference to the first aspect or the second aspect, in a possible implementation, when a coding rate R of the information bit sequence is 3/4, the matrix prototype of the parity-check matrix is the following matrix 10:

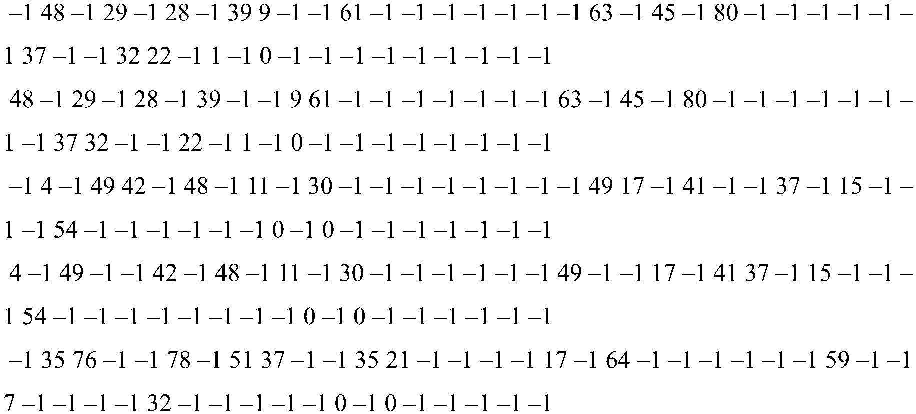

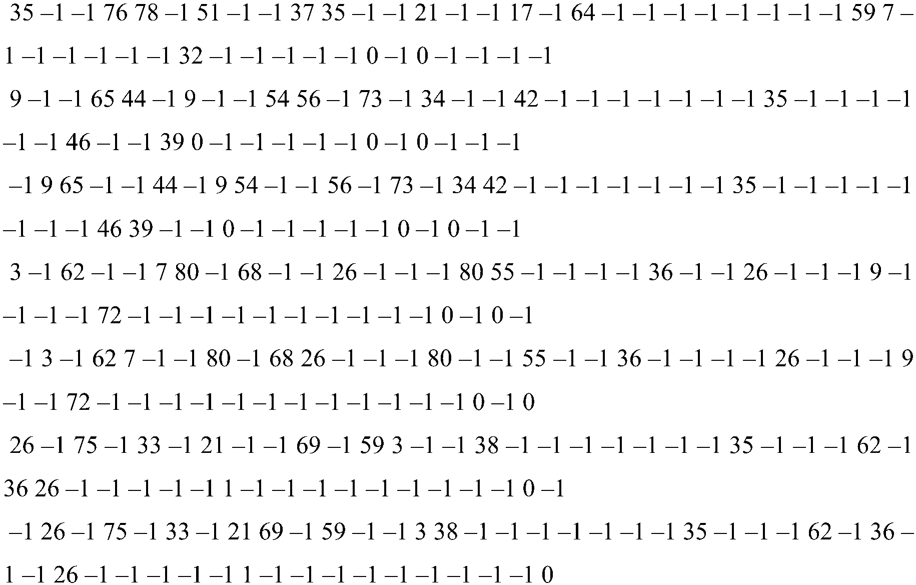

With reference to the first aspect or the second aspect, in a possible implementation, an extension indication matrix corresponding to the matrix 10 is: $\begin{matrix}1 & 1 & 1 & 1 & 0 & 1 & - 1 & - 1 & - 1 & 1 & 1 & 1 & - 1 & - 1 & - 1 & 0 & 1 & 0 & 0 & 0 & - 1 & - 1 & - 1 & - 1 \\ 1 & 1 & 0 & 0 & 0 & 0 & - 1 & - 1 & - 1 & 1 & 0 & 0 & 1 & 1 & - 1 & 1 & - 1 & - 1 & - 1 & 0 & 0 & - 1 & - 1 & - 1 \\ 1 & 0 & 1 & 1 & 0 & 1 & 0 & - 1 & 1 & 1 & - 1 & - 1 & - 1 & 0 & 1 & - 1 & - 1 & 0 & - 1 & - 1 & 0 & 0 & - 1 & - 1 \\ 0 & 1 & 0 & 0 & 1 & 0 & 0 & 0 & 1 & - 1 & - 1 & - 1 & 1 & - 1 & - 1 & - 1 & 0 & 1 & 0 & - 1 & - 1 & 0 & 0 & - 1 \\ 0 & 0 & 1 & 0 & 0 & 1 & - 1 & 1 & 0 & - 1 & 1 & - 1 & 0 & - 1 & 0 & - 1 & 1 & - 1 & - 1 & - 1 & - 1 & - 1 & 0 & 0 \\ 0 & 0 & 0 & 0 & 1 & 1 & 0 & 1 & - 1 & - 1 & - 1 & 1 & - 1 & 1 & 1 & 0 & - 1 & - 1 & 0 & - 1 & - 1 & - 1 & - 1 & 0\end{matrix}$

With reference to the first aspect or the second aspect, in a possible implementation, when a coding rate R of the information bit sequence is 5/6, the matrix prototype of the parity-check matrix is the following matrix 11:

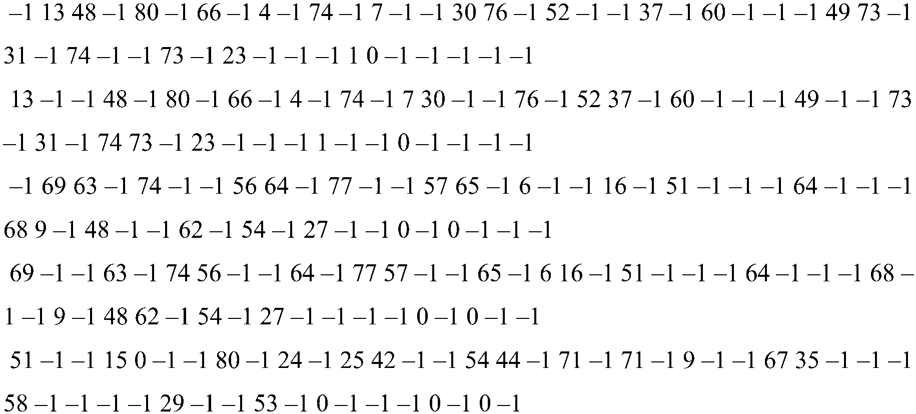

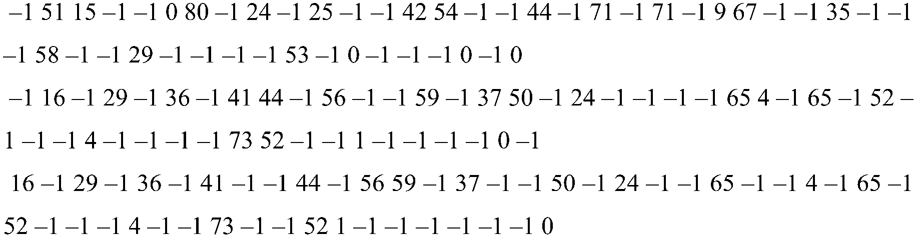

With reference to the first aspect or the second aspect, in a possible implementation, an extension indication matrix corresponding to the matrix 11 is: $\begin{matrix}1 & 0 & 0 & 0 & 0 & 0 & 0 & 1 & 0 & 0 & 1 & 1 & - 1 & 1 & 0 & 0 & 0 & 1 & 1 & - 1 & 1 & 0 & - 1 & - 1 \\ 1 & 0 & 0 & 1 & 0 & 0 & 1 & 0 & 0 & 1 & 1 & - 1 & 1 & - 1 & 1 & 0 & 0 & 1 & 1 & 1 & - 1 & 0 & 0 & - 1 \\ 0 & 1 & 0 & 1 & 1 & 1 & 0 & 1 & 0 & 0 & 0 & 0 & 1 & 0 & - 1 & 0 & - 1 & 1 & - 1 & 0 & 0 & - 1 & 0 & 0 \\ 1 & 1 & 1 & 1 & 0 & 0 & 1 & 1 & 0 & 0 & - 1 & 1 & 0 & 0 & 0 & - 1 & 0 & - 1 & 1 & 0 & 1 & - 1 & - 1 & 0\end{matrix}$

With reference to the first aspect or the second aspect, in a possible implementation, when a coding rate R of the information bit sequence is 5/6, the matrix prototype of the parity-check matrix is the following matrix 12:

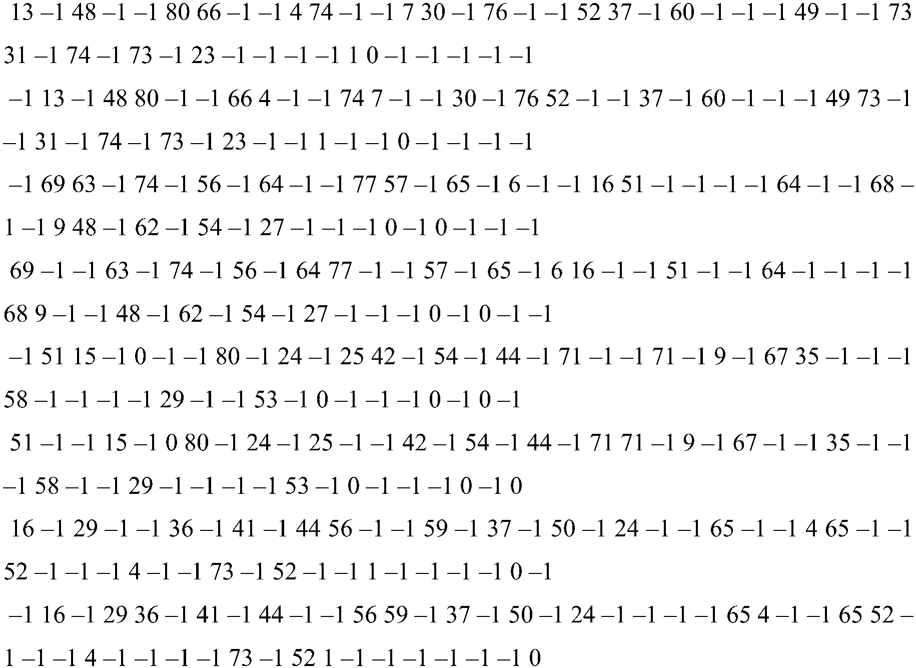

With reference to the first aspect or the second aspect, in a possible implementation, an extension indication matrix corresponding to the matrix 12 is: $\begin{matrix}0 & 0 & 1 & 0 & 1 & 0 & 1 & 0 & 0 & 1 & 0 & 0 & - 1 & 0 & 1 & 0 & 0 & 0 & 0 & - 1 & 1 & 0 & - 1 & - 1 \\ 1 & 0 & 0 & 0 & 0 & 1 & 0 & 0 & 0 & 1 & 0 & - 1 & 1 & - 1 & 0 & 1 & 0 & 0 & 0 & 0 & - 1 & 0 & 0 & - 1 \\ 1 & 0 & 0 & 1 & 1 & 1 & 0 & 0 & 0 & 0 & 1 & 1 & 1 & 0 & - 1 & 0 & - 1 & 1 & - 1 & 0 & 0 & - 1 & 0 & 0 \\ 0 & 0 & 1 & 1 & 1 & 0 & 1 & 1 & 1 & 1 & - 1 & 0 & 1 & 0 & 1 & - 1 & 1 & - 1 & 0 & 0 & 1 & - 1 & - 1 & 0\end{matrix}$

With reference to the first aspect or the second aspect, in a possible implementation, when a coding rate R of the information bit sequence is 5/6, the matrix prototype of the parity-check matrix is the following matrix 13:

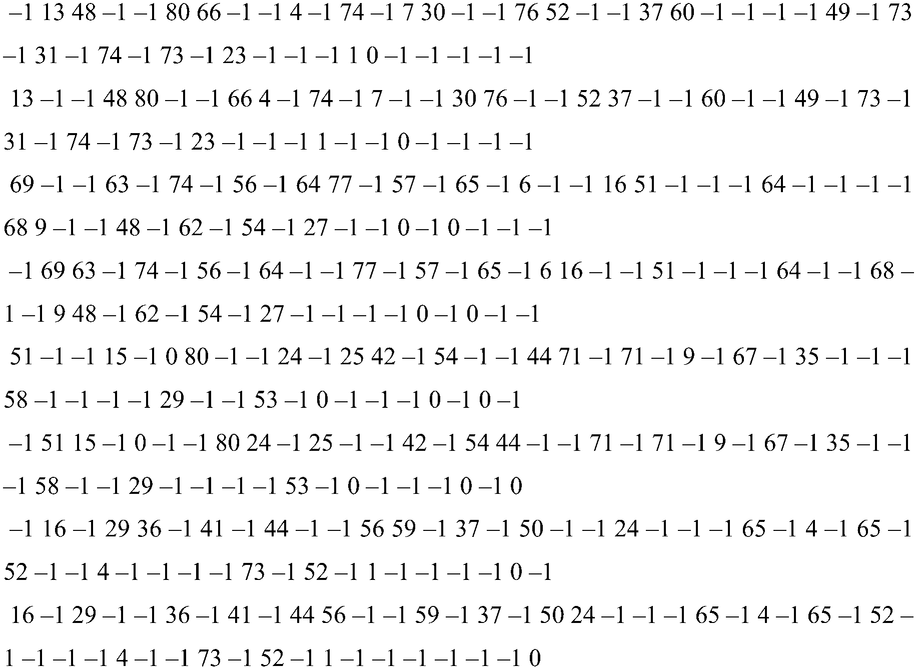

With reference to the first aspect or the second aspect, in a possible implementation, an extension indication matrix corresponding to the matrix 13 is: $\begin{matrix}1 & 0 & 1 & 0 & 1 & 1 & 1 & 0 & 1 & 0 & 1 & 0 & - 1 & 1 & 1 & 1 & 1 & 1 & 1 & - 1 & 1 & 0 & - 1 & - 1 \\ 0 & 1 & 1 & 1 & 1 & 0 & 0 & 0 & 0 & 1 & 0 & - 1 & 0 & - 1 & 1 & 0 & 1 & 1 & 1 & 1 & - 1 & 0 & 0 & - 1 \\ 0 & 1 & 1 & 0 & 1 & 1 & 0 & 0 & 1 & 0 & 0 & 0 & 0 & 0 & - 1 & 0 & - 1 & 1 & - 1 & 0 & 0 & - 1 & 0 & 0 \\ 1 & 1 & 0 & 0 & 0 & 1 & 0 & 0 & 0 & 1 & - 1 & 1 & 1 & 1 & 1 & - 1 & 0 & - 1 & 1 & 1 & 1 & - 1 & - 1 & 0\end{matrix}$

With reference to the first aspect or the second aspect, in a possible implementation, when a coding rate R of the information bit sequence is 5/6, the matrix prototype of the parity-check matrix is the following matrix 14:

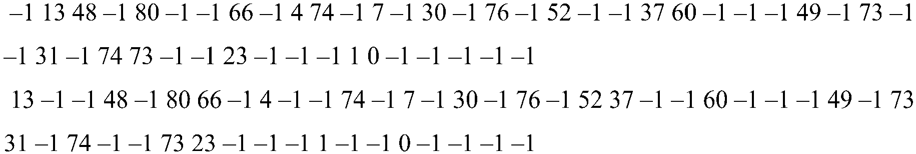

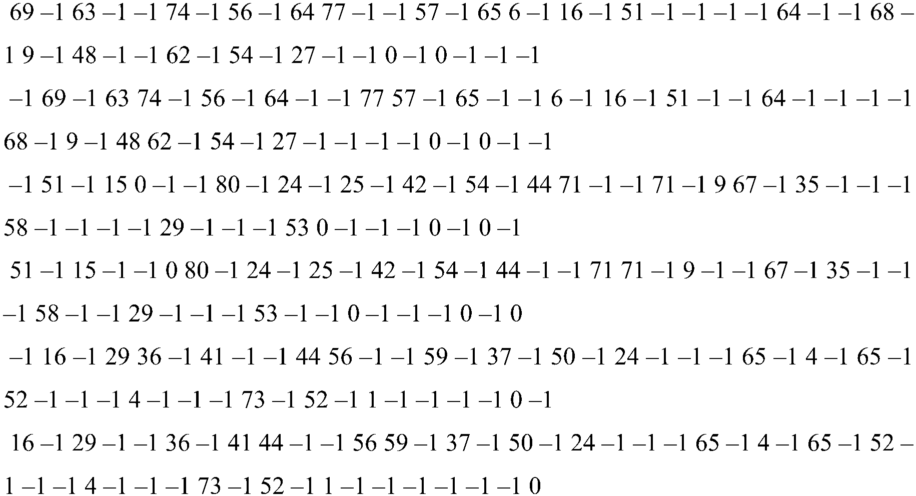

With reference to the first aspect or the second aspect, in a possible implementation, an extension indication matrix corresponding to the matrix 14 is: $\begin{matrix}1 & 0 & 0 & 1 & 1 & 0 & 0 & 0 & 0 & 0 & 1 & 0 & - 1 & 0 & 0 & 1 & 1 & 0 & 1 & - 1 & 1 & 0 & - 1 & - 1 \\ 0 & 0 & 1 & 1 & 1 & 0 & 1 & 1 & 0 & 0 & 0 & - 1 & 1 & - 1 & 0 & 0 & 0 & 1 & 1 & 1 & - 1 & 0 & 0 & - 1 \\ 1 & 1 & 0 & 1 & 1 & 1 & 1 & 1 & 1 & 0 & 1 & 1 & 0 & 0 & - 1 & 0 & - 1 & 1 & - 1 & 1 & 0 & - 1 & 0 & 0 \\ 1 & 1 & 0 & 0 & 1 & 0 & 1 & 1 & 1 & 1 & - 1 & 1 & 1 & 1 & 1 & - 1 & 1 & - 1 & 1 & 1 & 1 & - 1 & - 1 & 0\end{matrix}$

With reference to the first aspect or the second aspect, in a possible implementation, when a coding rate R of the information bit sequence is 1/2, the matrix prototype of the parity-check matrix is the following matrix 15:

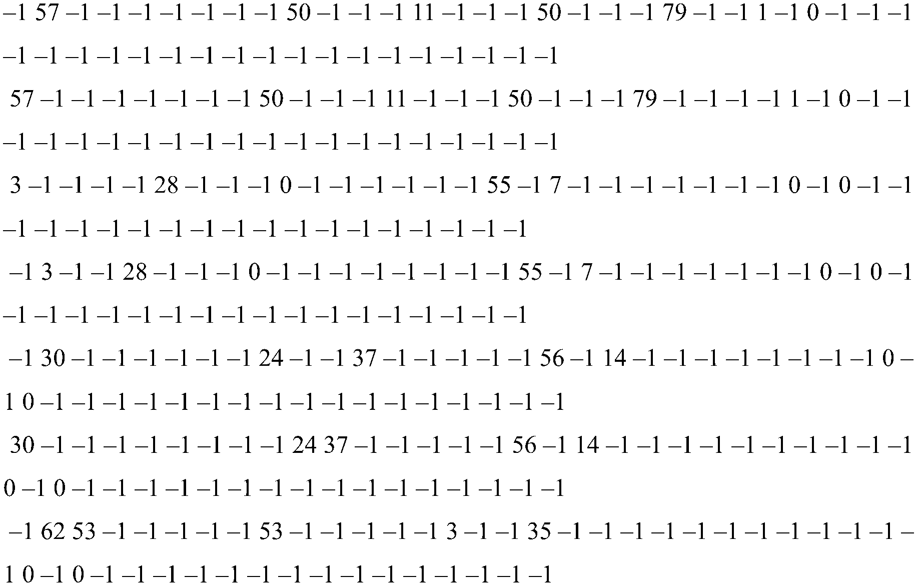

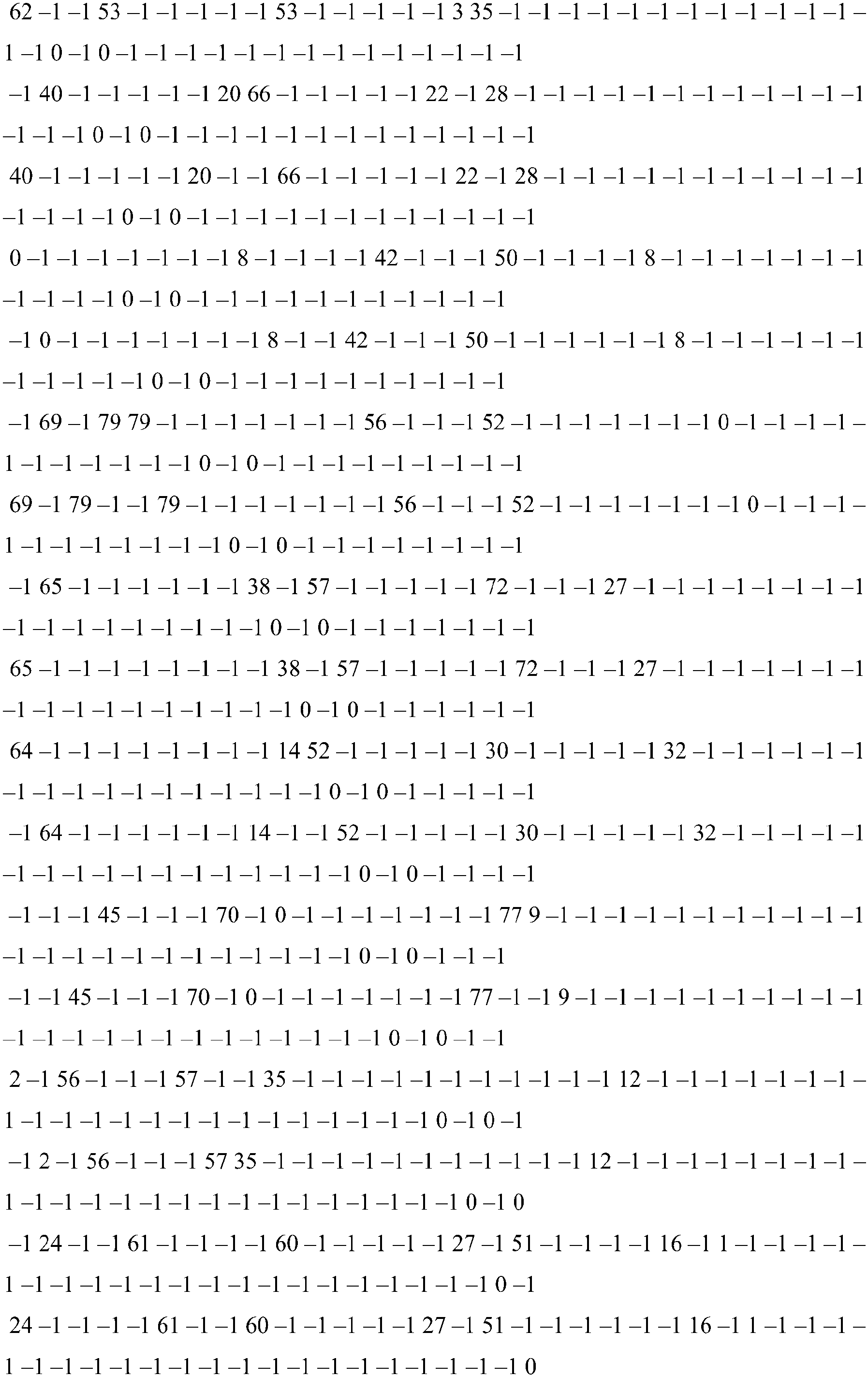

With reference to the first aspect or the second aspect, in a possible implementation, an extension indication matrix corresponding to the matrix 15 is: $\begin{matrix}1 & - 1 & - 1 & - 1 & 1 & - 1 & 1 & - 1 & 1 & - 1 & 1 & - 1 & 0 & 0 & - 1 & - 1 & - 1 & - 1 & - 1 & - 1 & - 1 & - 1 & - 1 & - 1 \\ 0 & - 1 & 1 & - 1 & 1 & - 1 & - 1 & - 1 & 0 & 0 & - 1 & - 1 & - 1 & 0 & 0 & - 1 & - 1 & - 1 & - 1 & - 1 & - 1 & - 1 & - 1 & - 1 \\ 1 & - 1 & - 1 & - 1 & 0 & 1 & - 1 & - 1 & 1 & 1 & - 1 & - 1 & - 1 & - 1 & 0 & 0 & - 1 & - 1 & - 1 & - 1 & - 1 & - 1 & - 1 & - 1 \\ 1 & 0 & - 1 & - 1 & 0 & - 1 & - 1 & 0 & 1 & - 1 & - 1 & - 1 & - 1 & - 1 & - 1 & 0 & 0 & - 1 & - 1 & - 1 & - 1 & - 1 & - 1 & - 1 \\ 1 & - 1 & - 1 & 1 & 0 & - 1 & - 1 & 0 & 0 & - 1 & - 1 & - 1 & - 1 & - 1 & - 1 & - 1 & 0 & 0 & - 1 & - 1 & - 1 & - 1 & - 1 & - 1 \\ 0 & - 1 & - 1 & - 1 & 0 & - 1 & 1 & - 1 & 1 & - 1 & - 1 & 0 & - 1 & - 1 & - 1 & - 1 & - 1 & 0 & 0 & - 1 & - 1 & - 1 & - 1 & - 1 \\ 1 & 1 & 0 & - 1 & - 1 & - 1 & 0 & - 1 & 0 & - 1 & - 1 & - 1 & 0 & - 1 & - 1 & - 1 & - 1 & - 1 & 0 & 0 & - 1 & - 1 & - 1 & - 1 \\ 1 & - 1 & - 1 & - 1 & 0 & 0 & - 1 & - 1 & 0 & - 1 & - 1 & 0 & - 1 & - 1 & - 1 & - 1 & - 1 & - 1 & - 1 & 0 & 0 & - 1 & - 1 & - 1 \\ 0 & - 1 & - 1 & - 1 & 1 & 0 & - 1 & - 1 & 0 & - 1 & - 1 & 0 & - 1 & - 1 & - 1 & - 1 & - 1 & - 1 & - 1 & - 1 & 0 & 0 & - 1 & - 1 \\ - 1 & 1 & - 1 & 1 & 1 & - 1 & - 1 & - 1 & 1 & 0 & - 1 & - 1 & - 1 & - 1 & - 1 & - 1 & - 1 & - 1 & - 1 & - 1 & - 1 & 0 & 0 & - 1 \\ 0 & 0 & - 1 & 0 & 1 & - 1 & - 1 & - 1 & - 1 & - 1 & 1 & - 1 & - 1 & - 1 & - 1 & - 1 & - 1 & - 1 & - 1 & - 1 & - 1 & - 1 & 0 & 0 \\ 1 & - 1 & 0 & - 1 & 1 & - 1 & - 1 & 1 & 1 & - 1 & - 1 & 0 & 0 & - 1 & - 1 & - 1 & - 1 & - 1 & - 1 & - 1 & - 1 & - 1 & - 1 & 0\end{matrix}$

With reference to the first aspect or the second aspect, in a possible implementation, when a coding rate R of the information bit sequence is 1/2, the matrix prototype of the parity-check matrix is the following matrix 16:

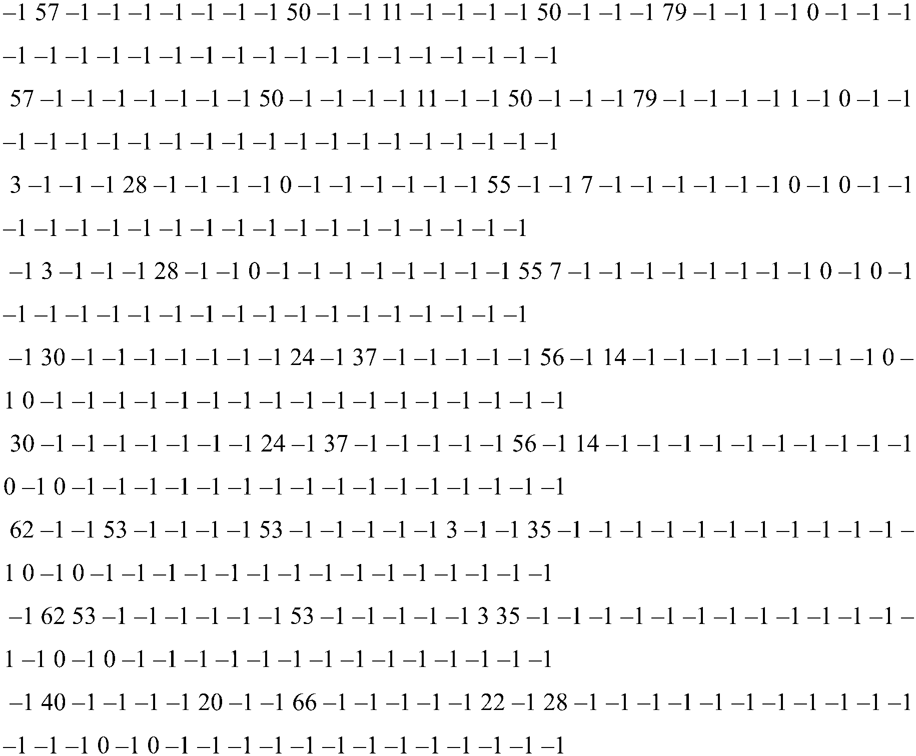

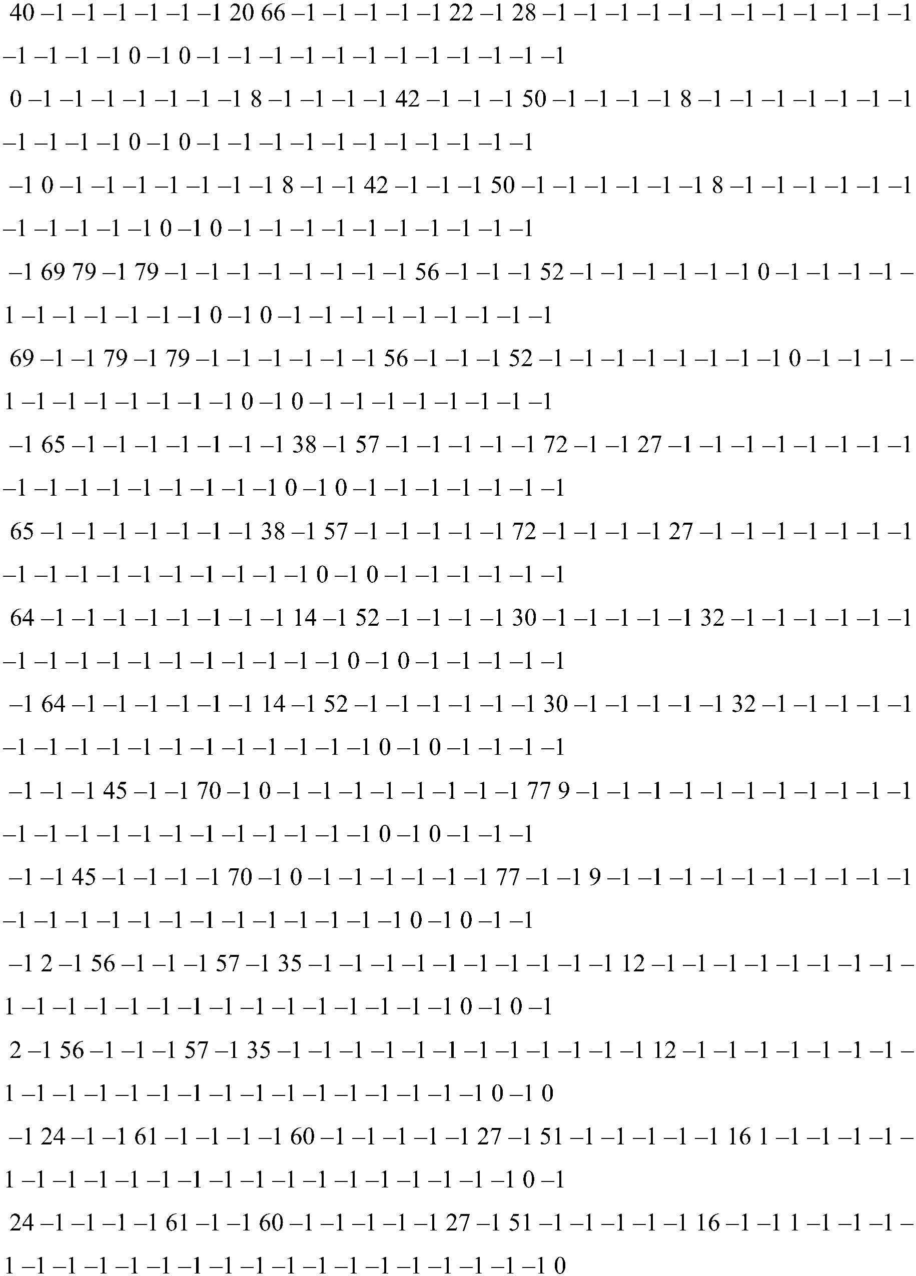

With reference to the first aspect or the second aspect, in a possible implementation, an extension indication matrix corresponding to the matrix 16 is:

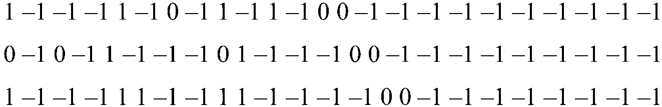

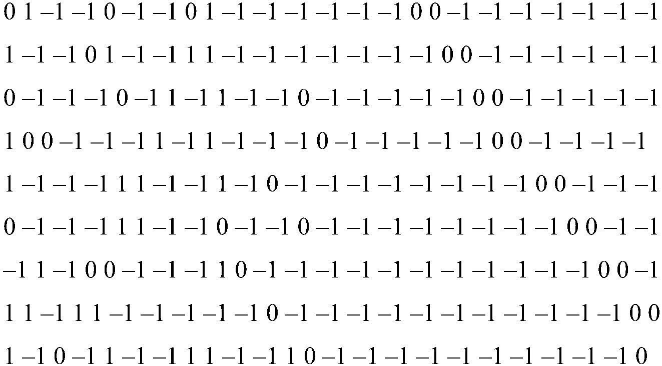

With reference to the first aspect or the second aspect, in a possible implementation, when a coding rate R of the information bit sequence is 2/3, the matrix prototype of the parity-check matrix is the following matrix 17:

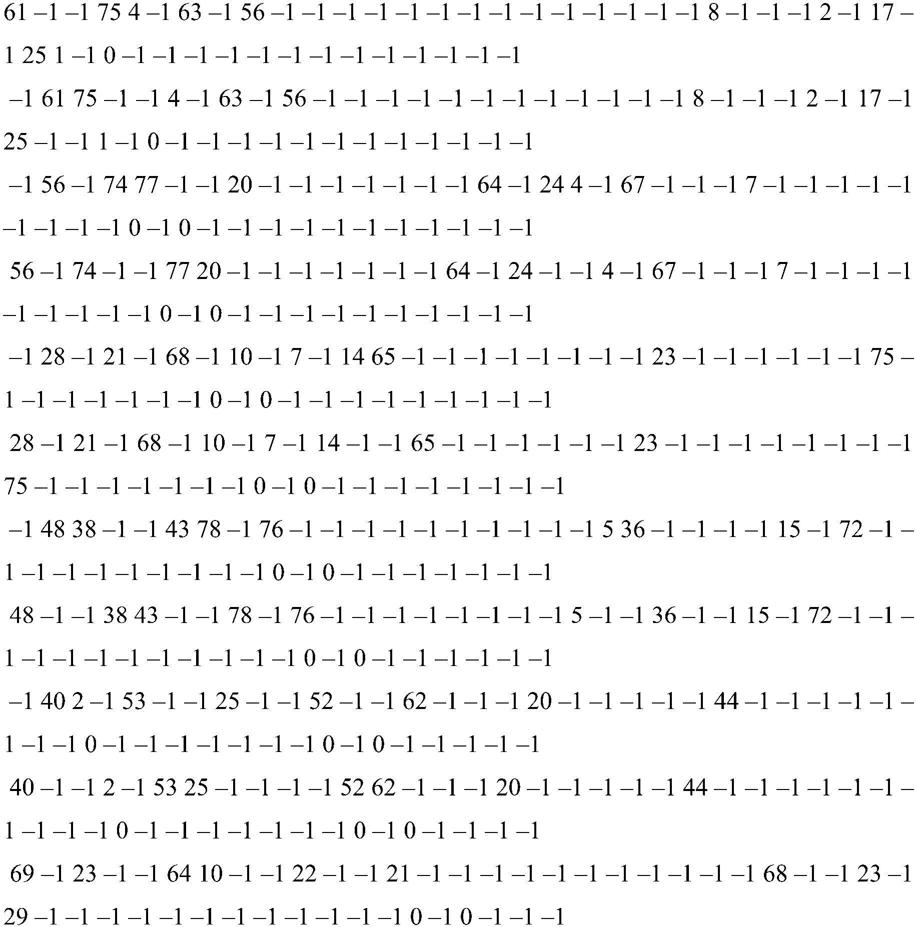

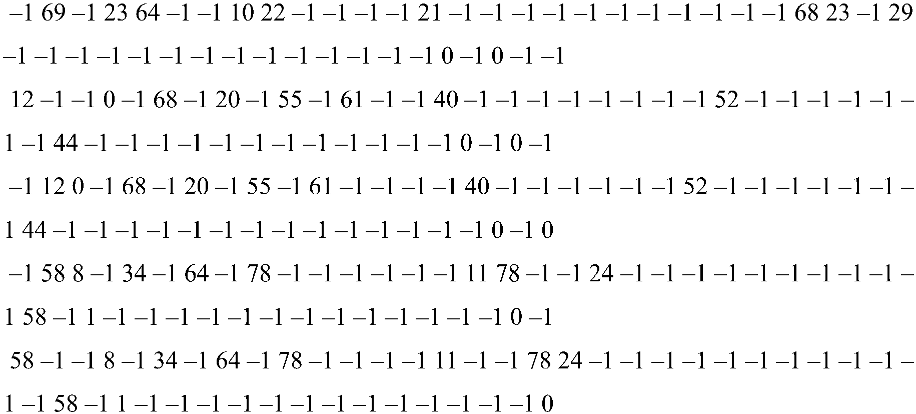

With reference to the first aspect or the second aspect, in a possible implementation, an extension indication matrix corresponding to the matrix 17 is: $\begin{matrix}0 & 1 & 0 & 0 & 0 & - 1 & - 1 & - 1 & - 1 & - 1 & - 1 & 1 & - 1 & 1 & 1 & 1 & 0 & 0 & - 1 & - 1 & - 1 & - 1 & - 1 & - 1 \\ 1 & 1 & 0 & 1 & - 1 & - 1 & - 1 & 1 & 1 & 0 & 0 & - 1 & 0 & - 1 & - 1 & - 1 & - 1 & 0 & 0 & - 1 & - 1 & - 1 & - 1 & - 1 \\ 1 & 1 & 1 & 1 & 1 & 1 & 0 & - 1 & - 1 & - 1 & 1 & - 1 & - 1 & - 1 & 0 & - 1 & - 1 & - 1 & 0 & 0 & - 1 & - 1 & - 1 & - 1 \\ 1 & 0 & 1 & 0 & 0 & - 1 & - 1 & - 1 & - 1 & 1 & 0 & - 1 & 1 & 1 & - 1 & - 1 & - 1 & - 1 & - 1 & 0 & 0 & - 1 & - 1 & - 1 \\ 1 & 0 & 0 & 1 & - 1 & 0 & 1 & - 1 & 1 & - 1 & - 1 & 1 & - 1 & - 1 & - 1 & - 1 & 0 & - 1 & - 1 & - 1 & 0 & 0 & - 1 & - 1 \\ 0 & 0 & 1 & 0 & 1 & - 1 & 0 & - 1 & - 1 & - 1 & - 1 & - 1 & 0 & 1 & 1 & - 1 & - 1 & - 1 & - 1 & - 1 & - 1 & 0 & 0 & - 1 \\ 0 & 1 & 1 & 1 & 1 & 1 & - 1 & 0 & - 1 & - 1 & - 1 & 1 & - 1 & - 1 & - 1 & 1 & - 1 & - 1 & - 1 & - 1 & - 1 & - 1 & 0 & 0 \\ 1 & 0 & 0 & 0 & 0 & - 1 & - 1 & 1 & 0 & 1 & - 1 & - 1 & - 1 & - 1 & - 1 & 0 & 0 & - 1 & - 1 & - 1 & - 1 & - 1 & - 1 & 0\end{matrix}$

With reference to the first aspect or the second aspect, in a possible implementation, when a coding rate R of the information bit sequence is 2/3, the matrix prototype of the parity-check matrix is the following matrix 18:

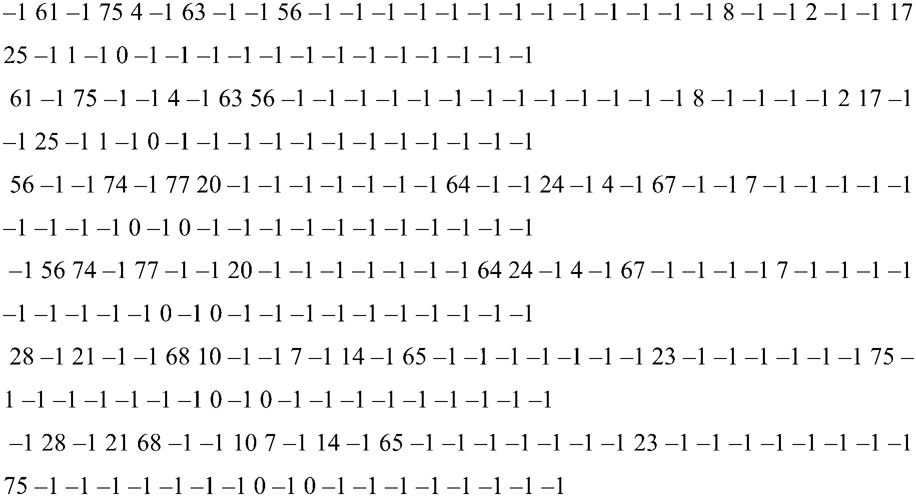

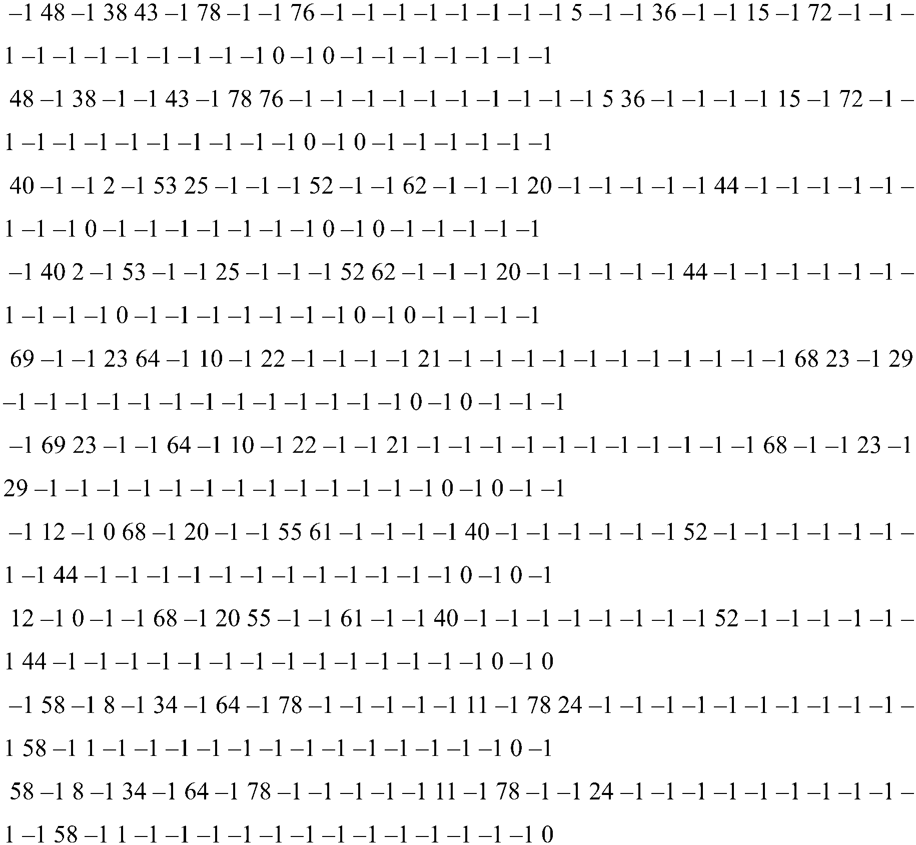

With reference to the first aspect or the second aspect, in a possible implementation, an extension indication matrix corresponding to the matrix 18 is: $\begin{matrix}1 & 1 & 0 & 0 & 1 & - 1 & - 1 & - 1 & - 1 & - 1 & - 1 & 1 & - 1 & 0 & 1 & 0 & 0 & 0 & - 1 & - 1 & - 1 & - 1 & - 1 & - 1 \\ 0 & 1 & 1 & 0 & - 1 & - 1 & - 1 & 0 & 1 & 1 & 1 & - 1 & 0 & - 1 & - 1 & - 1 & - 1 & 0 & 0 & - 1 & - 1 & - 1 & - 1 & - 1 \\ 0 & 0 & 1 & 0 & 1 & 1 & 1 & - 1 & - 1 & - 1 & 1 & - 1 & - 1 & - 1 & 0 & - 1 & - 1 & - 1 & 0 & 0 & - 1 & - 1 & - 1 & - 1 \\ 1 & 1 & 0 & 0 & 1 & - 1 & - 1 & - 1 & - 1 & 0 & 1 & - 1 & 0 & 0 & - 1 & - 1 & - 1 & - 1 & - 1 & 0 & 0 & - 1 & - 1 & - 1 \\ 0 & 1 & 1 & 0 & - 1 & 0 & 1 & - 1 & 1 & - 1 & - 1 & 1 & - 1 & - 1 & - 1 & - 1 & 0 & - 1 & - 1 & - 1 & 0 & 0 & - 1 & - 1 \\ 0 & 1 & 0 & 0 & 0 & - 1 & 1 & - 1 & - 1 & - 1 & - 1 & - 1 & 1 & 0 & 0 & - 1 & - 1 & - 1 & - 1 & - 1 & - 1 & 0 & 0 & - 1 \\ 1 & 1 & 0 & 0 & 1 & 0 & - 1 & 1 & - 1 & - 1 & - 1 & 0 & - 1 & - 1 & - 1 & 1 & - 1 & - 1 & - 1 & - 1 & - 1 & - 1 & 0 & 0 \\ 1 & 1 & 1 & 1 & 1 & - 1 & - 1 & 1 & 1 & 0 & - 1 & - 1 & - 1 & - 1 & - 1 & 0 & 0 & - 1 & - 1 & - 1 & - 1 & - 1 & - 1 & 0\end{matrix}$

With reference to the first aspect or the second aspect, in a possible implementation, when a coding rate R of the information bit sequence is 3/4, the matrix prototype of the parity-check matrix is the following matrix 19:

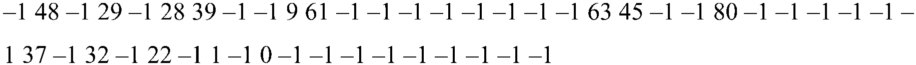

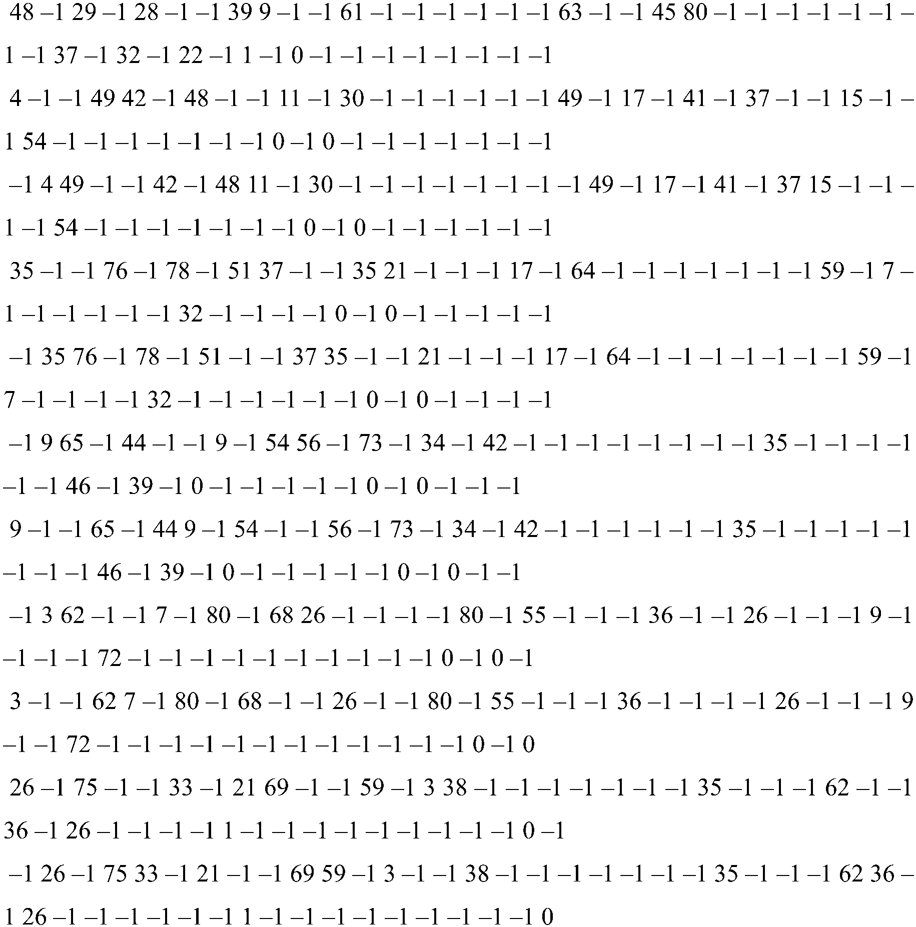

With reference to the first aspect or the second aspect, in a possible implementation, an extension indication matrix corresponding to the matrix 19 is: $\begin{matrix}1 & 1 & 1 & 0 & 1 & 0 & - 1 & - 1 & - 1 & 1 & 0 & 1 & - 1 & - 1 & - 1 & 0 & 0 & 0 & 0 & 0 & - 1 & - 1 & - 1 & - 1 \\ 0 & 1 & 0 & 0 & 1 & 1 & - 1 & - 1 & - 1 & 0 & 0 & 0 & 0 & 1 & - 1 & 0 & - 1 & - 1 & - 1 & 0 & 0 & - 1 & - 1 & - 1 \\ 0 & 1 & 1 & 1 & 0 & 1 & 0 & - 1 & 0 & 0 & - 1 & - 1 & - 1 & 0 & 0 & - 1 & - 1 & 1 & - 1 & - 1 & 0 & 0 & - 1 & - 1 \\ 1 & 0 & 0 & 1 & 1 & 0 & 0 & 0 & 0 & - 1 & - 1 & - 1 & 1 & - 1 & - 1 & - 1 & 0 & 0 & 0 & - 1 & - 1 & 0 & 0 & - 1 \\ 1 & 0 & 1 & 1 & 1 & 0 & - 1 & 1 & 1 & - 1 & 1 & - 1 & 0 & - 1 & 0 & - 1 & 1 & - 1 & - 1 & - 1 & - 1 & - 1 & 0 & 0 \\ 0 & 0 & 1 & 1 & 0 & 1 & 1 & 0 & - 1 & - 1 & - 1 & 0 & - 1 & 0 & 1 & 1 & - 1 & - 1 & 0 & - 1 & - 1 & - 1 & 1 & 0\end{matrix}$

With reference to the first aspect or the second aspect, in a possible implementation, when a coding rate R of the information bit sequence is 3/4, the matrix prototype of the parity-check matrix is the following matrix 20:

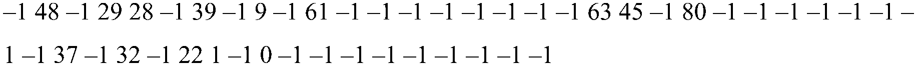

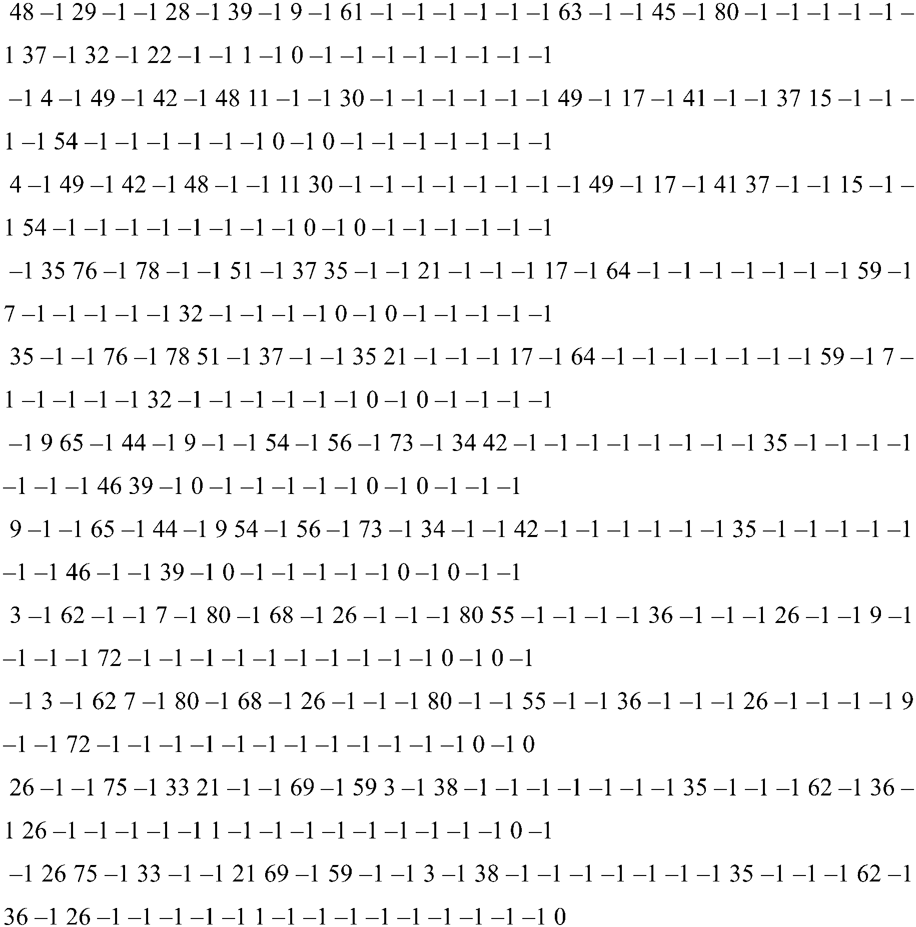

With reference to the first aspect or the second aspect, in a possible implementation, an extension indication matrix corresponding to the matrix 20 is: $\begin{matrix}1 & 1 & 0 & 0 & 0 & 0 & - 1 & - 1 & - 1 & 1 & 0 & 0 & - 1 & - 1 & - 1 & 1 & 1 & 1 & 0 & 0 & - 1 & - 1 & - 1 & - 1 \\ 1 & 1 & 1 & 1 & 0 & 1 & - 1 & - 1 & - 1 & 0 & 0 & 0 & 1 & 0 & - 1 & 1 & - 1 & - 1 & - 1 & 0 & 0 & - 1 & - 1 & - 1 \\ 1 & 0 & 0 & 1 & 1 & 0 & 1 & - 1 & 1 & 1 & - 1 & - 1 & - 1 & 1 & 1 & - 1 & - 1 & 1 & - 1 & - 1 & 0 & 0 & - 1 & - 1 \\ 1 & 0 & 0 & 0 & 1 & 1 & 1 & 1 & 0 & - 1 & - 1 & - 1 & 1 & - 1 & - 1 & - 1 & 1 & 0 & 0 & - 1 & - 1 & 0 & 0 & - 1 \\ 0 & 0 & 1 & 1 & 1 & 1 & - 1 & 1 & 0 & - 1 & 1 & - 1 & 1 & - 1 & 0 & - 1 & 1 & - 1 & - 1 & - 1 & - 1 & - 1 & 0 & 0 \\ 0 & 1 & 1 & 0 & 1 & 1 & 0 & 0 & - 1 & - 1 & - 1 & 0 & - 1 & 0 & 0 & 0 & - 1 & - 1 & 0 & - 1 & - 1 & - 1 & - 1 & 0\end{matrix}$

With reference to the first aspect or the second aspect, in a possible implementation, when a coding rate R of the information bit sequence is 5/6, the matrix prototype of the parity-check matrix is the following matrix 21:

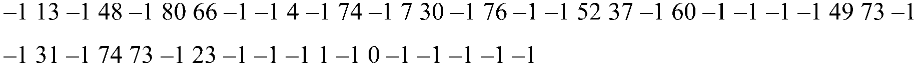

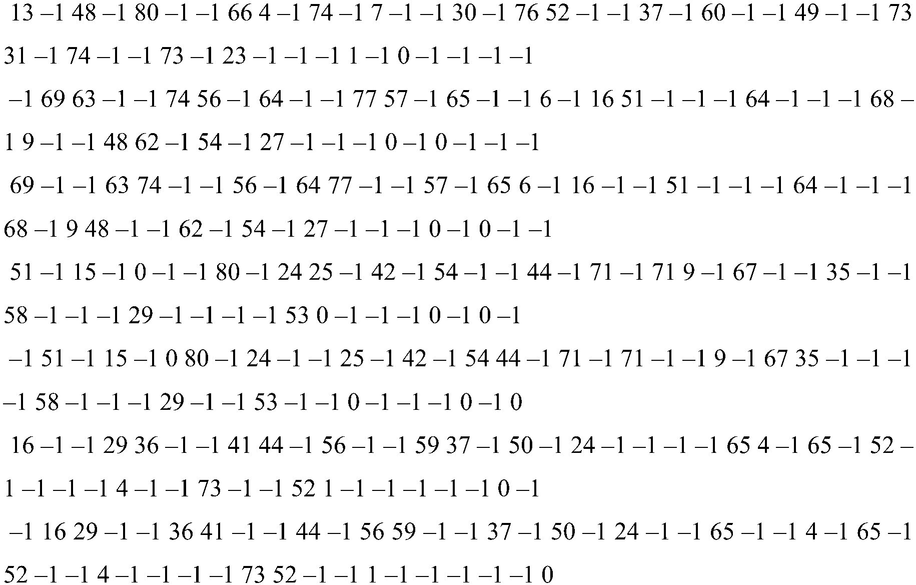

With reference to the first aspect or the second aspect, in a possible implementation, an extension indication matrix corresponding to the matrix 21 is: $\begin{matrix}1 & 1 & 1 & 0 & 1 & 1 & 1 & 0 & 0 & 1 & 0 & 0 & - 1 & 1 & 0 & 1 & 1 & 0 & 0 & - 1 & 0 & 0 & - 1 & - 1 \\ 1 & 0 & 1 & 0 & 0 & 1 & 0 & 0 & 1 & 1 & 0 & - 1 & 0 & - 1 & 0 & 0 & 1 & 0 & 0 & 0 & - 1 & 0 & 0 & - 1 \\ 0 & 0 & 0 & 1 & 1 & 0 & 0 & 0 & 1 & 1 & 1 & 0 & 0 & 1 & - 1 & 0 & - 1 & 0 & - 1 & 1 & 0 & - 1 & 0 & 0 \\ 0 & 1 & 0 & 1 & 0 & 0 & 1 & 0 & 0 & 0 & - 1 & 1 & 0 & 0 & 0 & - 1 & 1 & - 1 & 0 & 1 & 0 & - 1 & - 1 & 0\end{matrix}$

With reference to the first aspect or the second aspect, in a possible implementation, when a coding rate R of the information bit sequence is 5/6, the matrix prototype of the parity-check matrix is the following matrix 22:

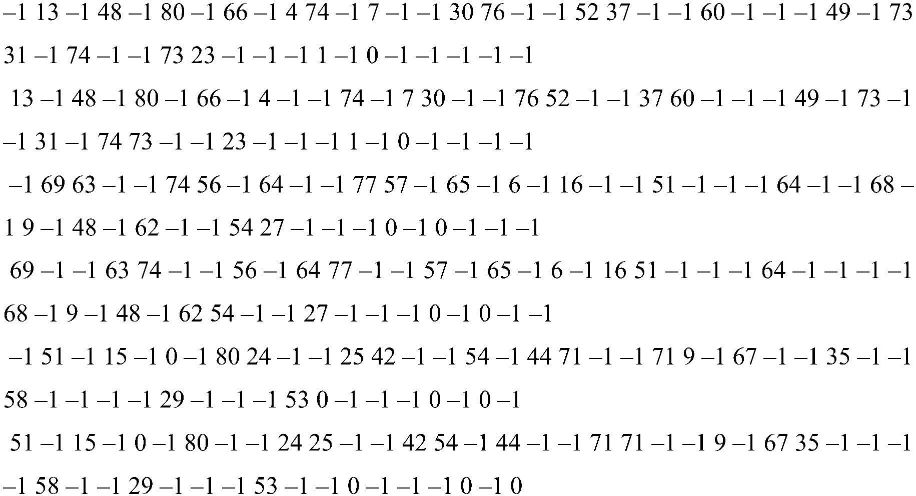

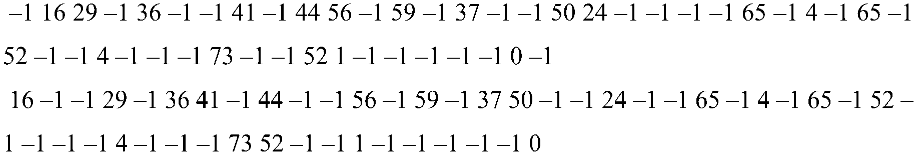

With reference to the first aspect or the second aspect, in a possible implementation, an extension indication matrix corresponding to the matrix 22 is: $\begin{matrix}1 & 1 & 1 & 1 & 1 & 0 & 0 & 1 & 0 & 1 & 0 & 1 & - 1 & 1 & 1 & 0 & 0 & 1 & 0 & - 1 & 0 & 0 & - 1 & - 1 \\ 1 & 0 & 1 & 0 & 0 & 1 & 0 & 0 & 0 & 0 & 1 & - 1 & 1 & - 1 & 0 & 0 & 0 & 0 & 1 & 0 & - 1 & 0 & 0 & - 1 \\ 1 & 1 & 1 & 1 & 0 & 1 & 0 & 1 & 1 & 0 & 1 & 0 & 0 & 1 & - 1 & 0 & - 1 & 1 & - 1 & 1 & 0 & - 1 & 0 & 0 \\ 1 & 0 & 0 & 1 & 1 & 0 & 0 & 0 & 1 & 0 & - 1 & 1 & 1 & 1 & 1 & - 1 & 0 & - 1 & 0 & 1 & 0 & - 1 & - 1 & 0\end{matrix}$

According to a third aspect, an embodiment of this application provides a first communication apparatus, configured to perform the method according to the first aspect or any possible implementation. The first communication apparatus includes a module configured to perform the method according to the first aspect or any possible implementation.

According to a fourth aspect, an embodiment of this application provides a second communication apparatus, configured to perform the method according to the second aspect or any possible implementation. The second communication apparatus includes a module configured to perform the method according to the second aspect or any possible implementation.

According to a fifth aspect, an embodiment of this application provides a first communication apparatus. The first communication apparatus includes a processor, configured to perform the method according to the first aspect or any possible implementation. The processor is configured to execute a program stored in a memory. When the program is executed, the method according to the first aspect or any possible implementation is performed.

In a possible implementation, the memory is located outside the first communication apparatus.

In a possible implementation, the memory is located inside the first communication apparatus.

In this embodiment of this application, the processor and the memory may alternatively be integrated into one component. In other words, the processor and the memory may alternatively be integrated together. For example, the first communication apparatus may be a chip.

In a possible implementation, the first communication apparatus further includes a transceiver. The transceiver is configured to receive information or send information.

According to a sixth aspect, an embodiment of this application provides a second communication apparatus. The second communication apparatus includes a processor, configured to perform the method according to the second aspect or any possible implementation. The processor is configured to execute a program stored in a memory. When the program is executed, the method according to the second aspect or any possible implementation is performed.

In a possible implementation, the memory is located outside the second communication apparatus.

In a possible implementation, the memory is located inside the second communication apparatus.

In this embodiment of this application, the processor and the memory may alternatively be integrated into one component. In other words, the processor and the memory may alternatively be integrated together. For example, the second communication apparatus may be a chip.

In a possible implementation, the second communication apparatus further includes a transceiver. The transceiver is configured to receive information or send information.

According to a seventh aspect, an embodiment of this application provides a first communication apparatus. The first communication apparatus includes a logic circuit and an interface. The logic circuit is coupled to the interface. The interface is configured to input and/or output information. The logic circuit is configured to perform the method according to the first aspect or any one of the possible implementations.

According to an eighth aspect, an embodiment of this application provides a second communication apparatus. The second communication apparatus includes a logic circuit and an interface. The logic circuit is coupled to the interface. The interface is configured to input and/or output information. The logic circuit is configured to perform the method according to the second aspect or any one of the possible implementations.

According to a ninth aspect, an embodiment of this application provides a computer-readable storage medium. The computer-readable storage medium is configured to store a computer program. When the computer program is run on a computer, the method according to any one of the first aspect to the second aspect or any possible implementation is performed.

According to a tenth aspect, an embodiment of this application provides a computer program product. When the computer program product is run on a computer, the method according to any one of the first aspect to the second aspect or any possible implementation is performed.

According to an eleventh aspect, an embodiment of this application provides a computer program. When the computer program is run on a computer, the method according to any one of the first aspect to the second aspect or any possible implementation is performed.

According to a twelfth aspect, an embodiment of this application provides a communication system. The communication system includes a first communication apparatus and/or a second communication apparatus. The first communication apparatus is configured to perform the method according to the first aspect or any possible implementation of the first aspect, and the second communication apparatus is configured to perform the method according to the second aspect or any possible implementation of the second aspect.

### BRIEF DESCRIPTION OF DRAWINGS

FIG. 1a is a diagram of a matrix prototype of a reference parity-check matrix according to an embodiment of this application;
FIG. 1b is a diagram of a CPM according to an embodiment of this application;
FIG. 2a is a diagram of an architecture of a communication system according to an embodiment of this application;
FIG. 2b is a diagram of an architecture of a communication system according to an embodiment of this application;
FIG. 2c is a diagram of an architecture of a communication system according to an embodiment of this application;
FIG. 3 is a schematic flowchart of an encoding method and a decoding method according to an embodiment of this application;
FIG. 4a is a diagram of a matrix prototype of a parity-check matrix according to an embodiment of this application;
FIG. 4b is a diagram of an extension indication matrix corresponding to FIG. 4a according to an embodiment of this application;
FIG. 5a is a diagram of a matrix prototype of a parity-check matrix according to an embodiment of this application;
FIG. 5b is a diagram of an extension indication matrix corresponding to FIG. 5a according to an embodiment of this application;
FIG. 6a is a diagram of a matrix prototype of a parity-check matrix according to an embodiment of this application;
FIG. 6b is a diagram of an extension indication matrix corresponding to FIG. 6a according to an embodiment of this application;
FIG. 7a is a diagram of a matrix prototype of a parity-check matrix according to an embodiment of this application;
FIG. 7b is a diagram of an extension indication matrix corresponding to FIG. 7a according to an embodiment of this application;
FIG. 8a is a diagram of a matrix prototype of a parity-check matrix according to an embodiment of this application;
FIG. 8b is a diagram of an extension indication matrix corresponding to FIG. 8a according to an embodiment of this application;
FIG. 9a is a diagram of a matrix prototype of a parity-check matrix according to an embodiment of this application;
FIG. 9b is a diagram of an extension indication matrix corresponding to FIG. 9a according to an embodiment of this application;
FIG. 10a is a diagram of a matrix prototype of a parity-check matrix according to an embodiment of this application;
FIG. 10b is a diagram of an extension indication matrix corresponding to FIG. 10a according to an embodiment of this application;
FIG. 11a is a diagram of a matrix prototype of a parity-check matrix according to an embodiment of this application;
FIG. 11b is a diagram of an extension indication matrix corresponding to FIG. 11a according to an embodiment of this application;
FIG. 12a is a diagram of a matrix prototype of a parity-check matrix according to an embodiment of this application;
FIG. 12b is a diagram of an extension indication matrix corresponding to FIG. 12a according to an embodiment of this application;
FIG. 13a is a diagram of a matrix prototype of a parity-check matrix according to an embodiment of this application;
FIG. 13b is a diagram of an extension indication matrix corresponding to FIG. 13a according to an embodiment of this application;
FIG. 13c is a diagram of an extension indication matrix corresponding to FIG. 13a according to an embodiment of this application;
FIG. 14a is a diagram of a matrix prototype of a parity-check matrix according to an embodiment of this application;
FIG. 14b is a diagram of an extension indication matrix corresponding to FIG. 14a according to an embodiment of this application;
FIG. 15a is a diagram of a matrix prototype of a parity-check matrix according to an embodiment of this application;
FIG. 15b is a diagram of an extension indication matrix corresponding to FIG. 15a according to an embodiment of this application;
FIG. 16a is a diagram of a matrix prototype of a parity-check matrix according to an embodiment of this application;
FIG. 16b is a diagram of an extension indication matrix corresponding to FIG. 16a according to an embodiment of this application;
FIG. 17a is a diagram of a matrix prototype of a parity-check matrix according to an embodiment of this application;
FIG. 17b is a diagram of an extension indication matrix corresponding to FIG. 17a according to an embodiment of this application;
FIG. 18 is a diagram of a part of a shortening operation in LDPC encoding according to an embodiment of this application;
FIG. 19a is a diagram of performing diagonal extension on element i according to an embodiment of this application;
FIG. 19b is a diagram of performing anti-diagonal extension on element i according to an embodiment of this application;
FIG. 20a is a diagram of two options of diagonal extension and anti-diagonal extension according to an embodiment of this application;
FIG. 20b is a diagram of a tree expansion according to an embodiment of this application;
FIG. 21a is a diagram of a simulation result according to an embodiment of this application;
FIG. 21b is a diagram of a simulation result according to an embodiment of this application;
FIG. 21c is a diagram of a simulation result according to an embodiment of this application;
FIG. 21d is a diagram of a simulation result according to an embodiment of this application;
FIG. 22 is a diagram of a structure of a communication apparatus according to an embodiment of this application;
FIG. 23 is a diagram of a structure of a communication apparatus according to an embodiment of this application;
FIG. 24 is a diagram of a structure of a communication apparatus according to an embodiment of this application;
FIG. 25 is a diagram of a grouping design for a matrix prototype of a basic parity-check matrix according to an embodiment of this application;
FIG. 26a and FIG. 26b are diagrams of an extension indication matrix according to an embodiment of this application;
FIG. 27a is a diagram of a matrix prototype of a parity-check matrix according to an embodiment of this application;
FIG. 27b is a diagram of an extension indication matrix corresponding to FIG. 27a according to an embodiment of this application;
FIG. 28a is a diagram of a matrix prototype of a parity-check matrix according to an embodiment of this application;
FIG. 28b is a diagram of an extension indication matrix corresponding to FIG. 28a according to an embodiment of this application;
FIG. 29a is a diagram of a matrix prototype of a parity-check matrix according to an embodiment of this application;
FIG. 29b is a diagram of an extension indication matrix corresponding to FIG. 29a according to an embodiment of this application;
FIG. 30a is a diagram of a matrix prototype of a parity-check matrix according to an embodiment of this application;
FIG. 30b is a diagram of an extension indication matrix corresponding to FIG. 30a according to an embodiment of this application;
FIG. 31a is a diagram of a matrix prototype of a parity-check matrix according to an embodiment of this application;
FIG. 31b is a diagram of an extension indication matrix corresponding to FIG. 31a according to an embodiment of this application;
FIG. 32a is a diagram of a matrix prototype of a parity-check matrix according to an embodiment of this application;
FIG. 32b is a diagram of an extension indication matrix corresponding to FIG. 32a according to an embodiment of this application;
FIG. 33a is a diagram of a matrix prototype of a parity-check matrix according to an embodiment of this application;
FIG. 33b is a diagram of an extension indication matrix corresponding to FIG. 33a according to an embodiment of this application;
FIG. 34a is a diagram of a matrix prototype of a parity-check matrix according to an embodiment of this application;
FIG. 34b is a diagram of an extension indication matrix corresponding to FIG. 34a according to an embodiment of this application;
FIG. 35a is a diagram of a matrix prototype of a parity-check matrix according to an embodiment of this application;
FIG. 35b is a diagram of an extension indication matrix corresponding to FIG. 35a according to an embodiment of this application;
FIG. 36a is a diagram of a matrix prototype of a parity-check matrix according to an embodiment of this application;
FIG. 36b is a diagram of an extension indication matrix corresponding to FIG. 36a according to an embodiment of this application;
FIG. 37a is a diagram of a matrix prototype of a parity-check matrix according to an embodiment of this application; and
FIG. 37b is a diagram of an extension indication matrix corresponding to FIG. 31a according to an embodiment of this application.

### DESCRIPTION OF EMBODIMENTS

For ease of understanding technical solutions in this application, the following further describes this application with reference to accompanying drawings.

Terms "first", "second", and the like in the specification, claims, and accompanying drawings of this application are merely intended to distinguish between different objects but do not indicate a particular order. In addition, the terms "include", "have", and any other variant thereof are intended to cover a non-exclusive inclusion. For example, a process, a method, a system, a product, or a device that includes a series of steps or units is not limited to the listed steps or units, but optionally further includes an unlisted step or unit, or optionally further includes another inherent step or unit of the process, the method, the product, or the device.

An "embodiment" mentioned in this specification means that a particular feature, structure, or characteristic described with reference to this embodiment may be included in at least one embodiment of this application. The phrase shown in various locations in the specification may not necessarily refer to a same embodiment, and is not an independent or optional embodiment exclusive from another embodiment. It may be explicitly and implicitly understood by a person skilled in the art that embodiments described in the specification may be combined with another embodiment.

In this application, "at least one (item)" means one or more, "a plurality of" means two or more, "at least two (items)" means two or three or more. "And/or" is used to describe an association relationship between associated objects, and indicates that three relationships may exist. For example, "A and/or B" may indicate the following three cases: Only A exists, only B exists, and both A and B exist, where A and B may be singular or plural. "Or" indicates that two relationships may exist, for example, only A exists and only B exists. When A and B are not mutually exclusive, it may indicate that three relationships exist, for example, only A exists, only B exists, and both A and B exist. The character "/" generally indicates an "or" relationship between the associated objects. "At least one of the following" or a similar expression thereof means any combination of these items. For example, at least one of a, b, or c may indicate: a, b, c, "a and b", "a and c", "b and c", or "a and b and c".

An LDPC code used in standards such as IEEE 802.11ac/ax is a quasi cyclic (quasi cyclic, QC) LDPC (QC-LDPC) code. The QC-LDPC code is a structured LDPC code that is widely used. A parity-check matrix of the QC-LDPC code has a unique structure, and encoding may be implemented by using a simple feedback shift register. Therefore, a problem of encoding complexity of the LDPC code can be well resolved.

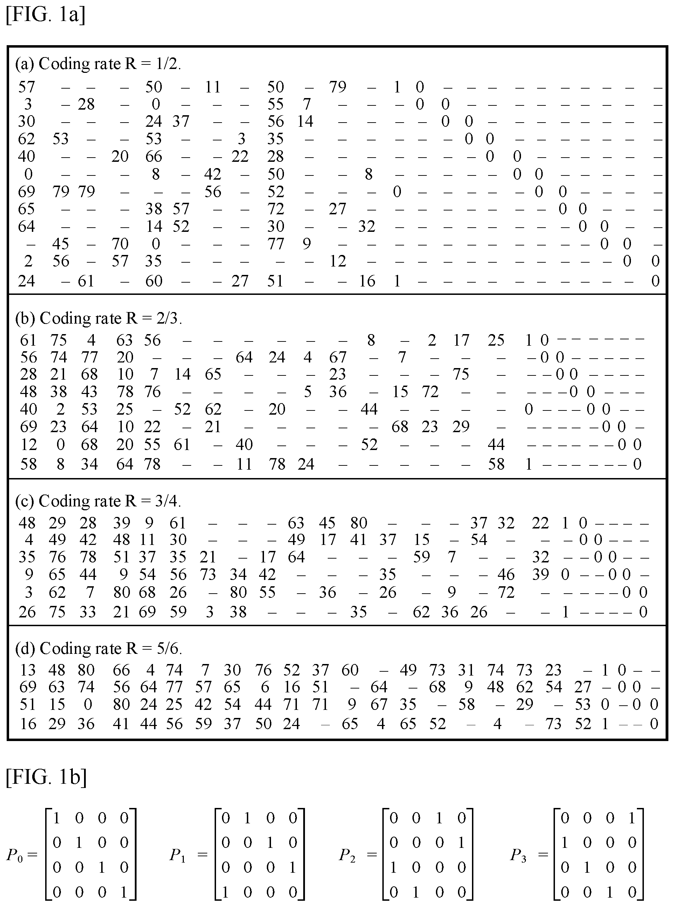

Currently, a total of 12 LDPC code parity-check matrices are used in a standard. There are three types of code lengths N: N=648, N=1296, or N=1944. Each code length may support four different coding rates (coding rates): 1/2, 2/3, 3/4, and 5/6. A matrix prototype of the parity-check matrix in each code length and coding rate is different, and a parity bit part (a matrix corresponding to a parity bit or a parity-check square matrix shown below) in matrix prototypes of 12 parity-check matrices with different code lengths and coding rates has a same structure. For example, selection of a coding rate may be determined by a current transmission system based on a modulation and coding scheme (modulation and coding scheme, MCS) selected by link adaptation. Therefore, a communication apparatus in a wireless local area network (wireless local area network, WLAN) may select one parity-check matrix from the 12 parity-check matrices based on a given code length and coding rate. The foregoing having a same structure may be understood as that in the parity bit part in the matrix prototypes of different parity-check matrices in FIG. 1a, elements in a first row and a first column are all 1, and elements in a last row and the first column are all 1. As shown in FIG. 1a, the first column of the parity bit part in the first matrix is a thirteenth column in the matrix prototype of the parity-check matrix, and a last column of the parity bit part is a twenty-fourth column in the matrix prototype of the parity-check matrix. In the second matrix in FIG. 1a, the first column of the parity bit part is a seventeenth column in the matrix prototype of the parity-check matrix, and the last column of the parity bit part is the twenty-fourth column in the matrix prototype of the parity-check matrix. In the third matrix in FIG. 1a, the first column of the parity bit part is a nineteenth column in the matrix prototype of the parity-check matrix, and the last column of the parity bit part is the twenty-fourth column in the matrix prototype of the parity-check matrix. In the second matrix in FIG. 1a, the first column of the parity bit part is a twenty-first column in the matrix prototype of the parity-check matrix, and the last column of the parity bit part is the twenty-fourth column in the matrix prototype of the parity-check matrix.

FIG. 1a shows a matrix prototype of the LDPC code parity-check matrix with a code length N=1944 and different coding rates. "-" in FIG. 1a represents a Z*Z all-zero matrix, "0" in FIG. 1a represents a Z*Z unit matrix, and a non-zero element in FIG. 1a represents a circulant permutation matrix (circulant permutation matrix, CPM) of the Z*Z unit matrix. For example, the CPM is represented by Pᵢ, and i represents a cyclic shift value, a quantity of bits of a right cyclic shift of the unit matrix, a CPM coefficient, an element greater than or equal to 0 in the matrix prototype of the parity-check matrix, or the like. A specific name of i is not limited in this embodiment of this application. i is a non-negative integer, for example, 0 ≤ i ≤ Z - 1. When i=0, the CPM may be understood as a Z*Z unit matrix, or a CPM whose cyclic shift value is 0. For example, in FIG. 1a, Z=N/24. The foregoing "24" may be the same as a quantity of columns of the matrix prototype of the parity-check matrix in an IEEE 802.11ac/ax standard. For the IEEE 801.11ac/ax, regardless of a code length N=648, N=1296, or N=1944, the quantity of columns of the matrix prototype of the parity-check matrix is 24.

For example, an element "1" (that is, i=1) in FIG. 1a is used as an example. The element 1 may be extended to a CPM of 81 *81 (1944/24=81). The CPM may be obtained after the right cyclic shift is performed on the unit matrix by 1 bit, as follows: $\left[\begin{matrix}0 & 1 & 0 & ⋯ & 0 \\ 0 & 0 & 1 & ⋯ & 0 \\ ⋮ & ⋮ & ⋮ & ⋱ & ⋮ \\ 0 & 0 & 0 & ⋯ & 1 \\ 1 & 0 & 0 & ⋯ & 0\end{matrix}\right]$ (1)

For example, a 4*4 CPM is used as an example. FIG. 1b shows a CPM when i=0, a CPM when i=1, a CPM when i=2, and a CPM when i=3. The CPM shown in FIG. 1b is merely an example. For CPMs of another Z*Z unit matrix in this embodiment of this application, final Pᵢ may be obtained according to a principle shown in FIG. 1a or FIG. 1b. Details are not described below again.

Because the LDPC code can improve transmission reliability of a wireless transmission system, the LDPC code has been widely applied in a WLAN standard. To further improve data transmission reliability of a Wi-Fi system, an LDPC code with a longer code length may be considered in a current standard, a next-generation standard, or the like, so that an encoding module obtains stronger error control performance, and decoding performance of a decoding module is improved.

In view of this, embodiments of this application provide an encoding method, a decoding method, and an apparatus. The method relates to a new LDPC code, and the LDPC code can support a longer code length. The parity-check matrix provided in this embodiment of this application may be applicable to a longer code length. For example, the parity-check matrix may be applicable to a code length that is n times of 1944, where n is an integer greater than or equal to 2. In addition, the parity-check matrix may further improve decoding performance. For example, based on an existing WLAN LDPC long code (for example, a code length is 1944 bits), the LDPC code (or referred to as an LDPC long code) (for example, a code length is 3888 bits) provided in this embodiment of this application can achieve excellent performance. Further, the new LDPC long code provided in this embodiment of this application can reuse an original WLAN LDPC code encoding/decoding architecture as much as possible. For example, modifications to an existing LDPC encoding module and LDPC decoding module are small, so that implementation complexity of LDPC encoding/decoding can be reduced.

In embodiments of this application, matrices shown below may be referred to as prototypes of parity-check matrices, matrix prototypes of the parity-check matrices (matrix prototypes of the parity-check matrices), matrix prototypes for code word block length N (matrix prototypes for code word block length N), base matrices, or the like. A specific name of the matrices in the embodiments of this application is not limited in the embodiments of this application. Generally, a matrix that includes an element 0 and an element 1 and that is extended based on Z and a cyclic shift value i is referred to as the parity-check matrix. Therefore, matrices shown below may also be referred to as matrices before CPM extension, or the like. The matrices shown in Example 1 to Example 14 below may be referred to as matrix prototypes of the parity-check matrices, and matrices obtained after elements in the matrices shown in Example 1 to Example 14 are extended may be referred to as the parity-check matrices. For a specific extension method, refer to the foregoing related descriptions about FIG. 1a and FIG. 1b. Specific content of the extended parity-check matrix is not enumerated in this embodiment of this application.

The code length in this embodiment of this application may also be referred to as a code word block length (code word block length) or the like. A specific name of the code length is not limited in this embodiment of this application. Z in this embodiment of this application may be referred to as a subblock size (subblock size), an expansion factor, a lifting factor (lifting factor), or the like. A specific name of Z is not limited in this embodiment of this application. For ease of description, the following uses an example in which Z is referred to as the expansion factor for description.

In this embodiment of this application, Z=N/48. However, with progress of a standard, a subsequent method for calculating Z may also change. This is not limited in this embodiment of this application. For ease of understanding, in this embodiment of this application, different letter parameters are used to represent different meanings. For example, N represents a code length, Z represents the expansion factor, R represents a coding rate, K represents a quantity of information bits, and E represents a quantity of parity bits. However, the letter parameters shown in the embodiments of this application are merely examples, and should not be construed as a limitation on the embodiments of this application.

The following describes a communication system in embodiments of this application.

Technical solutions provided in embodiments of this application may be applied to a wireless local area network (wireless local area network, WLAN) system, for example, Wi-Fi. The method provided in embodiments of this application may be applicable to IEEE 802.11 series protocols of the Institute of Electrical and Electronics Engineers, for example, an 802.11be protocol, an 802.11bn protocol, a next-generation protocol of the 802.11bn protocol, or a protocol supporting ambient power (ambient power, AMP). Examples are not enumerated herein. The technical solutions provided in embodiments of this application may be further applied to a wireless personal area network (wireless personal area network, WPAN) based on millimeter wave (millimeter wave, MMW) and ultra wideband (ultra wideband, UWB) technologies. For example, the method provided in embodiments of this application may be applied to IEEE 802.15 series protocols such as an 802.15.4a protocol, an 802.15.4z protocol, an 802.15.4ab protocol, or a future-generation UWB WPAN protocol. Examples are not enumerated herein. The technical solutions provided in embodiments of this application may be further applied to the following communication systems, for example, an internet of things (internet of things, IoT) system, vehicle-to-everything (vehicle-to-everything, V2X, where X may represent anything), device-to-device (device-to-device, D2D), a narrow band internet of things (narrow band internet of things, NB-IoT) system, a long term evolution (long term evolution, LTE) system, a 5th-generation (5th-generation, 5G) communication system, a new communication system emerging in future communication development, or the like. For example, the V2X may include vehicle-to-vehicle (vehicle-to-vehicle, V2V), vehicle-to-infrastructure (vehicle-to-infrastructure, V2I), vehicle-to-pedestrian (vehicle-to-pedestrian, V2P) communication, or vehicle-to-network (vehicle-to-network, V2N) communication.

The WLAN system may provide high-rate and low-latency transmission. With continuous evolution of WLAN application scenarios, the WLAN system is to be applied to more scenarios or industries, for example, an internet of things industry, an internet of vehicles industry, a banking industry, enterprise offices, stadiums and exhibition halls, concert halls, hotel rooms, dormitories, wards, classrooms, supermarkets, squares, streets, production workshops, and warehousing. Certainly, a device (for example, an access point or a station) that supports WLAN communication or sensing may be a sensor node (for example, a smart water meter, a smart electricity meter, or a smart air detection node) in a smart city, a smart device (for example, a smart camera, a projector, a display, a television, a speaker, a refrigerator, and a washing machine) in a smart home, an internet of things node, an entertainment terminal (for example, a wearable device like an augmented reality (augmented reality, AR) device or a virtual reality (virtual reality, VR) device), a smart device (for example, a printer, a projector, a loudspeaker, or a speaker) in smart office, an internet of vehicles device in the internet of vehicles, an infrastructure in a daily life scenario (for example, a vending machine, a self-service navigation console of a supermarket, a self-service cashier device, and a self-service ordering machine), a device in a large sports and music venue, or the like.

Although embodiments of this application mainly use a WLAN as an example, especially a network applied to IEEE 802.11 series standards, embodiments of this application may support Wi-Fi 8, which may also be referred to as ultra-high reliability (ultra-high reliability, UHR), ultra-high reliability and throughput (ultra-high reliability and throughput, UHRT), or the like. Examples are not enumerated herein. Various aspects in embodiments of this application may be extended to other networks that use various standards or protocols, for example, Bluetooth (Bluetooth), a high performance radio LAN (high performance radio LAN, HIPERLAN) (a wireless standard similar to the IEEE 802.11 standard), a wide area network (wide area network, WAN), or other networks known or developed in the future.

In a possible implementation, the method provided in embodiments of this application may be implemented by a communication apparatus in a communication system. For example, the communication apparatus may be an access point (access point, AP) or a station (station, STA).

The AP is an apparatus having a wireless communication function, supporting communication, sensing, or power transfer by using a WLAN protocol. The AP has a function of communicating with or sensing another device (for example, a non-access point station (non-access point station, non-AP STA) or another access point) in a WLAN network, or a function of power transfer, and certainly may further have a function of communicating with, sensing or transferring power to another device. Alternatively, the access point is equivalent to a bridge that connects a wired network and a wireless network. A main function of the access point is to connect various wireless network clients together and then connect the wireless network to Ethernet. In the WLAN system, the access point may be referred to as an access point station (AP STA). The apparatus having the wireless communication function may be an entire device, or may be a chip, a processing system, a functional module installed in the entire device. The device in which the chip, the processing system, or the functional module is installed may implement the methods and functions in embodiments of this application under control of the chip, the processing system, or the functional module. The AP in embodiments of this application is an apparatus that provides a service for the non-AP STA, and may support the 802.11 series protocols, subsequent protocols, or the like. For example, the access point may be an access point for a terminal (for example, a mobile phone) to access a wired (or wireless) network, and is mainly deployed in a home, a building, and a park. A typical coverage radius is tens to hundreds of meters. Certainly, the access point may alternatively be deployed outdoors. For another example, the AP may be a communication entity, for example, a communication server, a router, a switch, or a bridge, or the AP may include various forms of macro base stations, micro base stations, relay stations, or the like. Certainly, the AP may alternatively be a chip, a processing system, or a module in the foregoing devices in various forms, to implement the methods and functions in embodiments of this application.

The STA is an apparatus having a wireless communication function, supporting communication, sensing, or power transfer by using the WLAN protocol. The STA has a capability of communicating with, sensing or transferring power to another non-AP STA or access point in the WLAN network. In the WLAN system, the station may be referred to as the non-access point station (non-access point station, non-AP STA). For example, the STA is any user communication device that allows a user to communicate with, sense, or transfer power to the AP and then communicate with the WLAN. The apparatus having the wireless communication function may be an entire device, or may be a chip, a processing system, a functional module installed in the entire device. The device in which the chip, the processing system, or the functional module is installed may implement the methods and functions in embodiments of this application under control of the chip, the processing system, or the functional module. For example, the STA may be a wireless communication chip, a wireless sensor, or a wireless communication terminal, and may also be referred to as a user. For another example, the STA may be a mobile phone that supports a Wi-Fi communication function, a tablet computer that supports the Wi-Fi communication function, a set-top box that supports the Wi-Fi communication function, a smart television that supports the Wi-Fi communication function, a smart wearable device that supports the Wi-Fi communication function, a vehicle-mounted communication device that supports the Wi-Fi communication function, or a computer that supports the Wi-Fi communication function. Certainly, the STA may alternatively be a chip, a processing system, or a module in the foregoing devices in various forms, to implement the methods and functions in embodiments of this application.

For example, the communication system to which the method provided in this embodiment of this application may be applied may include the access point and the station. For example, embodiments of this application may be applied to a scenario of communication or sensing between the AP and the STA, between APs, or between STAs in the WLAN. This is not limited in embodiments of this application. Optionally, the AP may communicate with or sense a single STA, or the AP may simultaneously communicate with or sense a plurality of STAs. Specifically, communication or sensing between the AP and the plurality of STAs may be classified into downlink transmission in which the AP simultaneously sends signals to the plurality of STAs and uplink transmission in which the plurality of STAs send signals to the AP. A WLAN communication protocol may be supported between the AP and the STA, between the APs, and between the STAs. The communication protocol may include the IEEE 802.11 series protocols, for example, the 802.11bn protocol. Certainly, protocols subsequent to 802.11bn may also be supported.

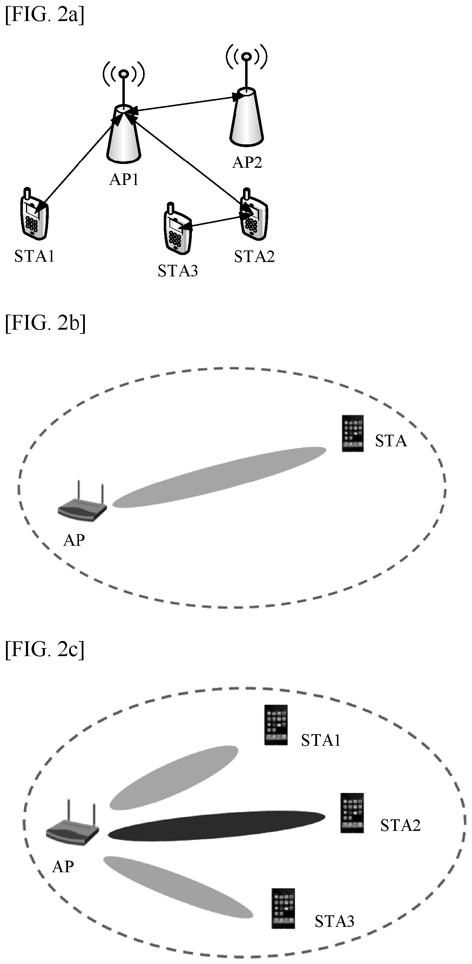

FIG. 2a is a diagram of an architecture of a communication system according to an embodiment of this application. The communication system may include one or more APs and one or more STAs. FIG. 2a shows two access points such as AP1 and AP2, and three stations such as STA1, STA2, and STA3. In an example, the method provided in this embodiment of this application may be applicable to data communication or sensing between one AP and one or more STAs, such as communication between AP1 and STA1 shown in FIG. 2a, communication between an AP and an STA shown in FIG. 2b, communication, sensing, or power transfer between AP1 and each of STA1 and STA2 shown in FIG. 2a, and communication, sensing, or power transfer between an AP and each of STA1, STA2, and STA3 shown in FIG. 2c. In another example, the method provided in this embodiment of this application may be applicable to communication between APs, such as communication or sensing between AP1 and AP2 shown in FIG. 2a. In still another example, the method provided in this embodiment of this application may be applicable to communication or sensing between STAs, such as communication or sensing between STA2 and STA3 shown in FIG. 2a.

In FIG. 2a to FIG. 2c, an example in which the STA is a mobile phone and the AP is a router is used. This does not indicate that types of the AP and the STA in embodiments of this application are limited. In addition, a quantity of APs and a quantity of STAs shown in FIG. 2a to FIG. 2c are merely examples. In a specific implementation, the quantity of APs or the quantity of STAs may be greater or less. This is not limited in this embodiment of this application.

From different perspectives of sending a signal and receiving a signal, in the following content, a first communication apparatus may be understood as a communication apparatus that sends a signal, and a second communication apparatus may be understood as a communication apparatus that receives a signal. Alternatively, the first communication apparatus may also be referred to as a transmit end, and the second communication apparatus may also be referred to as a receive end. In this embodiment of this application, the signal may be an encoded sequence, or a signal obtained after the encoded sequence is processed.

From a perspective of different devices, in an example, the first communication apparatus and the second communication apparatus may be Wi-Fi chips, functional modules, processing systems, or the like disposed in different Wi-Fi devices. In another example, the first communication apparatus may be an AP, and the second communication apparatus may be a non-AP STA. In still another example, both the first communication apparatus and the second communication apparatus may be non-AP STAs or APs. In still another example, the first communication apparatus may be a non-AP STA, and the second communication apparatus may be an AP. In another example, at least one of the first communication apparatus and the second communication apparatus may be a multi-link device (multi-link device, MLD), or the like. Examples are not enumerated in embodiments of this application. For example, the multi-link device (multi-link device, MLD) means that the device simultaneously has a plurality of stations (for example, APs or non-AP STAs), which operate on different frequency bands or channels. The multi-link device includes a plurality of affiliated stations. The affiliated stations may be physical stations, or may be logical stations. Each station may operate on one link, one frequency band, one channel, or the like. The affiliated station may be an AP or a non-AP STA. The multi-link device (for example, a non-AP MLD or an AP MLD) may be a communication apparatus having a wireless communication function. The communication apparatus may be an entire device, or may be a chip, a processing system, a module installed in the entire device. The device in which the chip, the processing system, or the module is installed may implement the methods and functions in embodiments of this application under control of the chip, the processing system, or the module. The multi-link device may implement wireless communication in compliance with 802.11 series protocols, to communicate with another device. The another device may be a multi-link device, or may not be a multi-link device. Frequency bands on which the multi-link device operates may include but are not limited to sub 1 GHz, 2.4 GHz, 5 GHz, 6 GHz, or the like. Examples are not enumerated herein.

In embodiments of this application, the method provided in embodiments of this application is described from two sides: the first communication apparatus and the second communication apparatus. However, in a process in which the first communication apparatus and the second communication apparatus transmit a signal, the signal may be further forwarded via another apparatus, for example, a signal between the first communication apparatus and the second communication apparatus is forwarded via a forwarding apparatus. An apparatus other than the first communication apparatus and the second communication apparatus is not limited in embodiments of this application.

The following describes methods in embodiments of this application.

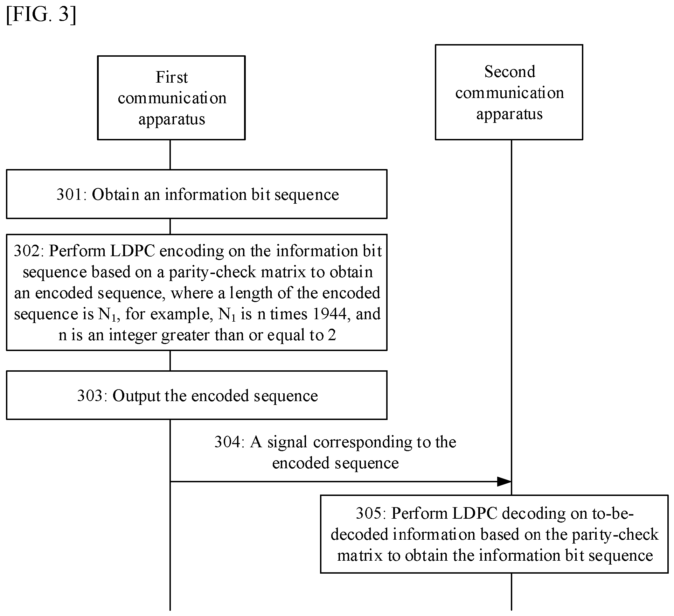

FIG. 3 is a schematic flowchart of an encoding method and a decoding method according to an embodiment of this application. For descriptions of the first communication apparatus and the second communication apparatus, refer to the foregoing descriptions. Details are not described herein again. As shown in FIG. 3, the method includes the following steps.

301: The first communication apparatus obtains an information bit sequence.

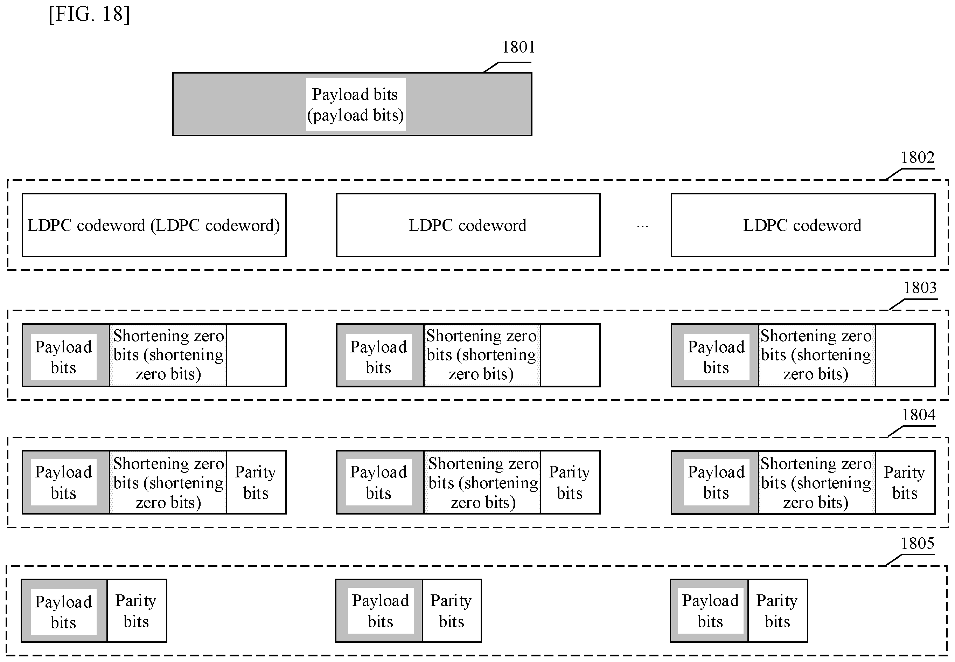

The information bit sequence may be a bit sequence that includes an information amount. For example, a length of the information bit sequence is N₂, or a quantity of bits in the information bit sequence is N₂. N₂ is a positive integer. The N₂ bits may include K information bits, or referred to as K data bits, or referred to as K payload bits (payload bits). K is a positive integer. N₂ may be an integer greater than or equal to K. For example, when N₂ is greater than K, the information bit sequence may further include (N₂-K) 0s. For related descriptions of "0" shown herein, refer to the following descriptions of a shortening operation in FIG. 18. Details are not described herein again.

A value of N₂ may be related to a code length and a coding rate. In the following step 302, if a length of an encoded sequence is N₁, N₂=N₁*R, and R is a coding rate of the information bit sequence. N₁ shown herein may also be referred to as a code length corresponding to a parity-check matrix. N₁ may also be understood as an original code length of a single LDPC code word, and N₂ may be understood as an original information bit of the single LDPC code word.

In a possible implementation, the method shown in FIG. 3 may further include the following step.

The first communication apparatus obtains the code length N₁.

In an example, N₁ may be m times 1296, and m is an integer greater than or equal to 2. For example, N₁=1296*2=2592. For another example, N₁=1296*3=3888, which is not enumerated herein.

In another example, N₁ may be n times 1944, and n is an integer greater than or equal to 2. For example, N₁=1944*2=3888, or N₁=1944*3=5832, which is not enumerated herein.

In a possible implementation, the method shown in FIG. 3 may further include the following step.

The first communication apparatus obtains a coding rate R.

In a WLAN system, different code lengths and coding rates may correspond to different parity-check matrices. Therefore, before performing LDPC encoding, the first communication apparatus may further obtain the coding rate R. After obtaining the coding rate R, the first communication apparatus may select the parity-check matrix based on the coding rate R and the code length N₁. The coding rate R may be determined based on an MCS selected by link adaptation. For example, the coding rate R may be determined based on current channel information. A specific method for determining the coding rate R is not limited in this embodiment of this application. In an example, the MCS may be delivered by an AP. In another example, the MCS may be determined by the first communication apparatus, or the like. For example, the first communication apparatus sends the MCS to the second communication apparatus, and the second communication apparatus receives the MCS and obtains the coding rate R based on the MCS. For another example, the second communication apparatus sends the MCS to the first communication apparatus, and the first communication apparatus receives the MCS and obtains the coding rate R based on the MCS. A specific interaction procedure of the MCS is not limited in this embodiment of this application.

For example, R may be any one of the following: 1/2, 2/3, 3/4, and 5/6. Certainly, with progress of a standard, a value of R may be another value subsequently. This is not limited in this embodiment of this application.

A sequence in which the first communication apparatus obtains the code length and the coding rate is not limited in this embodiment of this application. After obtaining the code length and the coding rate, the first communication apparatus may determine a matrix prototype of a corresponding parity-check matrix based on the code length and the coding rate. Similarly, a sequence in which the first communication apparatus obtains the information bit sequence and the code length (or the coding rate) is not limited either.

302: The first communication apparatus performs LDPC encoding on the information bit sequence based on the parity-check matrix, to obtain an encoded sequence. A length of the encoded sequence is N₁. For example, N₁ is n times 1944, and n is an integer greater than or equal to 2.

The encoded sequence may include K information bits and E parity bits. Alternatively, the encoded sequence may include the information bit sequence and a parity bit sequence. A length of the information bit sequence may be N₂, and a length of the parity bit sequence may be E. N₁=N₂+E. A value of E is related to N₁ and R. For example, if N₁=3888 and R=1/2, then E=1944. For another example, if N₁=3888 and R=2/3, then E=3888*1/3=1296. For another example, if N₁=3888 and R=3/4, then E=3888*1/4=972. For another example, if N₁=3888 and R=5/6, then E=3888*1/6=648.

The following describes a matrix prototype of a parity-check matrix in embodiments of this application.

In the matrix prototype of the parity-check matrix shown below, "-1" represents a Z*Z all-zero matrix, "0" represents a Z*Z unit matrix, and a non-zero element represents a CPM of the Z*Z unit matrix. Certainly, "-1" in the matrix prototype may also be replaced with "- ". This is not limited in this application. For description of each parameter and description of the CPM, refer to the foregoing description. Details are not described herein again. The following "1" in Example 1, "2" in Example 2, or "3" in Example 3 is used to distinguish between different examples and facilitate subsequent reference.

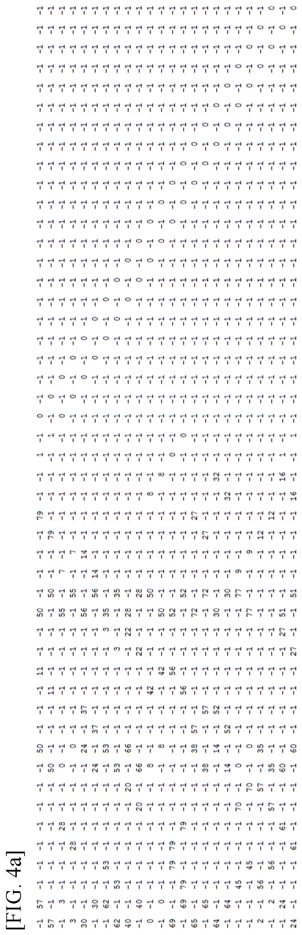

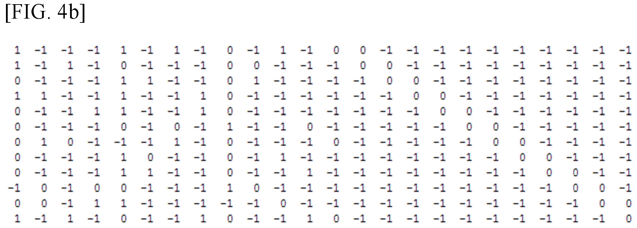

In Example 1, the matrix prototype of the parity-check matrix may be shown in FIG. 4a. For descriptions of FIG. 4b, refer to the following. Details are not described herein again.

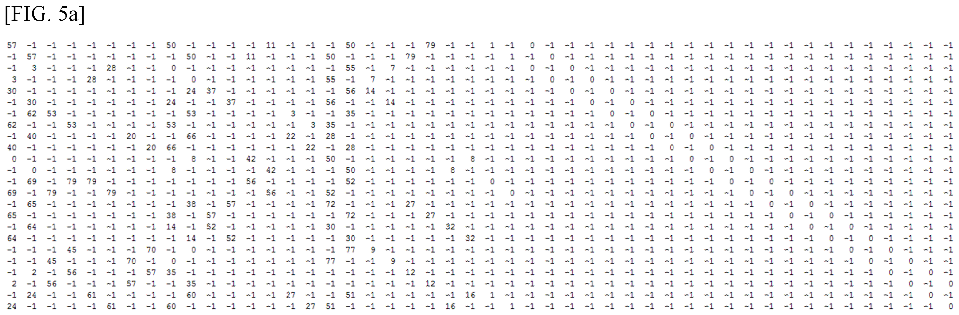

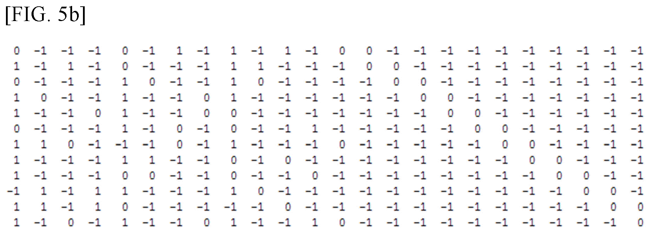

In another example 2, the matrix prototype of the parity-check matrix may be shown in FIG. 5a. For descriptions of FIG. 5b, refer to the following. Details are not described herein again.

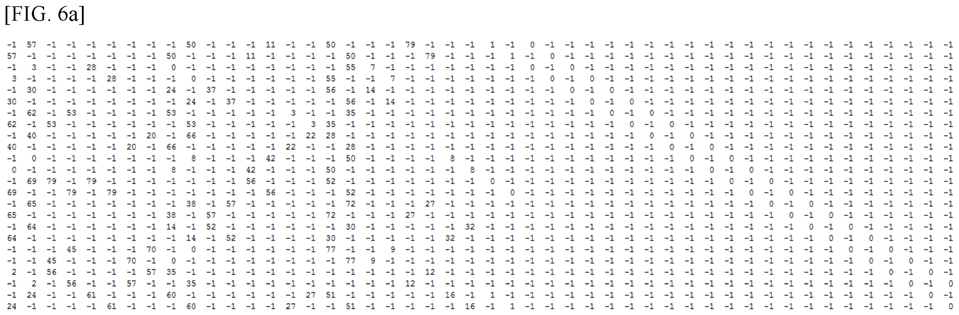

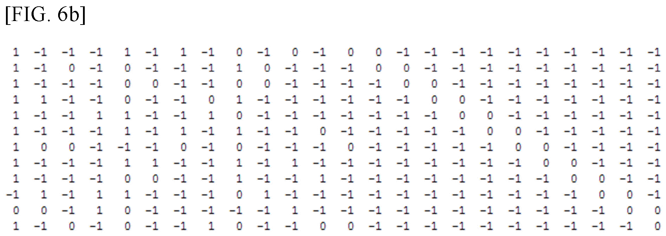

In still another example 3, the matrix prototype of the parity-check matrix may be shown in FIG. 6a. For descriptions of FIG. 6b, refer to the following. Details are not described herein again.

R corresponding to the matrix prototype of the parity-check matrix shown in Example 1 to Example 3 may be equal to 1/2. In addition, R corresponding to the parity-check matrix is also equal to 1/2. For example, N₁ corresponding to the matrix prototype of the parity-check matrix shown in Example 1 to Example 3 may be equal to 3888. In addition, N₁ corresponding to the parity-check matrix is also equal to 3888. In addition, the first communication apparatus performs LDPC encoding by using the parity-check matrix corresponding to the matrix prototypes shown in Example 1 to Example 3, and a length of an obtained encoded sequence is 3888 bits.

Each non-negative integer (for example, an element i) in the matrix prototypes of the parity-check matrix shown in Example 1 to Example 3 may be extended to the CPM of the Z*Z unit matrix. The element i in Example 1 to Example 3 may be extended to the CPM. For example, the CPM is obtained after the unit matrix is extended by performing a right cyclic shift by i bits. For example, an element 0 in Example 1 to Example 3 may be extended to an 81*81 unit matrix, and the element i greater than 0 (for example, i is greater than 0) may obtain an 81*81 CPM by performing the right cyclic shift by i bits of the unit matrix. For example, an element "57" in the matrix prototype may be extended to a CPM of the 81*81 unit matrix. For example, the CPM may be obtained by performing the right cyclic shift by 57 bits on the 81*81 unit matrix.

In this embodiment of this application, the matrix prototypes shown in Example 1 to Example 3 include 24 rows and 48 columns. Therefore, the parity-check matrix extended based on an expansion factor Z may include 24*81 rows and 48*81 columns (that is, 1944 rows and 3888 columns). For how to extend the matrix prototype to the parity-check matrix, refer to the description in FIG. 1a or FIG. 1b, or refer to a related standard or protocol. Details are not described herein again. Related descriptions of the expansion factor Z herein are also applicable to the following Example 4 to Example 14. Details are not described below again.

For ease of description, in the following, first X columns in the matrix prototype of the parity-check matrix are referred to as a matrix corresponding to information bits, or an information bit part of an LDPC code word, or an information bit part of the matrix prototype, and last Y columns in the matrix prototype of the parity-check matrix are referred to as a matrix corresponding to parity bits, or a parity-check square matrix, or a parity bit part of the LDPC code word, or a parity bit part of the matrix prototype. Both X and Y are positive integers. For example, X=48*R. Y=48* (1-R). For example, for the matrix prototypes shown in Example 1 to Example 3, X=24, and Y=24.

In an example, when K=3888*1/2=1944, that is, when the information bit sequence includes 1944 information bits, the encoded sequence may include 1944 information bits and 1944 parity bits.

In another example, when K is less than 1944, that is, a quantity of information bits included in the information bit sequence is less than 1944, the encoded sequence may include K information bits and 1944 parity bits. Although the encoded sequence includes K information bits and 1944 parity bits, a length of the encoded sequence is N₁. As shown in FIG. 18 below, because a quantity of information bits is less than 1944, before performing LDPC encoding, the first communication apparatus may obtain the information bit sequence by filling in a specific quantity of 0s, and then discard these 0s after completing LDPC encoding. For example, the quantity of 0s may be equal to 1944-K. For related descriptions of the shortening operation, refer to FIG. 18. Details are not described herein again.

In still another example, when the quantity of to-be-sent information bits obtained before the first communication apparatus obtains the information bit sequence is greater than 1944, the first communication apparatus may perform a code word division processing on the information bits before performing LDPC encoding. For example, after the code word division processing, a plurality of code words (or referred to as blocks or segments) may be obtained, and a quantity of information bits carried in each code word may be less than or equal to 1944. For specific descriptions of the code word division processing, refer to a related standard, protocol, or the like. This is not limited in this embodiment of this application. Certainly, after performing the code word division processing, the first communication apparatus may further combine the shortening operation or the like. A combination of the shortening operation and the code word division operation is not described herein again.

Related descriptions of different values of K herein are also applicable to the following Example 4 to Example 14. Details are not described below again.

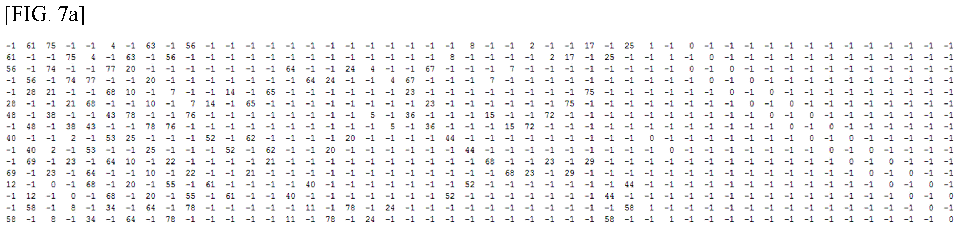

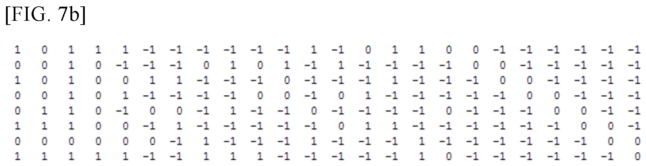

In Example 4, the matrix prototype of the parity-check matrix may be shown in FIG. 7a. For descriptions of FIG. 7b, refer to the following. Details are not described herein again.

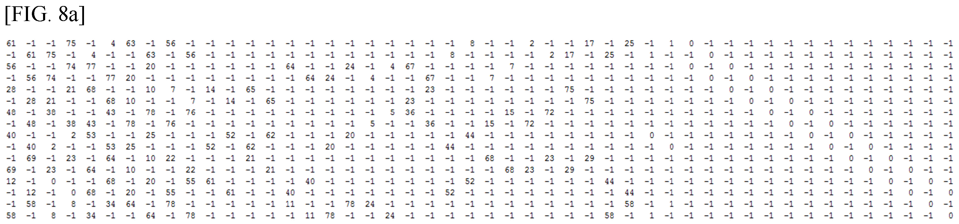

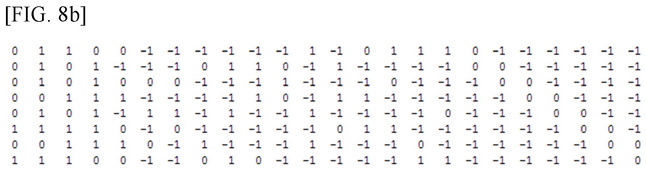

In another example 5, the matrix prototype of the parity-check matrix may be shown in FIG. 8a. For descriptions of FIG. 8b, refer to the following. Details are not described herein again.

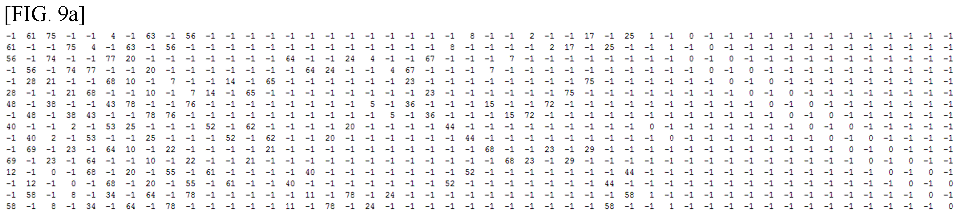

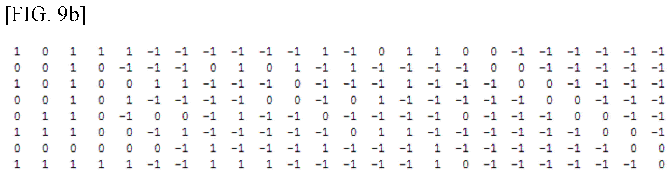

In still another example 6, the matrix prototype of the parity-check matrix may be shown in FIG. 9a. For descriptions of FIG. 9b, refer to the following. Details are not described herein again.

R corresponding to the matrix prototype of the parity-check matrix shown in Example 4 to Example 6 may be equal to 2/3. In addition, R corresponding to the parity-check matrix is also equal to 2/3. For example, N₁ corresponding to the matrix prototype of the parity-check matrix shown in Example 4 to Example 6 may be equal to 3888. In addition, N₁ corresponding to the parity-check matrix is also equal to 3888. In addition, the first communication apparatus performs LDPC encoding by using the parity-check matrix corresponding to the matrix prototype shown in Example 4 to Example 6, and the length of the obtained encoded sequence is 3888 bits.

For example 4 to example 6, X=48*2/3=32, and Y=48*1/3=16. For related descriptions of X and Y, refer to Example 1 to Example 3. Details are not described herein again.

For descriptions of the expansion factor, the CPM, and K, refer to the foregoing Example 1 to Example 3. Details are not described herein again.

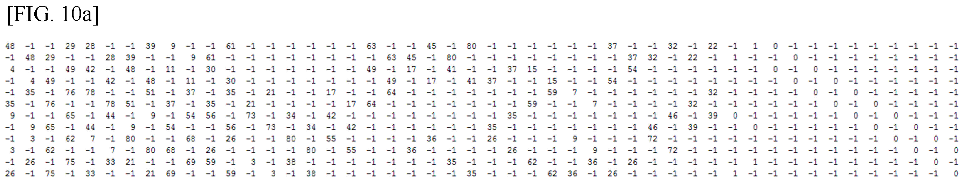

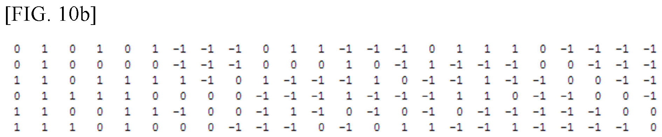

In Example 7, the matrix prototype of the parity-check matrix may be shown in FIG. 10a. For descriptions of FIG. 10b, refer to the following. Details are not described herein again.

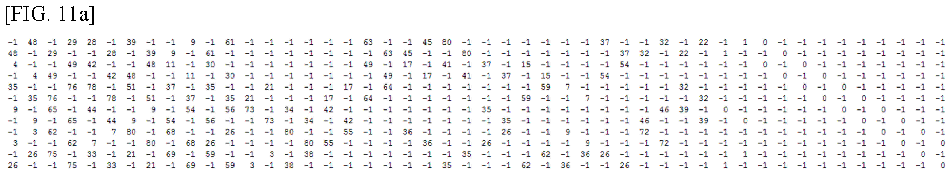

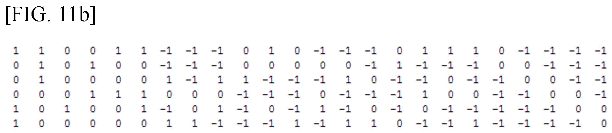

In another example 8, the matrix prototype of the parity-check matrix may be shown in FIG. 11a. For descriptions of FIG. 11b, refer to the following. Details are not described herein again.

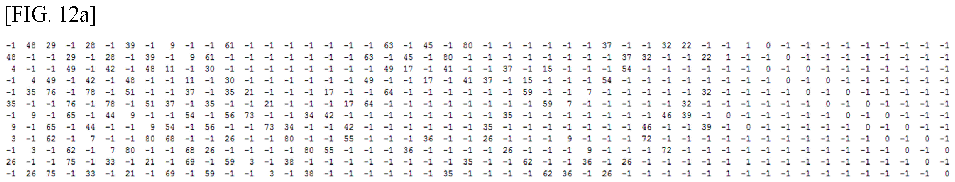

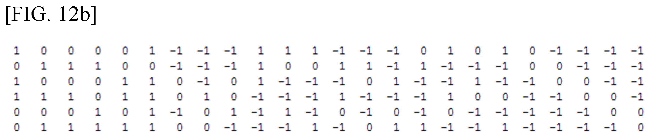

In still another example 9, the matrix prototype of the parity-check matrix may be shown in FIG. 12a. For descriptions of FIG. 12b, refer to the following. Details are not described herein again.

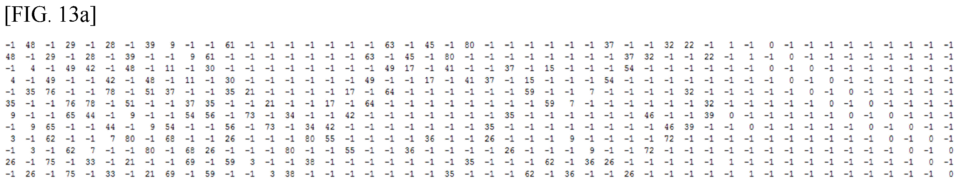

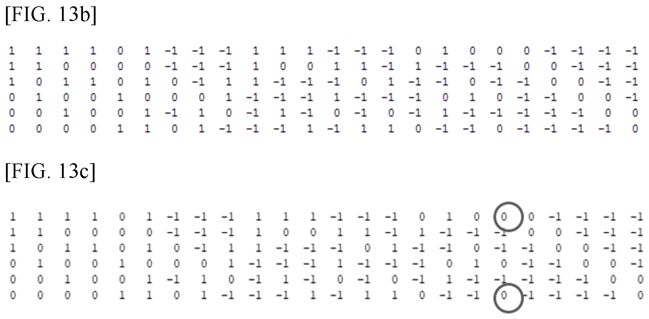

In still another example 10, the matrix prototype of the parity-check matrix may be shown in FIG. 13a. For descriptions of FIG. 13b, refer to the following. Details are not described herein again.

R corresponding to the matrix prototype of the parity-check matrix shown in Example 7 to Example 10 may be equal to 3/4. In addition, R corresponding to the parity-check matrix is also equal to 3/4. For example, N₁ corresponding to the matrix prototype of the parity-check matrix shown in Example 7 to Example 10 may be equal to 3888. In addition, N₁ corresponding to the parity-check matrix is also equal to 3888. In addition, the first communication apparatus performs LDPC encoding by using the parity-check matrix corresponding to the matrix prototype shown in Example 7 to Example 10, and the length of the obtained encoded sequence is 3888 bits.

For example 7 to example 10, X=48*3/4=36, and Y=48*1/4=12. For related descriptions of X and Y, refer to Example 1 to Example 3. Details are not described herein again.

For descriptions of the expansion factor, the CPM, and K, refer to the foregoing Example 1 to Example 3. Details are not described herein again.

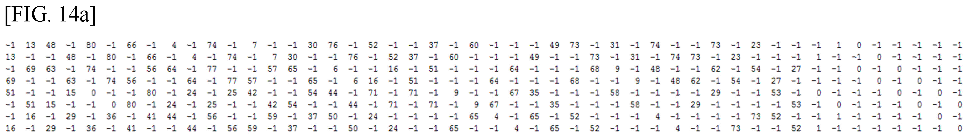

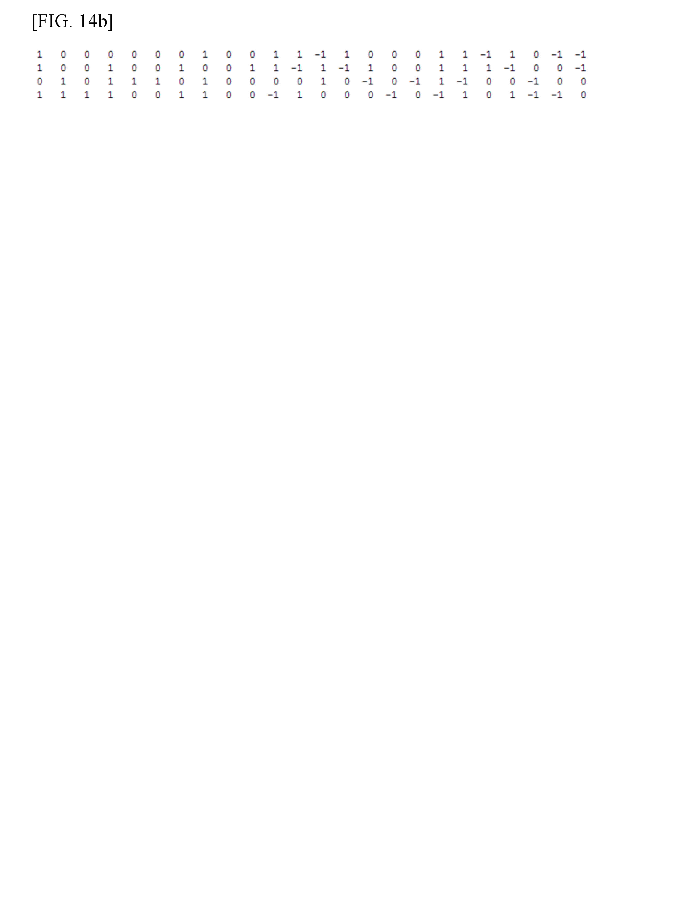

In Example 11, the matrix prototype of the parity-check matrix may be shown in FIG. 14a. For descriptions of FIG. 14b, refer to the following. Details are not described herein again.

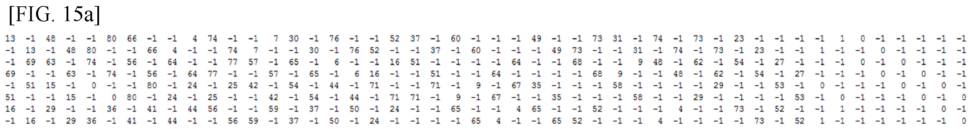

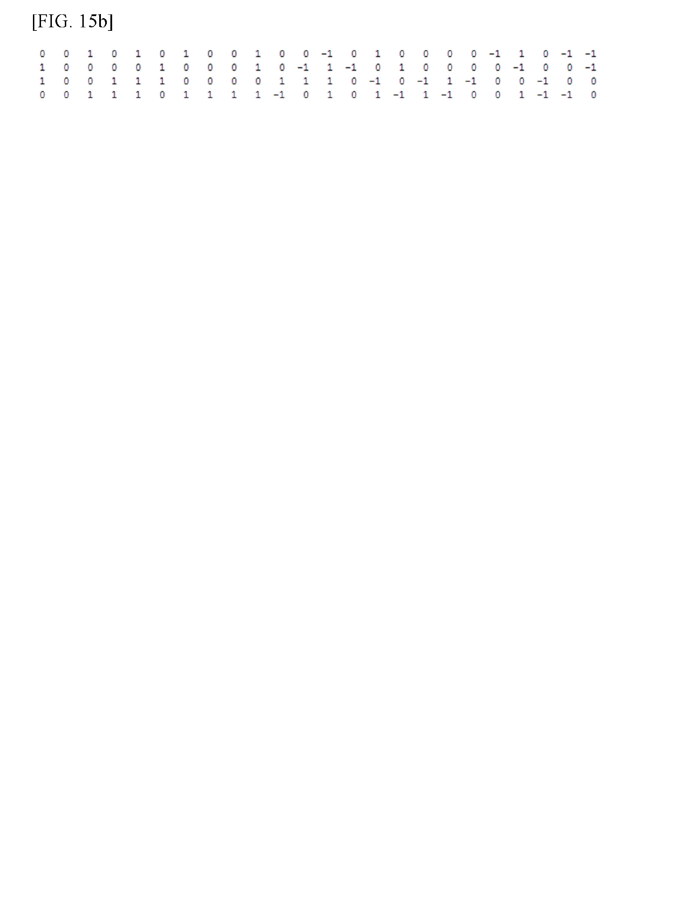

In another example 12, the matrix prototype of the parity-check matrix may be shown in FIG. 15a. For descriptions of FIG. 15b, refer to the following. Details are not described herein again.

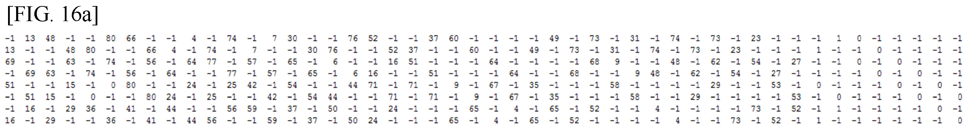

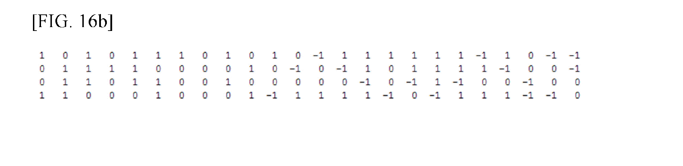

In still another example 13, the matrix prototype of the parity-check matrix may be shown in FIG. 16a. For descriptions of FIG. 16b, refer to the following. Details are not described herein again.

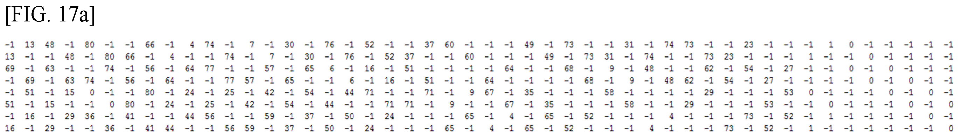

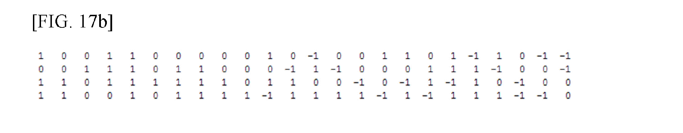

In still another example 14, the matrix prototype of the parity-check matrix may be shown in FIG. 17a. For descriptions of FIG. 17b, refer to the following. Details are not described herein again.

R corresponding to the matrix prototype of the parity-check matrix shown in Example 11 to Example 14 may be equal to 5/6. In addition, R corresponding to the parity-check matrix is also equal to 5/6. For example, N₁ corresponding to the matrix prototype of the parity-check matrix shown in Example 11 to Example 14 may be equal to 3888. In addition, N₁ corresponding to the parity-check matrix is also equal to 3888. In addition, the first communication apparatus performs LDPC encoding by using the parity-check matrix corresponding to the matrix prototype shown in Example 7 to Example 10, and the length of the obtained encoded sequence is 3888 bits.

For example 11 to example 14, X=48*5/6=40, and Y=48*1/6=8. For related descriptions of X and Y, refer to Example 1 to Example 3. Details are not described herein again.

For descriptions of the expansion factor, the CPM, and K, refer to the foregoing Example 1 to Example 3. Details are not described herein again.

The matrix prototypes of the parity-check matrix shown in Example 1 to Example 14 are merely examples. The matrix prototypes of the parity-check matrix shown in this embodiment of this application may alternatively be obtained by using the following determination method. Examples are not enumerated herein.

303: The first communication apparatus outputs the encoded sequence.

For example, the first communication apparatus may perform LDPC encoding by using an encoding module (for example, an LDPC encoding module), to obtain the encoded sequence, and output the encoded sequence from the encoding module. For related descriptions of the length of the encoded sequence, refer to step 301 or step 302. Details are not described herein again.

In a possible implementation, after outputting the encoded sequence, the first communication apparatus may further perform the shortening operation. The following uses examples for description.

Generally, after being encoded, an information bit sequence needs to be placed into an integer quantity of orthogonal frequency division multiplexing (orthogonal frequency division multiplexing, OFDM) symbols, and the encoded sequence also needs to be placed into an integer quantity of LDPC code words. Therefore, before the first communication apparatus performs LDPC encoding, the first communication apparatus further needs to first determine a minimum quantity N_{SYM} of OFDM symbols required for current transmission, and then calculate, based on the N_{SYM} and a current modulation and coding scheme (for example, a modulation order indicated by the MCS), a total quantity N_{TCB} of coded bits that can be stored in all OFDM symbols, where N_{TCB}=N_{CBPS}*N_{SYM}, and N_{CBPS} is a quantity of coded bits that can be stored in each OFDM symbol. Then, the first communication apparatus may calculate, based on the foregoing obtained result, an LDPC code length (that is, the code length shown in this embodiment of this application) used for current transmission and a quantity N_{CW} of required code words. For example, when there are not enough information bits (for example, when K is less than 1944 shown in Example 1 to Example 3) that can fill the information bit part of the LDPC code word, the first communication apparatus may perform the shortening operation before performing LDPC encoding (which may also be referred to as generating a parity bit). The shortening operation means that before the parity bit is generated through LDPC encoding, a specific quantity of 0s are filled in the information bit, and these 0s are discarded after the parity bit is generated through encoding. FIG. 18 is a diagram of a part of a shortening operation in LDPC encoding according to an embodiment of this application. As shown in FIG. 18, step 1801 indicates that the first communication apparatus may obtain to-be-encoded payload bits (payload bits) (for example, K information bits shown in this embodiment of this application). Step 1802 indicates that the first communication apparatus may calculate an LDPC code length and a quantity of code words. FIG. 18 shows an example of three LDPC code words. A length (that is, a code length) of each LDPC code word (LDPC code word) may be equal to the code length. Step 1803 indicates that the first communication apparatus may perform the shortening operation on an information bit. FIG. 18 shows a code word including payload bits and shortening zero bits (shortening zero bits). Step 1804 indicates that the first communication apparatus may generate parity bits (parity bits) by using the payload bits and shortening bits. FIG. 18 shows a code word including the payload bits, the shortening zero bits, and the parity bits. Step 1805 indicates that the first communication apparatus discards the shortening zero bits (discard shortening bits). FIG. 18 shows a code word including data bits and the parity bits. The foregoing related descriptions of the shortening operation are merely examples. For related descriptions of the shortening operation, refer to a related standard, protocol, or the like. This is not limited in this embodiment of this application.

304: The first communication apparatus sends a signal corresponding to the encoded sequence, and the second communication apparatus receives the signal.

The foregoing signal corresponding to the encoded sequence is a signal that is obtained after the encoded sequence is output from the encoding module and that is obtained after other processing may be performed on the encoded sequence, so that the first communication apparatus transmits the processed signal through a channel.

For example, the first communication apparatus may perform rate matching on the encoded sequence, and the rate matching method may include puncturing, repetition, and shortening. For example, the first communication apparatus may puncture a parity bit in the encoded sequence, to obtain a higher coding rate or a shorter code length. For example, the first communication apparatus may further perform at least one of the following processing on the encoded sequence: stream parsing, constellation mapping, LDPC subcarrier mapping, stream cyclic shift, spatial and frequency mapping, inverse discrete Fourier transform (inverse discrete Fourier transform, IDFT), and cyclic prefix insertion and windowing (insert GI and window). For example, after receiving the signal transmitted through the channel, the second communication apparatus may perform corresponding processing on the signal. For example, before obtaining to-be-decoded information, the second communication apparatus may perform at least one of the following processing: cyclic prefix removal, discrete Fourier transform (discrete Fourier transform, DFT), spatial and frequency demapping, deinterleaving, and constellation demapping.

For other processing performed by the first communication apparatus on the encoded sequence and corresponding processing performed before the second communication apparatus obtains the to-be-decoded information, refer to a related standard, protocol, or the like. This is not limited in this embodiment of this application.

305: The second communication apparatus performs LDPC decoding on the to-be-decoded information based on the parity-check matrix, to obtain the information bit sequence.

A length of the to-be-decoded information may be N₁. For example, the to-be-decoded information may include a bit, a real number, or the like. Specific content included in the to-be-decoded information is not limited in this embodiment of this application. For example, before obtaining the to-be-decoded information, the second communication apparatus may further supplement a shortening bit, for example, supplement a shortening bit based on a code length and K, or may further supplement a puncturing bit. This is not limited in this embodiment of this application.

For example, a decoding method that may be used by the second communication apparatus includes but is not limited to a hard-decision decoding method, a soft-decision decoding method, or a hybrid decoding method. A specific decoding process is not described in detail in this embodiment of this application.

For example, the second communication apparatus may alternatively determine the code length N₁ by using a method similar to that in FIG. 18. For related descriptions of how the second communication apparatus obtains the code length N₁ and the coding rate R, refer to the foregoing descriptions of the first communication apparatus. Details are not described herein again. For a method for obtaining N₁ and R by the first communication apparatus and a method for obtaining N₁ and R by the second communication apparatus, refer to a related standard, protocol, or the like. This is not limited in this embodiment of this application.

In this embodiment of this application, step 302 to step 303 may be implemented by an encoding module, and step 305 may be implemented by a decoding module. In a specific implementation, the method shown in FIG. 3 may be further divided into an encoding method or a decoding method. For example, the encoding method may include step 302 to step 303, or include step 301 to step 303, and the first communication apparatus may include the encoding module. For example, the decoding method may include step 305, and the second communication apparatus may include the decoding module. Optionally, in addition to the foregoing encoding module, the first communication apparatus may further include an obtaining module. The obtaining module may be configured to obtain a code length, a coding rate, or the like. Optionally, the first communication apparatus may further include a shortening module, a block division module, or the like. Optionally, in addition to the decoding module, the second communication apparatus may further include an obtaining module. The obtaining module may be configured to obtain the to-be-decoded information.

In the embodiment of this application, the parity-check matrix may be applicable to an information bit sequence whose code length is n times of 1944, where n is an integer greater than or equal to 2. Therefore, transmission reliability of a system can be improved, and decoding performance can be improved.

The following describes a method for determining the parity-check matrix in the embodiments of this application.

The method for determining the parity-check matrix shown in this embodiment of this application is merely an example. In a specific implementation, the determination method shown below may be defined by a standard. Alternatively, in a specific implementation, two communication parties may not perform the determination method shown below. For example, the two communication parties may store the matrix prototype of the parity-check matrix, or store an extension indication matrix (or referred to as an accompanying extension indication matrix or the like). Matrix prototypes of the 14 parity-check matrices shown above may be obtained by using the determination method shown below. Although the foregoing shows the matrix prototypes of the 14 parity-check matrices as an example, matrix prototypes of other parity-check matrices determined according to the determination method shown in embodiments of this application also fall within the protection scope of the embodiments of this application.

The determination method shown below is shown by using an example in which a basic parity-check matrix is a code length N₀=1944. As shown in step 301 above, N₁ may also be m times 1296. That is, according to the determination method shown below, a parity-check matrix whose code length is greater than 1944 may also be determined based on a parity-check matrix corresponding to a code length 1296. According to the determination method shown below, the parity-check matrix whose code length is greater than 1944 determined by using the parity-check matrix corresponding to the code length 1296 as the basic parity-check matrix also falls within the protection scope of this embodiment of this application. The following uses an example in which a matrix prototype of the basic parity-check matrix is the matrix shown in FIG. 1a to describe a method for determining the matrix prototype of the parity-check matrix shown in this embodiment of this application. Certainly, a name of the basic parity-check matrix shown in this embodiment of this application is merely an example. For example, the basic parity-check matrix may also be referred to as a reference parity-check matrix, a baseline parity-check matrix, an original parity-check matrix, or the like.

To reuse an encoding/decoding architecture of an original WLAN LDPC code as much as possible, in this embodiment of this application, LDPC codes at different coding rates whose code lengths are 1944 bits in an existing WLAN system are separately used as basic matrices for extension, to obtain parity-check matrices of the LDPC codes whose code lengths are 3888 bits at corresponding coding rates. In the matrix prototypes (shown in FIG. 1a) of the four parity-check matrices whose original code lengths are 1944 bits, a CPM size of each element is 81. In the matrix prototype of the parity-check matrix of the LDPC code whose code length is 3888 bits shown in this embodiment of this application, a CPM size of each element is also 81. However, the size of the matrix prototype of the parity-check matrix shown in this embodiment of this application is twice the size of the matrix prototype of the basic parity-check matrix. Details are described below.

The basic parity-check matrix is described as follows:

A code length N₀ of the basic parity-check matrix is 1944, and a coding rate includes 1/2, 2/3, 3/4, and 5/6. An expansion factor of the basic parity-check matrix is Z=1944/24=81.

When R=1/2, the matrix prototype of the basic parity-check matrix is a matrix whose size is 12*24, that is, the matrix prototype of the basic parity-check matrix includes 12 rows and 24 columns. The basic parity-check matrix extended based on the matrix prototype may include 972 rows and 1944 columns. X=12, Y=12.

When R=2/3, the matrix prototype of the basic parity-check matrix is a matrix whose size is 8*24, that is, the matrix prototype of the basic parity-check matrix includes 8 rows and 24 columns. The basic parity-check matrix extended based on the matrix prototype may include 648 rows and 1944 columns. X=16, Y=8.

When R=3/4, the matrix prototype of the basic parity-check matrix is a matrix whose size is 6*24, that is, the matrix prototype of the basic parity-check matrix includes 6 rows and 24 columns. The basic parity-check matrix extended based on the matrix prototype may include 648 rows and 1944 columns. X=18, Y=6.

When R=5/6, the matrix prototype of the basic parity-check matrix is a matrix whose size is 4*24, that is, the matrix prototype of the basic parity-check matrix includes 4 rows and 24 columns. The basic parity-check matrix extended based on the matrix prototype may include 324 rows and 1944 columns. X=20, Y=4.

The parity-check matrix is described as follows:
A code length N₁ of the parity-check matrix is 3888, and a coding rate includes 1/2, 2/3, 3/4, and 5/6. An expansion factor of the parity-check matrix is Z=3888/48=81.

When R=1/2, the matrix prototype of the parity-check matrix is a matrix whose size is 24*48, that is, the matrix prototype of the parity-check matrix includes 24 rows and 48 columns. The parity-check matrix extended based on the matrix prototype includes 1944 rows and 3888 columns. X=24, Y=24.

When R=2/3, the matrix prototype of the parity-check matrix is a matrix whose size is 16*48, that is, the matrix prototype of the parity-check matrix includes 16 rows and 48 columns. The parity-check matrix extended based on the matrix prototype includes 1296 rows and 3888 columns. X=32, Y=16.

When R=3/4, the matrix prototype of the parity-check matrix is a matrix whose size is 12*48, that is, the matrix prototype of the parity-check matrix includes 12 rows and 48 columns. The parity-check matrix extended based on the matrix prototype includes 972 rows and 3888 columns. X=36, Y=12.

When R=5/6, the matrix prototype of the parity-check matrix is a matrix whose size is 8*48, that is, the matrix prototype of the parity-check matrix includes 8 rows and 48 columns. The parity-check matrix extended based on the matrix prototype includes 648 rows and 3888 columns. X=40, Y=8.

In this embodiment of this application, the parity-check matrix may be obtained after diagonal extension or anti-diagonal extension is performed on an element in an x^{th} row and a y^{th} column in the matrix prototype of the basic parity-check matrix. A code length N₀ corresponding to the basic parity-check matrix is less than or equal to 1944, and a coding rate corresponding to the basic parity-check matrix is the same as a coding rate corresponding to the parity-check matrix. The element in the x^{th} row and the y^{th} column is greater than or equal to 0. The parity-check matrix is obtained after diagonal extension or anti-diagonal extension is performed on each item in the basic parity-check matrix, so that modules in an LDPC encoding/decoding architecture whose code length is 1944 bits can be effectively reused. Details are described below.

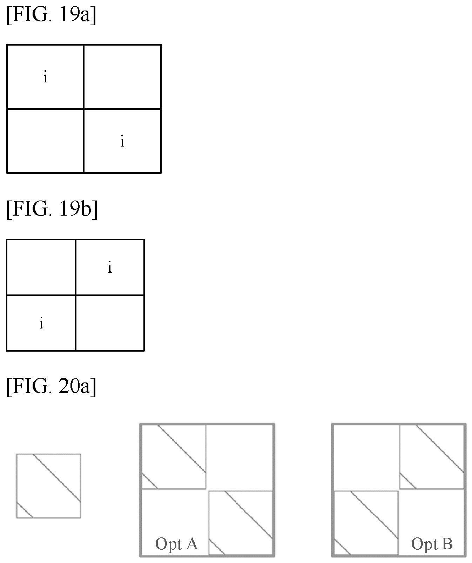

For example, if the element in the x^{th} row and the y^{th} column in the matrix prototype of the basic parity-check matrix is i, a matrix shown in FIG. 19a may be obtained after diagonal extension is performed on i, and a matrix shown in FIG. 19b may be obtained after anti-diagonal extension is performed on i, where i may be an integer greater than or equal to 0. For another example, the element in the x^{th} row and the j^{th} column in the matrix prototype of the basic parity-check matrix is "-1" or "-", and an element in a corresponding location in the parity-check matrix may still be "-1" or "-". Therefore, the element i in the matrix prototype of the basic parity-check matrix may be extended in a diagonal manner or an anti-diagonal manner. For example, each element may be extended to a 2*2 square matrix, and a non-negative element in the square matrix may represent CPM of a Z*Z unit matrix (for example, 0 in the square matrix may represent the Z*Z unit matrix, and an element greater than 0 may represent the CPM of the Z*Z unit matrix). In FIG. 19a and FIG. 19b, "-1" (or "-") is not shown in a blank area, and "-1" in the square matrix may represent a Z*Z all-zero square matrix.

(d) R=5/6 in FIG. 1a is used as an example. The basic parity-check matrix has Z=81, and the size of the matrix prototype of the basic parity-check matrix is 4 rows and 24 columns. Z of the parity-check matrix obtained after diagonal extension or anti-diagonal extension is performed on the element i in the basic parity-check matrix is still equal to 81, that is, a size of the expansion factor of the basic parity-check matrix remains unchanged. For example, when the element i is extended to a 2*2 square matrix, the matrix prototype of the parity-check matrix has a size of 8 rows and 48 columns, and a coding rate of the parity-check matrix is still equal to 5/6. Therefore, a code length may be equal to 1944*2=3888. Certainly, that the element i in the matrix prototype of the basic parity-check matrix shown in this embodiment of this application is extended to the 2*2 square matrix is merely an example. For example, the element i may also be extended to a 3*3 square matrix, or the element i may also be extended to a 4*4 square matrix. Examples are not enumerated herein. In this case, a code length of the extended parity-check matrix may be longer. For example, when the element i in the matrix prototype of the basic parity-check matrix is extended to the 3*3 square matrix, a code length corresponding to the parity-check matrix may be 24*3*81=5382. For another example, when the element i in the matrix prototype of the basic parity-check matrix is extended to the 4*4 square matrix, a code length corresponding to the parity-check matrix may be 24*4*81=7776. Examples are not enumerated herein.

In this embodiment of this application, diagonal extension or anti-diagonal extension may be performed on the element i in the matrix prototype of the basic parity-check matrix. This does not mean that diagonal extension or anti-diagonal extension is performed on each element in the matrix prototype of the basic parity-check matrix. Instead, diagonal extension is performed on a first part of elements greater than or equal to 0 in the matrix prototype of the basic parity-check matrix, and anti-diagonal extension is performed on a second part of elements greater than or equal to 0. A matrix corresponding to information bits in the matrix prototype of the parity-check matrix is obtained after diagonal extension or anti-diagonal extension is performed on the element in the x^{th} row and the y^{th} column in the matrix corresponding to the information bits in the matrix prototype of the basic parity-check matrix. To be specific, an information bit part in the matrix prototype of the parity-check matrix may be obtained after diagonal extension is performed on the first part of elements greater than or equal to 0 in the information bit part in the matrix prototype of the basic parity-check matrix, and after anti-diagonal extension is performed on the second part of elements greater than or equal to 0 in the information bit part in the matrix prototype of the basic parity-check matrix.

Further, a first column and a second column in the matrix that is corresponding to a parity bit and that is in the matrix prototype of the parity-check matrix are obtained after diagonal extension or anti-diagonal extension is performed on both a first element and a last element in the first column of the matrix corresponding to the parity bit in the matrix prototype of the basic parity-check matrix. In other words, the first column and the second column in the parity bit part in the matrix prototype of the parity-check matrix may be obtained after diagonal extension or anti-diagonal extension is performed on the first element (for example, an element 1) or the last element (for example, the element 1) in the first column of the parity bit part in the matrix prototype of the basic parity-check matrix. In other words, in the matrix prototype of the basic parity-check matrix, the first element and the last element in the first column in the last Y columns have the same extension manner.

For example, in the matrix prototype of the basic parity-check matrix, after diagonal extension (or anti-diagonal extension) is performed on both an element in a first row and the first column and an element in a last row and the first column in the last Y columns, an element in the first row and the first column, an element in a second row and the first column, an element in the first row and the second column, and an element in the second row and the second column in the last Y columns in the matrix prototype of the parity-check matrix, and an element in the last row and the first column, an element in the last but one row and the first column, an element in the last row and the second column, and an element in the last but one row and the second column are obtained. For example, an element in the first row and the first column in the last Y columns of the extension indication matrix is the same as an element in the last row and the first column. FIG. 13b is used as an example, and Y=6. To be specific, an element in the first row and the first column in the last six columns of the extension indication matrix is 0, and an element in the last row and the first column is also 0, as shown in FIG. 13c. Similarly, in the extension indication matrix in FIG. 14b, an element in the first row and the first column in the last column is 1, and an element in the last row and the first column is also 1. By analogy, details are not described herein.

For example, after diagonal extension or anti-diagonal extension is performed on an element 0 in the first column of the parity bit part in the matrix prototype of the basic parity-check matrix, an element at a corresponding location in the matrix prototype of the parity-check matrix is obtained.

Generally, the first column of the parity bit part in the matrix prototype of the basic parity-check matrix is of a "1-0-1" structure, that is, the first row and the last row of the column are all 1 from top to bottom, and the remaining rows are all 0. Therefore, to maintain a fast and efficient encoding algorithm of an original WLAN LDPC, a similar structure of the parity bit part is maintained in this embodiment of this application. For example, in the last Y columns of the extension indication matrix, both an element in the first row and an element in the last row are 0 or 1. In this way, a fast and efficient encoding algorithm of the LDPC code can be ensured.

Further, elements other than elements in the first column and the second column in the matrix corresponding to the parity bit in the matrix prototype of the parity-check matrix are obtained after diagonal extension is performed on elements 0 other than elements in the first column in the matrix corresponding to the parity bit in the matrix prototype of the basic parity-check matrix. In the matrix prototype of the basic parity-check matrix, all elements (for example, 0) other than "-1" (or "-") in other columns in the parity bit part except the first column may be diagonal extension. As shown in FIG. 1a, the element 0 in the parity bit part in the matrix prototype is extended in a diagonal manner, and the element 1 in the first column of the parity bit part is extended in the diagonal manner (or an anti-diagonal manner), so as to obtain the parity bit part in the matrix prototype of the parity-check matrix.

In other words, the first column and the second column in the parity bit part in the matrix prototype of the parity-check matrix may be obtained after diagonal extension or anti-diagonal extension is performed on both the first element and the last element in the first column of the parity bit part in the matrix prototype of the basic parity-check matrix, in addition, the remaining columns in the parity bit part in the matrix prototype of the parity-check matrix may be obtained after diagonal extension is performed on all elements 0 in other columns in the parity bit part except the first column in the matrix prototype of the basic parity-check matrix. Therefore, in an example, extension manners of elements in the parity bit part in the matrix prototype of the basic parity-check matrix may be the same. As shown in FIG. 4a, the parity bit part in the matrix prototype of the parity-check matrix may be obtained after diagonal extension is performed on all elements of the parity bit part in the matrix prototype of the basic parity-check matrix. In another example, extension manners of elements in the parity bit part in the matrix prototype of the basic parity-check matrix may not be completely the same. As shown in FIG. 8b, the parity bit part in the matrix prototype of the parity-check matrix may be obtained after anti-diagonal extension is performed on the first element and the last element in the first column of the parity bit part in the matrix prototype of the basic parity-check matrix, and diagonal extension is performed on all elements 0 in the parity bit part except the first element and the last element in the first column. Examples are not enumerated herein.

The matrix prototype of the parity-check matrix shown above may be obtained after corresponding extension is performed on elements in the matrix prototype of the basic parity-check matrix. An extension manner of each element shown above may also be represented by the extension indication matrix. For example, the matrix prototype of the parity-check matrix may be determined based on the matrix prototype of the basic parity-check matrix and the extension indication matrix. Alternatively, a relationship between the matrix prototype of the basic parity-check matrix and the matrix prototype of the parity-check matrix may be represented by the extension indication matrix.

A size of the extension indication matrix is the same as a size of the matrix prototype of the basic parity-check matrix. For example, an element in an x^{th} row and a y^{th} column in the extension indication matrix may indicate that a square matrix at a corresponding location in the matrix prototype of the parity-check matrix is obtained after diagonal extension or anti-diagonal extension is performed on an element in an x^{th} row and a y^{th} column in the matrix prototype of the basic parity-check matrix. For another example, an element in an x^{th} row and a y^{th} column in the extension indication matrix may indicate that the following operation is performed on the x^{th} row and the j^{th} column in the matrix prototype of the basic parity-check matrix to obtain an element in a corresponding location in the matrix prototype of the parity-check matrix: diagonal extension, anti-diagonal extension, and remaining unchanged.

For example, if an element in the x^{th} row and the j^{th} column in the extension indication matrix is an element j, the element j may be equal to 0, 1, or "-1" (or may be replaced with "-"). j=0 may indicate that the element at the corresponding location in the matrix prototype of the parity-check matrix is obtained after diagonal extension is performed on the element in the x^{th} row and the j^{th} column in the matrix prototype of the basic parity-check matrix. j=1 may indicate that the element at the corresponding location in the matrix prototype of the parity-check matrix is obtained after anti-diagonal extension is performed on the element in the x^{th} row and the j^{th} column in the matrix prototype of the basic parity-check matrix. j=-1 may indicate that the element (that is, "-1" or "-") in the x^{th} row and the j^{th} column in the matrix prototype of the basic parity-check matrix is extended to a 2*2 all-zero matrix, or j=-1 may indicate that the element at the corresponding location in the matrix prototype of the parity-check matrix is still the same as the element in the x^{th} row and the j^{th} column in the matrix prototype of the basic parity-check matrix, that is, "-1" (or understood as not being extended, or understood as remaining unchanged). A relationship between a value and a meaning of j shown herein is merely an example. In a specific implementation, another value may be used to represent the foregoing meaning. Examples are not enumerated herein.

For the coding rate R=1/2, the following description is provided:
In an example, the matrix prototype of the parity-check matrix shown in FIG. 4a may be determined based on the extension indication matrix shown in FIG. 4b and the matrix (a) (that is, R=1/2) shown in FIG. 1a.

For example, if an element in the first row and the first column in the matrix (a) shown in FIG. 1a is 57, and an element in the first row and the first column in the extension indication matrix shown in FIG. 4b is 1, it indicates that an element in the first row and the first column, an element in the first row and the second column, an element in the second row and the first column, and an element in the second row and the second column in the matrix prototype of the parity-check matrix are obtained after anti-diagonal extension is performed based on the element 57. In other words, in the matrix prototype of the parity-check matrix, the element in the first row and the first column is "-1", the element in the first row and the second column is 57, the element in the second row and the first column is 57, and the element in the second row and the second column is "-1".

For another example, if an element in the first row and the second column in the matrix (a) shown in FIG. 1a is "-1", an element in the first row and the second column in the extension indication matrix shown in FIG. 4b is still "-1", and an element in the first row and the third column, an element in the first row and the fourth column, an element in the second row and the third column, and an element in the second row and the fourth column in the matrix prototype of the parity-check matrix remain unchanged, that is still "-1".

For another example, if an element in the third row and the first column in the matrix (a) shown in FIG. 1a is 30, and an element in the third row and the first column in the extension indication matrix shown in FIG. 4b is 0, it indicates that an element in the fifth row and the first column, an element in the fifth row and the second column, an element in the sixth row and the first column, and an element in the sixth row and the second column in the matrix prototype of the parity-check matrix are obtained after diagonal extension is performed on the element 30. In other words, in the matrix prototype of the parity-check matrix, the element in the fifth row and the first column is 30, the element in the fifth row and the second column is "-1", the element in the sixth row and the first column is "-1", and the element in the sixth row and the second column is 30.

Descriptions of other elements in the matrix prototype of the basic parity-check matrix, other elements in the extension indication matrix, and elements in the matrix prototype of the parity-check matrix are not enumerated herein.

In another example, the matrix prototype of the parity-check matrix shown in FIG. 5a may be determined based on the extension indication matrix shown in FIG. 5b and the matrix (a) (that is, R=1/2) shown in FIG. 1a.

In still another example, the matrix prototype of the parity-check matrix shown in FIG. 6a may be determined based on the extension indication matrix shown in FIG. 6b and the matrix (a) (that is, R=1/2) shown in FIG. 1a.

For the coding rate R=2/3, the following description is provided:
In an example, the matrix prototype of the parity-check matrix shown in FIG. 7a may be determined based on the extension indication matrix shown in FIG. 7b and the matrix (b) (that is, R=2/3) shown in FIG. 1a.
In another example, the matrix prototype of the parity-check matrix shown in FIG. 8a may be determined based on the extension indication matrix shown in FIG. 8b and the matrix (b) (that is, R=2/3) shown in FIG. 1a.
In still another example, the matrix prototype of the parity-check matrix shown in FIG. 9a may be determined based on the extension indication matrix shown in FIG. 9b and the matrix (b) (that is, R=2/3) shown in FIG. 1a.

For the coding rate R=3/4, the following description is provided:
In an example, the matrix prototype of the parity-check matrix shown in FIG. 10a may be determined based on the extension indication matrix shown in FIG. 10b and the matrix (c) (that is, R=3/4) shown in FIG. 1a.
In another example, the matrix prototype of the parity-check matrix shown in FIG. 11a may be determined based on the extension indication matrix shown in FIG. 11b and the matrix (c) (that is, R=3/4) shown in FIG. 1a.
In still another example, the matrix prototype of the parity-check matrix shown in FIG. 12a may be determined based on the extension indication matrix shown in FIG. 12b and the matrix (c) (that is, R=3/4) shown in FIG. 1a.
In still another example, the matrix prototype of the parity-check matrix shown in FIG. 13a may be determined based on the extension indication matrix shown in FIG. 13b and the matrix (c) (that is, R=3/4) shown in FIG. 1a.

For the coding rate R=5/6, the following description is provided:
In an example, the matrix prototype of the parity-check matrix shown in FIG. 14a may be determined based on the extension indication matrix shown in FIG. 14b and the matrix (d) (that is, R=5/6) shown in FIG. 1a.
In another example, the matrix prototype of the parity-check matrix shown in FIG. 15a may be determined based on the extension indication matrix shown in FIG. 15b and the matrix (d) (that is, R=5/6) shown in FIG. 1a.
In still another example, the matrix prototype of the parity-check matrix shown in FIG. 16a may be determined based on the extension indication matrix shown in FIG. 16b and the matrix (d) (that is, R=5/6) shown in FIG. 1a.
In still another example, the matrix prototype of the parity-check matrix shown in FIG. 17a may be determined based on the extension indication matrix shown in FIG. 17b and the matrix (d) (that is, R=5/6) shown in FIG. 1a.

In an example, two communication parties (for example, the first communication apparatus and the second communication apparatus) store elements in the matrix prototype of the parity-check matrix. For example, each element in the matrix prototype in the parity-check matrix is stored, and when the code length is 3888 bits, the two communication parties may directly obtain the parity-check matrix based on the stored elements and the expansion factor. For another example, each element in the matrix prototype in the parity-check matrix is stored. When the code length is 1944 bits, the two communication parties may obtain the basic parity-check matrix based on the foregoing extension manner. In other words, the two communication parties may obtain LDPC codes of two code lengths by storing each element (or referred to as each CPM coefficient or cyclic shift value) in the matrix prototype of the parity-check matrix, so as to save storage space. In another example, the two communication parties may further store the basic parity-check matrix and the extension indication matrix. For example, when the code length is 3888 bits, the two communication parties may obtain the matrix prototype of the parity-check matrix based on the matrix prototype of the basic parity-check matrix and the extension indication matrix.

The foregoing indicates an extension manner of each element in the matrix prototype of the basic parity-check matrix in a form of a matrix. However, the foregoing matrix form is merely an example. In a specific implementation, other variations may be further performed on the foregoing extension indication matrix. For example, a bitmap manner is adopted to indicate the extension manner of each element in the matrix prototype of the basic parity-check matrix. For example, a length of the bitmap may be equal to a quantity of elements greater than or equal to 0 in the matrix prototype of the basic parity-check matrix. For another example, a table manner is adopted to indicate the extension manner of each element in the matrix prototype of the basic parity-check matrix. Examples are not enumerated herein.

The matrix prototype (or the parity-check matrix) of the parity-check matrix obtained based on the foregoing determination method falls within the protection scope of the embodiments of this application. In addition, with reference to the foregoing method and the tree structure, a parity-check matrix with better decoding performance may be further effectively screened out, and decoding performance of the parity-check matrix is further improved.

According to an extension manner of diagonal extension or anti-diagonal extension, one extension manner, that is, diagonal (Opt A) or anti-diagonal (Opt B), may be selected for each element in the matrix prototype of the basic parity-check matrix from the foregoing two extension manners. A small square in FIG. 20a may represent an element value in the matrix prototype of the basic parity-check matrix, an option A (Opt A) may represent a square matrix obtained after diagonal extension is performed on the element value, and an option B (Opt B) represents a square matrix obtained after anti-diagonal extension is performed on the element value.

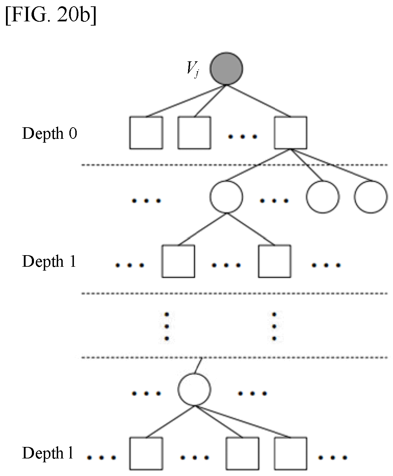

Specifically, when the Opt A or the Opt B is selected for the element value, to-be-selected nodes may be expanded according to a quantity, and an extension manner with a deep depth may be selected. A specific diagram of tree expansion is shown in FIG. 20b, where a circle represents a variable node, and a square represents a check node. A deeper depth of the expanded tree indicates fewer short cycles included in an obtained corresponding matrix, and the short cycles cause negative impact on decoding performance. If each variable node is expanded according to a tree, a depth corresponding to each Opt A or Opt B in a corresponding matrix may be different, and a cycle structure caused by the Opt A or Opt B in a factor graph (tanner graph) corresponding to an entire parity-check matrix may also be different. Therefore, in this embodiment of this application, a local cycle structure and an overall cycle structure of the matrix are comprehensively considered, and all non-zero elements are designed based on tree expansion, so as to ensure that the factor graph corresponding to the parity-check matrix has a good cycle structure.

With reference to the determination method and the tree structure shown above, it can be effectively ensured that the parity-check matrix provided in this embodiment of this application can maintain a fast and efficient encoding scheme of an original WLAN LDPC code, and decoding performance can be improved.

The following describes a simulation result of the parity-check matrix provided in this embodiment of this application.

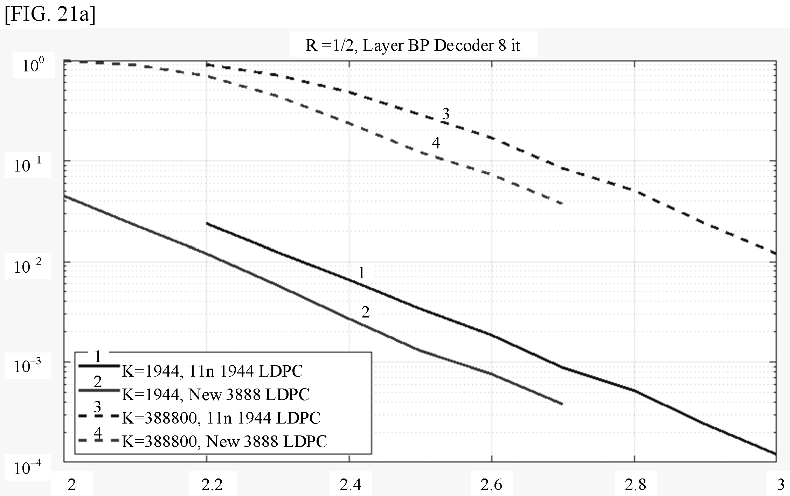

The following describes performance comparison between the foregoing parity-check matrix and the basic parity-check matrix. In FIG. 21a to FIG. 21d, a horizontal coordinate represents a signal-to-noise ratio (signal-to-noise ratio, SNR), and a unit is dB, and a vertical coordinate represents a block error rate (block error rate, BLER). A decoding method is a soft-decision decoding method, for example, a belief propagation (belief propagation, BP) algorithm, and a quantity of decoding iterations is 8. Sequence numbers 1 to 4 in FIG. 21a to FIG. 21d are set for ease of distinguishing different curves, and should not be construed as a limitation on the embodiments of this application.

FIG. 21a shows a performance comparison between a parity-check matrix of a code length 3888 and a basic parity-check matrix of a code length 1944. R=1/2.

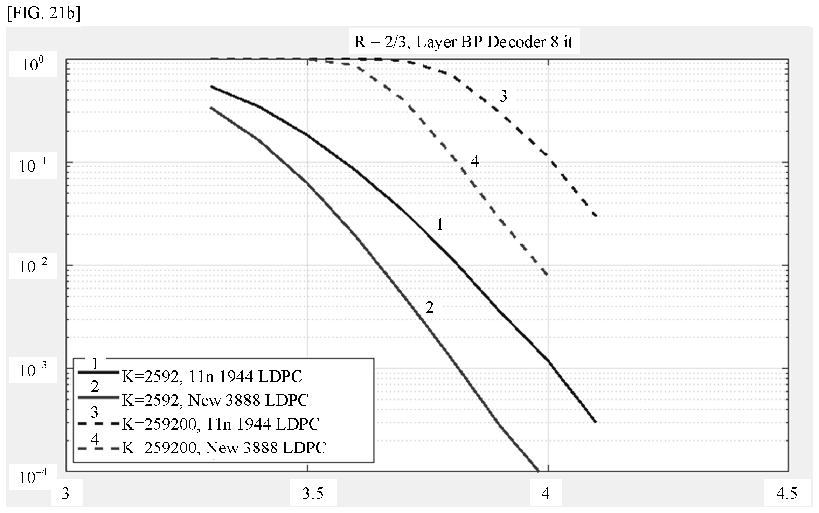

FIG. 21b shows the performance comparison between the parity-check matrix of the code length 3888 and the basic parity-check matrix of the code length 1944. R=2/3.

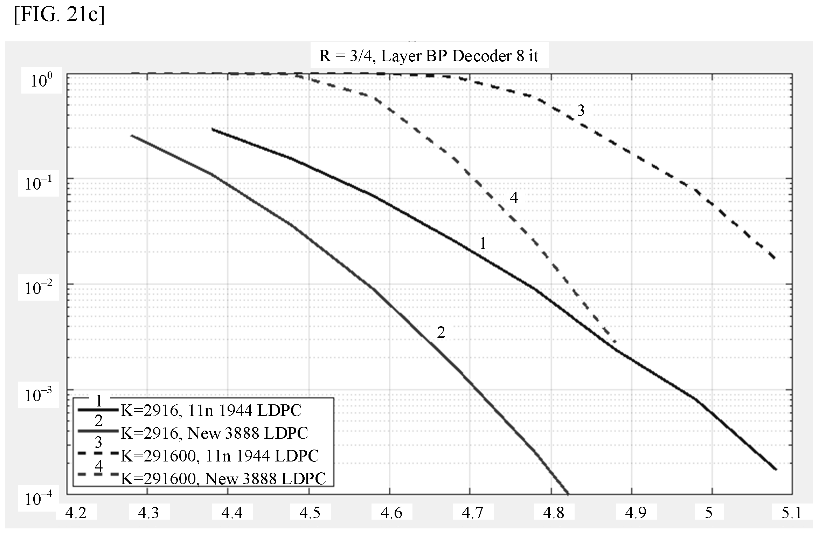

FIG. 21c shows the performance comparison between the parity-check matrix of the code length 3888 and the basic parity-check matrix of the code length 1944. R=3/4

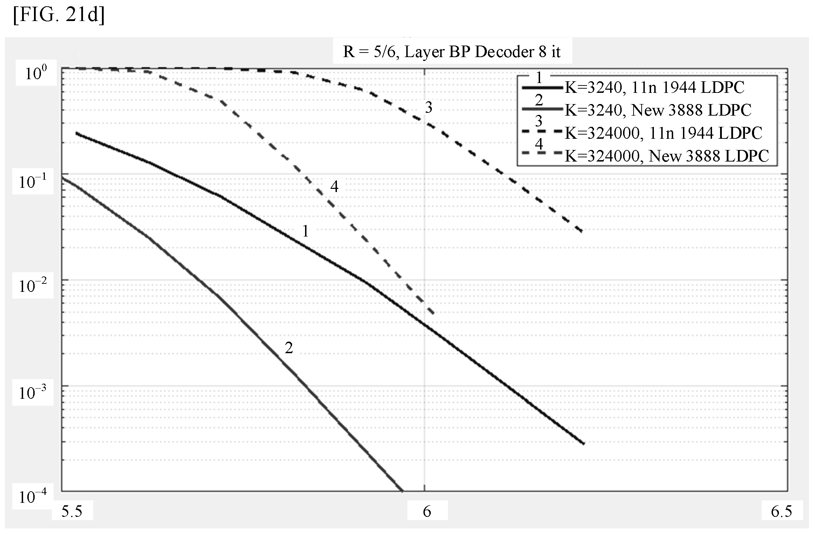

FIG. 21d shows the performance comparison between the parity-check matrix of the code length 3888 and the basic parity-check matrix of the code length 1944. R=5/6.

It can be learned from the foregoing that under a same SNR, a BLER corresponding to the parity-check matrix is lower. Therefore, decoding performance of the parity-check matrix is better. Therefore, each parity-check matrix provided in this embodiment of this application can achieve a significant improvement in decoding performance, and a good trade-off may be achieved between decoding performance and complexity.

In this embodiment of this application, in the matrix prototype of the parity-check matrix of the designed LDPC code, impact of columns with different column weights participating in a small cycle (or may also be referred to as a short cycle) on final performance is different. For example, if a small cycle is formed between columns with a small column weight (for example, a column weight is 2 or 3), performance deterioration is more severe than performance deterioration caused by a small cycle formed between columns with a large column weight. The small column weight is relative to the large column weight. For example, the small column weight means that a column weight is less than or equal to a first value, and the large column weight means that a column weight is greater than or equal to a second value. The first value may be equal to the second value, or the first value may be less than the second value. Specific values of the first value and the second value are not limited in this embodiment of this application.

Therefore, a small cycle may be preferentially avoided between columns with small column weights. In this embodiment of this application, extension design may be performed on the basic parity-check matrix based on different column weights, or extension design may be performed on the basic parity-check matrix based on different column weight groups. In other words, regions with a same column weight in the basic parity-check matrix may be preferentially designed for extension, that is, an extension indication matrix corresponding to the regions with the same column weight is preferentially designed. The extension indication matrix designed in this embodiment of this application may be designed based on different column weights, or may be designed based on different column weight groups.

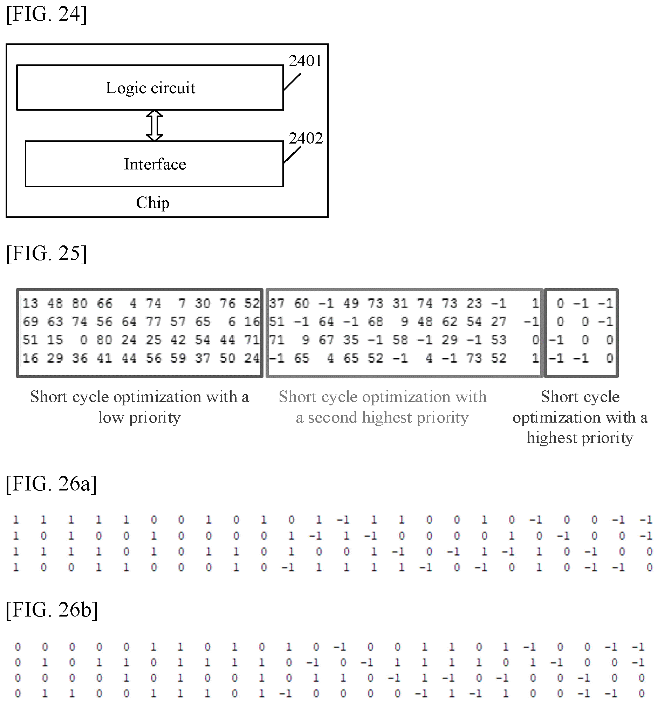

FIG. 25 is a diagram of a grouping design for a matrix prototype of a basic parity-check matrix according to an embodiment of this application. FIG. 25 is a diagram of an example of a grouping design for a matrix prototype of a basic parity-check matrix when a code rate R=5/6 and N=1944. As shown in FIG. 25, the matrix prototype of the LDPC basic parity-check matrix when the coding rate R=5/6 and N=1944 may be designed into three groups based on column weights, and then the groups are sequentially optimized based on priorities. For example, first, for a region corresponding to short cycle optimization with a highest priority, an extension indication matrix (for example, a column weight is 2) corresponding to the region may be designed first, to preferentially ensure performance of the region. Second, for a region corresponding to short cycle optimization with a second highest priority, an extension indication matrix (for example, a column weight is 3) corresponding to the region may be optimized. A region corresponding to short cycle optimization with a low priority (for example, a column weight is 4) is optimized. FIG. 25 shows a case in which R=5/6. For another coding rate, an extension indication matrix may also be designed based on a column weight. The column-based regrouping or region-based optimization method is similar to the foregoing example, and each grouping region may also be designed according to a priority of short cycle optimization. Examples are not enumerated herein. The foregoing column weight is shown by using a quantity of non- "-1" in a column as an example.

In the foregoing method for designing the LDPC parity-check matrix or the extension indication matrix, the extension indication matrix corresponding to columns with the same column weight may fall within the protection scope of the embodiments of this application. In other words, according to the foregoing design method, an extension indication matrix corresponding to one or more packet regions also falls within the protection scope of the embodiments of this application. This principle is applicable to all the embodiments of this application. The extension indication matrix shown in this embodiment of this application may also be referred to as an extended pattern. For example, FIG. 25 is used as an example. An extension indication matrix (or referred to as a first partial extension indication matrix) and a matrix prototype (or referred to as a first partial matrix prototype) of the parity-check matrix corresponding to the short cycle optimization with the highest priority may fall within the protection scope of the embodiments of this application. An extension indication matrix (or referred to as a second partial extension indication matrix) and a matrix prototype (or referred to as a second partial matrix prototype) of the parity-check matrix corresponding to the short cycle optimization with the second highest priority also fall within the protection scope of the embodiments of this application. An extension indication matrix (or referred to as a third partial extension indication matrix) and a matrix prototype (or referred to as a third partial matrix prototype) of the parity-check matrix corresponding to the short cycle optimization with the low priority also fall within the protection scope of the embodiments of this application. Similarly, matrix prototypes of the extension indication matrix and the parity-check matrix corresponding to all the regions shown in FIG. 25 also fall within the protection scope of the embodiments of this application.

In the extension indication matrix, in addition to the matrix corresponding to the parity-check square matrix, negation of all columns or negation of some columns in the remaining matrix also falls within the protection scope of this embodiment of this application. In other words, in the extension indication matrix, negation of all columns or negation of some columns of the matrix corresponding to the information bit part also falls within the protection scope of this embodiment of this application. For ease of description, a remaining partial matrix region in the extension indication matrix except the matrix corresponding to the parity-check square matrix is referred to as an information part matrix or a system part matrix. In a structural feature of the matrix prototype of the 11n LDPC parity-check matrix, a parity-check square matrix of the 11n LDPC parity-check matrix has a fixed structure and includes a double diagonal structure. Therefore, to implement fast encoding, a matrix corresponding to the parity-check square matrix in the extension indication matrix may not be negated. Whether to perform negation on the matrix corresponding to the parity-check square matrix is not limited in the embodiments of this application.

In this embodiment of this application, a matrix obtained after column permutation or row permutation is performed on the matrix prototype of the parity-check matrix also falls within the protection scope of this embodiment of this application. In other words, after column permutation or row permutation is performed on the matrix prototypes of the parity-check matrices shown in this application, or both row permutation and column permutation are performed, the matrix prototype of the parity-check matrix may also be obtained. The matrix prototype before permutation has the same performance as the matrix prototype after permutation. The method for determining the extension indication matrix or the method for determining the matrix prototype of the parity-check matrix in the embodiments of this application also falls within the protection scope of the embodiments of this application. Because the matrix prototype of the parity-check matrix has the foregoing changes, the matrix prototypes are enumerated one by one in this embodiment of this application. Therefore, all or some of the foregoing variations of the LDPC matrices also fall within the protection scope of this application.

FIG. 26a and FIG. 26b are diagrams of an extension indication matrix according to an embodiment of this application. For the matrix prototype of the LDPC parity-check matrix with the coding rate R=5/6 and N=1944 shown in FIG. 25, an embodiment of this application shows the extension indication matrix.

The extension indication matrix shown in FIG. 26b is obtained after the information part matrix of the extension indication matrix shown in FIG. 26a is negated. A specific negation manner is: negating "1" in the information part matrix in the extension indication matrix to "0", negating "0" to "1", and remaining "-1" unchanged. In addition, a rightmost 4x4 parity matrix remains unchanged. After the information part matrix is negated according to the foregoing method, cycle length distribution of each variable node corresponding to the parity-check matrix obtained by extension is the same as the parity-check matrix obtained by extension before negation. Therefore, the two extension manners may be considered equivalent under an optimization principle for the cycle length distribution.

In other words, for all extension indication matrices, matrix prototypes of parity-check matrices, or parity-check matrices provided in this embodiment of this application, an extension indication matrix obtained after matrix negation of a corresponding information part (for example, "1" is negated to "0", "0" is negated to "1", and "-1" remains unchanged) and a matrix prototype of a parity-check matrix obtained based on the extension indication matrix fall within the protection scope of this embodiment of this application.

In addition to the matrix prototypes and the extension indication matrices of the parity-check matrices shown above, the embodiments of this application further provide the following matrices. R corresponding to the matrix prototype of the parity-check matrix shown below is the same as R corresponding to the parity-check matrix. For example, N₁ corresponding to the matrix prototype of the parity-check matrix shown below may be equal to 3888. In addition, N₁ corresponding to the parity-check matrix is also equal to 3888. For descriptions of R, N₁, or the like, refer to the foregoing description. Details are not described herein again.

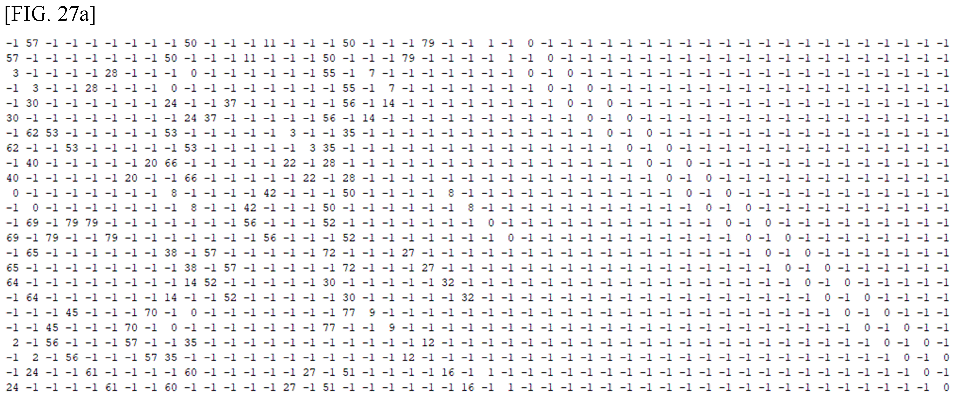

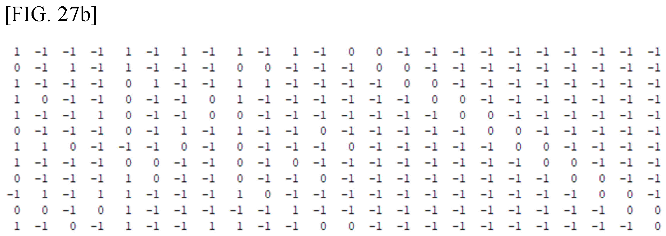

For the coding rate R=1/2, the following description is provided:
In an example, the matrix prototype of the parity-check matrix may be shown in FIG. 27a. The matrix prototype of the parity-check matrix shown in FIG. 27a may be determined based on the extension indication matrix shown in FIG. 27b and the matrix (a) (that is, R=1/2) shown in FIG. 1a.

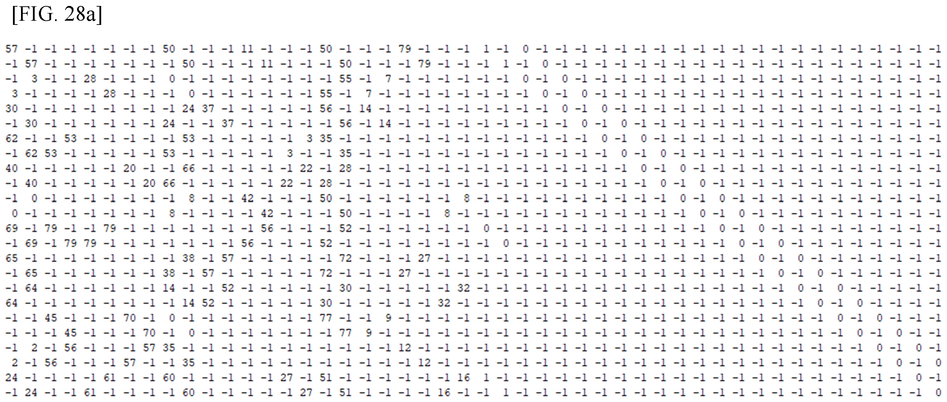

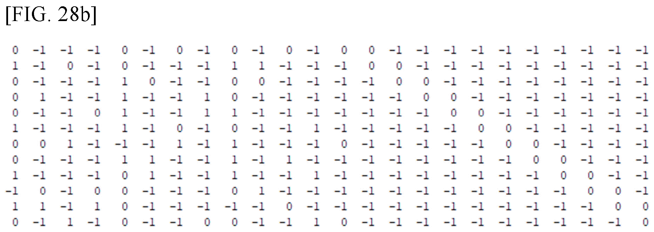

In another example, the matrix prototype of the parity-check matrix may be shown in FIG. 28a. The matrix prototype of the parity-check matrix shown in FIG. 28a may be determined based on the extension indication matrix shown in FIG. 28b and the matrix (a) (that is, R=1/2) shown in FIG. 1a.

The extension indication matrix shown in FIG. 28b is an extension indication matrix obtained after the information part matrix in the extension indication matrix shown in FIG. 27b is negated. FIG. 27b and FIG. 28b show the extension indication matrix obtained after the information part matrix in the extension indication matrix is negated. FIG. 27a and FIG. 28a show a matrix prototype of a parity-check matrix corresponding to the negated extension indication matrix. For ease of brevity, the following does not show an extension indication matrix obtained after the information part matrix in the extension indication matrix is negated.

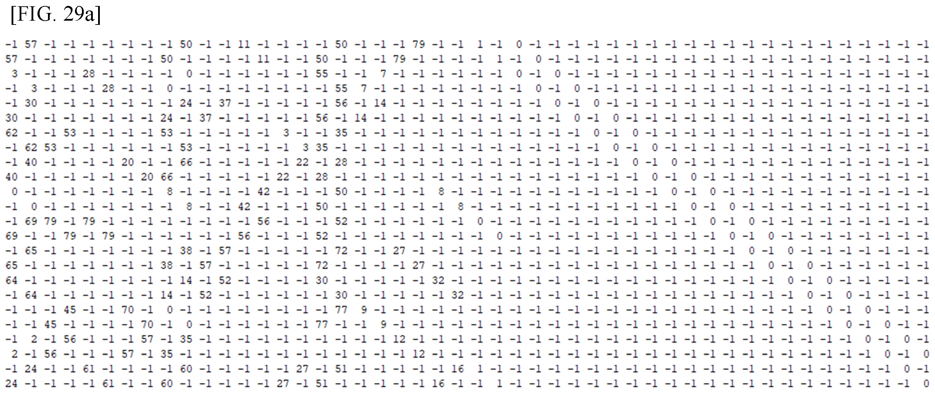

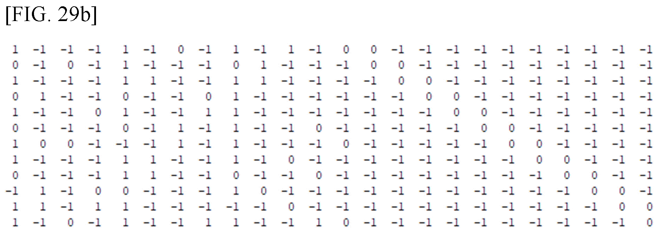

In still another example, the matrix prototype of the parity-check matrix may be shown in FIG. 29a. The matrix prototype of the parity-check matrix shown in FIG. 29a may be determined based on the extension indication matrix shown in FIG. 29b and the matrix (a) (that is, R=1/2) shown in FIG. 1a.

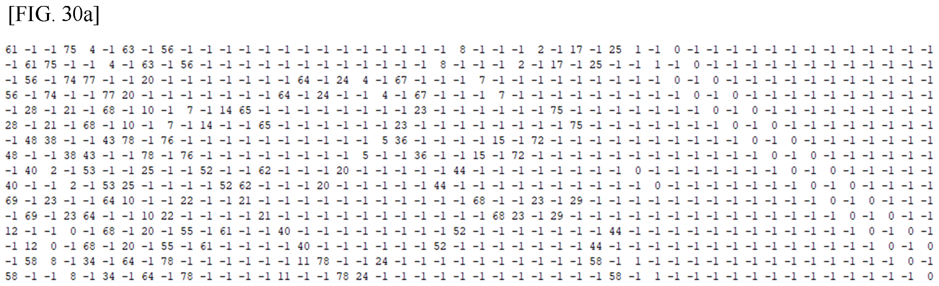

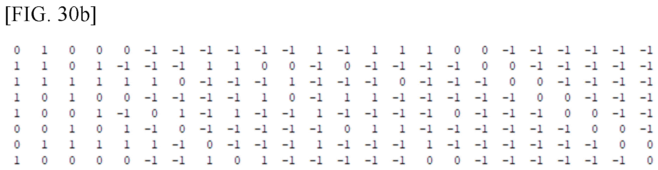

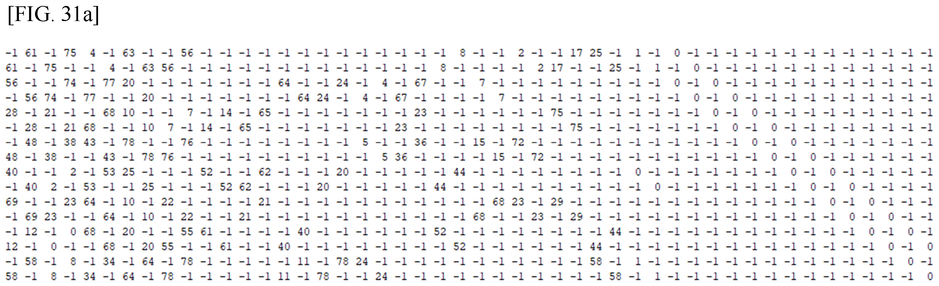

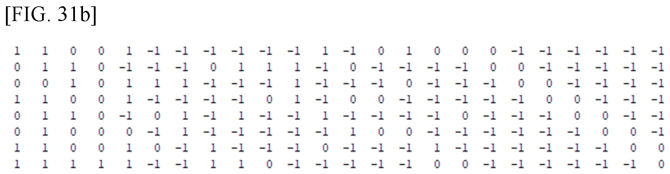

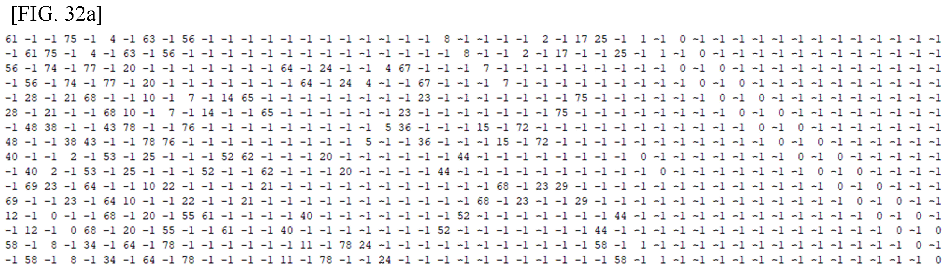

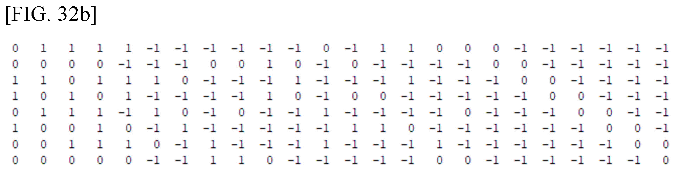

For the coding rate R=2/3, the following description is provided:
In an example, the matrix prototype of the parity-check matrix may be shown in FIG. 30a. The matrix prototype of the parity-check matrix shown in FIG. 30a may be determined based on the extension indication matrix shown in FIG. 30b and the matrix (b) (that is, R=2/3) shown in FIG. 1a. In another example, the matrix prototype of the parity-check matrix may be shown in FIG. 31a. The matrix prototype of the parity-check matrix shown in FIG. 31a may be determined based on the extension indication matrix shown in FIG. 31b and the matrix (b) (that is, R=2/3) shown in FIG. 1a.
In still another example, the matrix prototype of the parity-check matrix may be shown in FIG. 32a. The matrix prototype of the parity-check matrix shown in FIG. 32a may be determined based on the extension indication matrix shown in FIG. 32b and the matrix (b) (that is, R=2/3) shown in FIG. 1a.

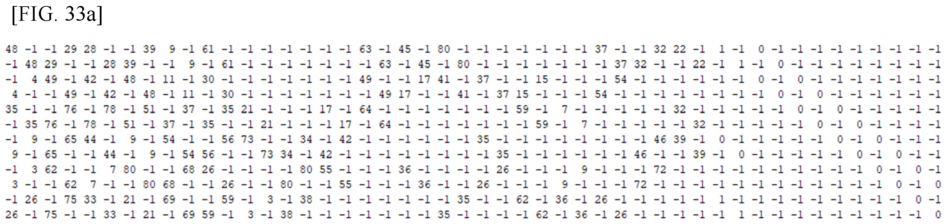

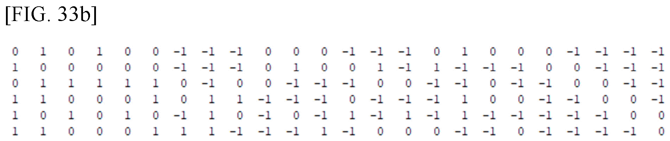

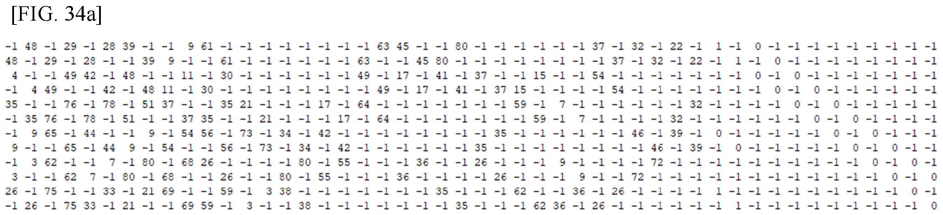

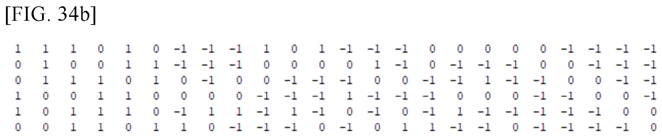

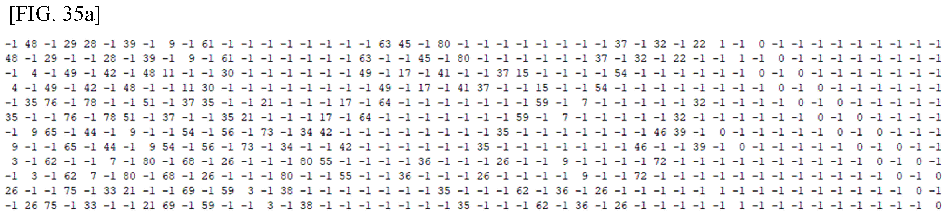

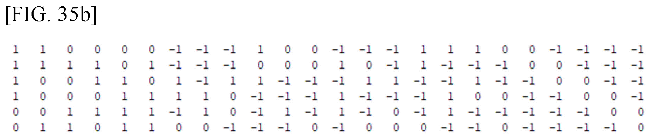

For the coding rate R=3/4, the following description is provided:
In an example, the matrix prototype of the parity-check matrix may be shown in FIG. 33a. The matrix prototype of the parity-check matrix shown in FIG. 33a may be determined based on the extension indication matrix shown in FIG. 33b and the matrix (c) (that is, R=3/4) shown in FIG. 1a.
In another example, the matrix prototype of the parity-check matrix may be shown in FIG. 34a. The matrix prototype of the parity-check matrix shown in FIG. 34a may be determined based on the extension indication matrix shown in FIG. 34b and the matrix (c) (that is, R=3/4) shown in FIG. 1a.
In still another example, the matrix prototype of the parity-check matrix may be shown in FIG. 35a. The matrix prototype of the parity-check matrix shown in FIG. 35a may be determined based on the extension indication matrix shown in FIG. 35b and the matrix (c) (that is, R=3/4) shown in FIG. 1a.

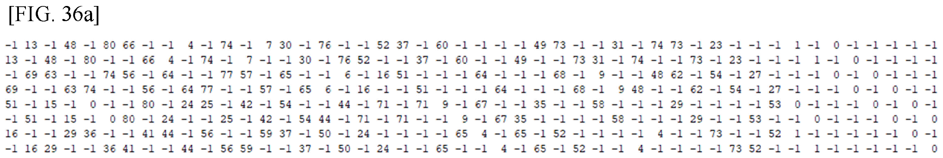

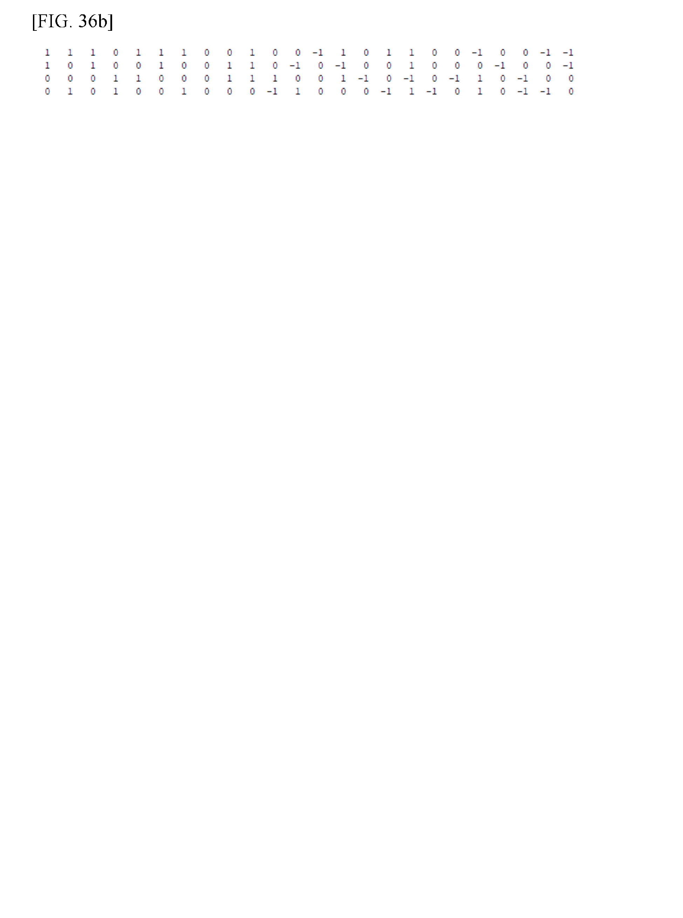

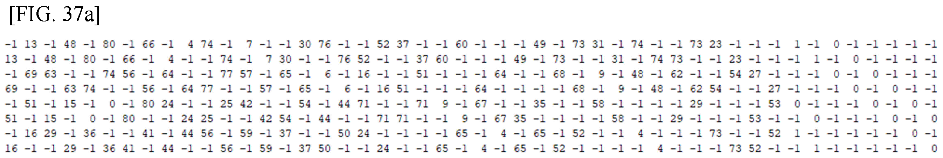

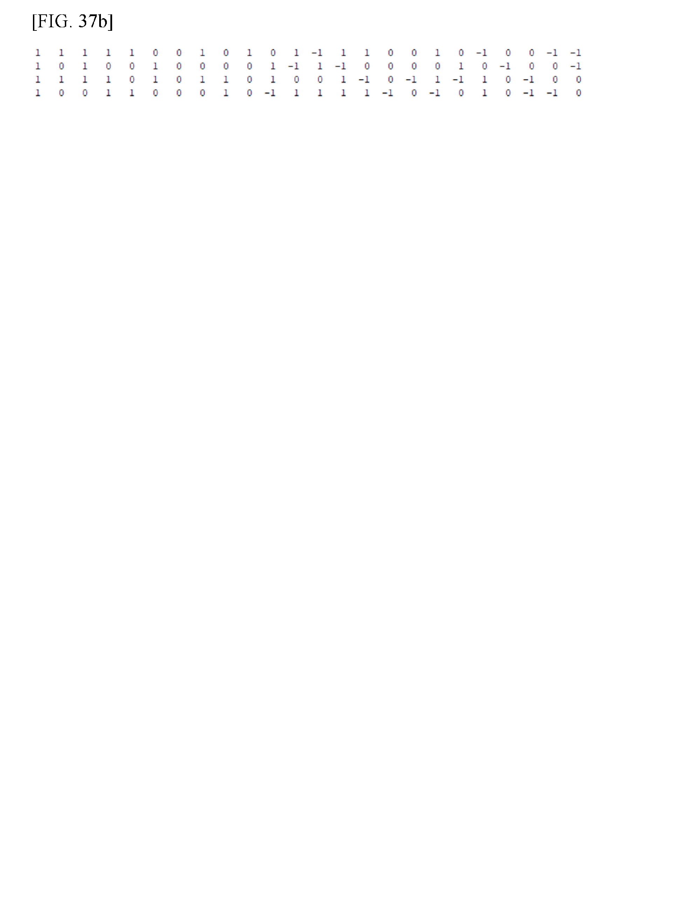

For the coding rate R=5/6, the following description is provided:
In an example, the matrix prototype of the parity-check matrix may be shown in FIG. 36a. The matrix prototype of the parity-check matrix shown in FIG. 36a may be determined based on the extension indication matrix shown in FIG. 36b and the matrix (d) (that is, R=5/6) shown in FIG. 1a.
In another example, the matrix prototype of the parity-check matrix may be shown in FIG. 37a. The matrix prototype of the parity-check matrix shown in FIG. 37a may be determined based on the extension indication matrix shown in FIG. 37b and the matrix (d) (that is, R=5/6) shown in FIG. 1a.

A communication apparatus provided in embodiments of this application is described below.

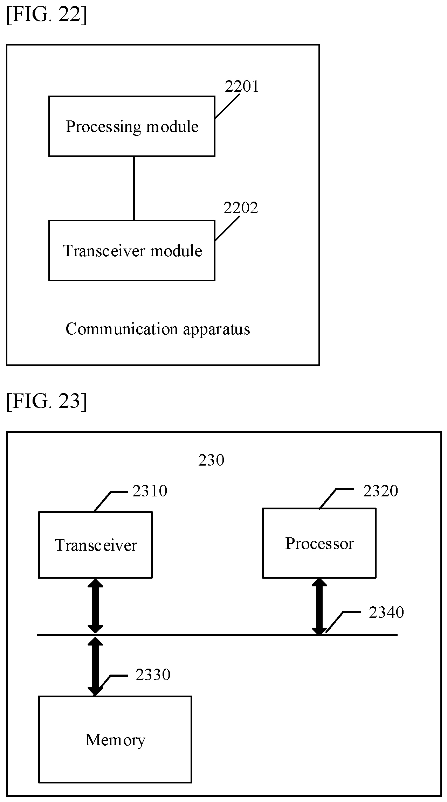

In this application, the communication apparatus is divided into functional modules based on the foregoing method embodiments. For example, each functional module may be obtained through division based on each corresponding function, or two or more functions may be integrated into one processing module. The integrated module may be implemented in a form of hardware, or may be implemented in a form of a software functional module. It should be noted that, in this application, division into the modules is an example, and is merely a logical function division. In actual implementation, another division manner may be used. The communication apparatus provided in embodiments of this application is described below in detail with reference to FIG. 22 to FIG. 24.

FIG. 22 is a diagram of a structure of a communication apparatus according to an embodiment of this application. As shown in FIG. 22, the communication apparatus includes a processing module 2201 and a transceiver module 2202. The transceiver module 2202 may implement a corresponding communication function, and the processing module 2201 is configured to implement a corresponding processing function. For example, the transceiver module 2202 may also be referred to as an interface, a communication interface, a communication module, or the like.

In some embodiments of this application, the communication apparatus may be configured to perform an action performed by the first communication apparatus in the foregoing method embodiments. In this case, the first communication apparatus may be a Wi-Fi device, or a chip, a functional module that can be configured in the device. The transceiver module 2202 is configured to perform a sending/receiving-related operation of the first communication apparatus in the foregoing method embodiments, and the processing module 2201 is configured to perform a processing-related operation of the first communication apparatus in the foregoing method embodiments.

For example, the processing module 2201 may be configured to: obtain an information bit sequence, and perform LDPC encoding on the information bit sequence based on a parity-check matrix, to obtain an encoded sequence; and the transceiver module 2202 may be configured to output the encoded sequence.

For example, the processing module 2201 may be further configured to perform other processing on the encoded sequence; and the transceiver module 2202 may be further configured to send or output a signal obtained after other processing.

For example, the processing module 2201 may include an encoding module. For example, the processing module 2201 may further include an obtaining module, a shortening module, a block division module, or the like. For example, the processing module 2201 may further include at least one of the following modules: a constellation mapping module, a stream cyclic shift module, a spatial and frequency mapping module, an IDFT module, and a cyclic prefix insertion and windowing module. For example, the transceiver module 2202 may include a radio frequency module, an antenna module, or the like. For example, the transceiver module 2202 may include a pin module or the like.

FIG. 22 is reused. In some other embodiments of this application, the communication apparatus may be configured to perform an action performed by the second communication apparatus in the foregoing method embodiments. In this case, the communication apparatus may be a Wi-Fi device, or a chip, a functional module, or the like that can be configured in the device. The transceiver module 2202 is configured to perform a sending/receiving-related operation of the second communication apparatus in the foregoing method embodiments, and the processing module 2201 is configured to perform a processing-related operation of the second communication apparatus in the foregoing method embodiments.

For example, the transceiver module 2202 may be configured to receive or input a signal transmitted through a channel; and the processing module 2201 may be configured to process the signal to obtain to-be-decoded information.

For example, the transceiver module 2202 may be configured to input the to-be-decoded information; and the processing module 2201 may perform LDPC decoding on the to-be-decoded information based on the parity-check matrix, to obtain the information bit sequence.

For example, the processing module 2201 may include a decoding module. For example, the processing module 2201 may further include an obtaining module or the like. For example, the processing module 2201 may further include at least one of the following components: a cyclic prefix removal module, a DFT module, a deinterleaving module, a constellation demapping module, and a descrambling module. For example, the transceiver module 2202 may include a radio frequency module, an antenna module, or the like. For example, the transceiver module 2202 may include a pin module or the like.

Optionally, in the foregoing embodiments, the communication apparatus may further include a storage module. The storage module may be configured to store instructions and/or data. The processing module 2201 may read the instructions and/or the data in the storage module, to enable the communication apparatus to implement the foregoing method embodiments. For example, the storage module may store the matrix prototype of the parity-check matrix shown above, or the storage module may be configured to store the CPM coefficient in the matrix prototype of the parity-check matrix shown above, an extension indication matrix, or the like.

In the foregoing embodiments, for specific descriptions of terms or steps such as the reference parity-check matrix, the parity-check matrix, the prototype of the parity-check matrix, the prototype of the reference parity-check matrix, the CPM, the quantity of cyclic shift bits, the expansion factor, the code length, and the coding rate, refer to the descriptions in the foregoing method embodiments. Details are not described herein again.

Specific descriptions of the transceiver module and the processing module shown in the foregoing embodiments are merely examples. For specific functions or steps performed by the transceiver module and the processing module, refer to the foregoing method embodiments. Details are not described herein again.

The foregoing describes the communication apparatus in embodiments of this application. The following describes a possible product form of the communication apparatus. Any form of product that has a function of the communication apparatus in FIG. 22 falls within the protection scope of embodiments of this application. The following descriptions are merely examples, and a product form of the communication apparatus in embodiments of this application is not limited thereto.

In a possible implementation, in the communication apparatus shown in FIG. 22, the processing module 2201 may be one or more processors, and the transceiver module 2202 may be a transceiver; or the transceiver module 2202 may be a sending module and a receiving module, the sending module may be a transmitter, the receiving module may be a receiver, and the sending module and the receiving module are integrated into one device, for example, a transceiver. In embodiments of this application, the processor and the transceiver may be coupled, or the like. A connection manner between the processor and the transceiver is not limited in embodiments of this application. In a process of performing the foregoing method, a process of sending information in the foregoing method may be a process of outputting the information by the processor. When outputting the information, the processor outputs the information to a transceiver, so that the transceiver transmits the information. After the information is outputted by the processor, other processing may further need to be performed on the information before the information arrives at the transceiver. Similarly, a process of receiving information in the foregoing method may be a process of receiving the input information by the processor. When the processor receives the input information, the transceiver receives the information and inputs the information to the processor. Further, after the transceiver receives the information, other processing may need to be performed on the information before the information is input into the processor.

As shown in FIG. 23, the communication apparatus 230 includes one or more processors 2320 and a transceiver 2310.

In some embodiments of this application, the communication apparatus may be configured to perform steps, methods, or functions performed by the first communication apparatus. For example, the processor 2320 may be configured to perform functions or steps implemented by the processing module 2201 shown in FIG. 22. The transceiver 2310 may be configured to perform functions or steps implemented by the transceiver module 2202 shown in FIG. 22. For specific descriptions of the processor 2320 and the transceiver 2310, refer to FIG. 22 or the method embodiments shown above. Details are not described herein again.

In some other embodiments of this application, the communication apparatus is configured to perform steps, methods, or functions performed by the second communication apparatus. For example, the processor 2320 may be configured to perform functions or steps implemented by the processing module 2201 shown in FIG. 22. The transceiver 2310 may be configured to perform functions or steps implemented by the transceiver module 2202 shown in FIG. 22. For specific descriptions of the processor 2320 and the transceiver 2310, refer to FIG. 22 or the method embodiments shown above. Details are not described herein again.

In various implementations of the communication apparatus shown in FIG. 23, the transceiver may include a receiver and a transmitter, the receiver is configured to perform a receiving function (or operation), and the transmitter is configured to perform a transmitting function (or operation). In addition, the transceiver is configured to communicate with another device/apparatus through a transmission medium.

Optionally, the communication apparatus 230 may further include one or more memories 2330, configured to store program instructions and/or data. The memory 2330 is coupled to the processor 2320. The coupling in embodiments of this application may be an indirect coupling or a communication connection between communication apparatuses, units, or modules in an electrical form, a mechanical form, or another form, and is used for information exchange between the communication apparatuses, the units, or the modules. The processor 2320 may operate in collaboration with the memory 2330. The processor 2320 may execute the program instructions stored in the memory 2330. Optionally, at least one of the one or more memories may be included in the processor.

A specific connection medium between a transceiver 2310, the processor 2320, and the memory 2330 is not limited in this embodiment of this application. In this embodiment of this application, the memory 2330, the processor 2320, and the transceiver 2310 are connected through a bus 2340 in FIG. 23, and the bus is represented by a thick line in FIG. 23. A connection manner between other components is schematically described, and is not limited thereto. The bus may be classified into an address bus, a data bus, a control bus, and the like. For ease of representation, only one thick line is used to represent the bus in FIG. 23, but this does not mean that there is only one bus or only one type of bus.

In this embodiment of this application, the processor may be a general-purpose processor, a digital signal processor, an application-specific integrated circuit, a field programmable gate array or another programmable logic device, a discrete gate or transistor logic device, a discrete hardware component, or the like. The processor can implement or execute the methods, the steps, and the logical block diagrams disclosed in embodiments of this application. The general-purpose processor may be a microprocessor or any conventional processor or the like. The steps of the methods disclosed in combination with embodiments of this application may be directly implemented by a hardware processor, or may be implemented by using a combination of hardware and software modules in the processor, or the like.

In this embodiment of this application, the memory may include but is not limited to a nonvolatile memory such as a hard disk drive (hard disk drive, HDD) or a solid-state drive (solid-state drive, SSD), a random access memory (Random Access Memory, RAM), an erasable programmable read-only memory (Erasable Programmable ROM, EPROM), a read-only memory (Read-Only Memory, ROM), or a portable read-only memory (Compact Disc Read-Only Memory, CD-ROM). The memory is any storage medium that can be used to carry or store program code in a form of an instruction or a data structure and that can be read and/or written by a computer (for example, the communication apparatus shown in this application). However, this application is not limited thereto. The memory in embodiments of this application may alternatively be a circuit or any other apparatus that can implement a storage function, and is configured to store the program instructions and/or the data.

The processor 2320 is mainly configured to process a communication protocol and communication data, control the communication apparatus, execute a software program, and process data of the software program. The memory 2330 is mainly configured to store the software program and data. The transceiver 2310 may include a control circuit and an antenna. The control circuit is mainly configured to convert a baseband signal and a radio frequency signal and process the radio frequency signal. The antenna is mainly configured to receive and send a radio frequency signal in a form of an electromagnetic wave. The input/output apparatus, such as a touchscreen, a display, or a keyboard, is mainly configured to receive data input by a user and output data to the user.

After the communication apparatus is powered on, the processor 2320 may read the software program in the memory 2330, interpret and execute instructions of the software program, and process data of the software program. When data needs to be sent in a wireless manner, after performing baseband processing on the to-be-sent data, the processor 2320 outputs a baseband signal to the radio frequency circuit; and the radio frequency circuit performs radio frequency processing on the baseband signal and then sends the radio frequency signal to the outside in a form of an electromagnetic wave through the antenna. When data is sent to the communication apparatus, the radio frequency circuit receives a radio frequency signal through the antenna, converts the radio frequency signal into a baseband signal, and outputs the baseband signal to the processor 2320. The processor 2320 converts the baseband signal into data, and processes the data.

In another implementation, the radio frequency circuit and the antenna may be disposed independent of the processor that performs baseband processing. For example, in a distributed scenario, the radio frequency circuit and the antenna may be disposed remotely and independently of the communication apparatus.

The communication apparatus shown in this embodiment of this application may further have more components than those shown in FIG. 23, or the like. This is not limited in this embodiment of this application. The methods performed by the processor and the transceiver are merely examples. For specific steps performed by the processor and the transceiver, refer to the methods described above.

In another possible implementation, in the communication apparatus shown in FIG. 22, the processing module 2201 may be one or more logic circuits, and the transceiver module 2202 may be an input/output interface that is also referred to as a communication interface, an interface circuit, an interface, or the like. Alternatively, the transceiver module 2202 may be a sending module and a receiving module. The sending module may be an output interface, and the receiving module may be an input interface. The sending module and the receiving module are integrated into one module, for example, an input/output interface. As shown in FIG. 24, the communication apparatus shown in FIG. 24 includes a logic circuit 2401 and an interface 2402. In other words, the processing module 2201 may be implemented by the logic circuit 2401, and the transceiver module 2202 may be implemented by the interface 2402. The logic circuit 2401 may be a chip, a processing circuit, an integrated circuit, a system on chip (system on chip, SoC) chip, or the like. The interface 2402 may be a communication interface, an input/output interface, a pin, or the like. For example, FIG. 24 shows an example in which the communication apparatus is a chip. The chip includes the logic circuit 2401 and the interface 2402.

In this embodiment of this application, the logic circuit and the interface may further be coupled to each other. A specific manner of connection between the logic circuit and the interface is not limited in this embodiment of this application. For example, the logic circuit 2401 may be configured to perform a function or a step implemented by the processing module 2201 shown in FIG. 22, and the interface 2402 may be configured to perform a function or a step implemented by the transceiver module 2202 shown in FIG. 22. For specific descriptions of the logic circuit 2401 and the interface 2402, refer to FIG. 22 or the method embodiments shown above. Details are not described herein again.

The communication apparatus shown in embodiments of this application may implement the methods according to embodiments of this application in a form of hardware, or may implement the methods according to embodiments of this application in a form of software. This is not limited in embodiments of this application.

An embodiment of this application further provides a communication system. The communication system includes a first communication apparatus and a second communication apparatus. The first communication apparatus and the second communication apparatus may be configured to perform the method according to any one of the foregoing embodiments.

In addition, this application further provides a computer program. The computer program is configured to implement operations and/or processing performed by communication apparatuses in the method provided in this application.

This application further provides a computer-readable storage medium. The computer-readable storage medium stores computer code. When the computer code is run on a computer, the computer is enabled to perform operations and/or processing performed by the communication apparatuses in the methods provided in this application.

This application further provides a computer program product. The computer program product includes computer code or a computer program. When the computer code or the computer program is run on a computer, operations and/or processing performed by the communication apparatuses in the methods provided in this application are/is performed.

In the several embodiments provided in this application, it should be understood that the disclosed system, communication apparatus, and method may be implemented in other manners. For example, the described communication apparatus embodiments are merely examples. For example, division into the modules is merely logical function division. In actual implementation, there may be another division manner. For example, a plurality of modules or components may be combined or integrated into another system, or some features may be ignored or not performed. In addition, the displayed or discussed mutual couplings or direct couplings or communication connections may be implemented through some interfaces, communication apparatuses, or modules. The indirect couplings or communication connections between the communication apparatuses or modules may be implemented in electrical, mechanical, or other forms.

The modules described as separate parts may or may not be physically separate, and parts displayed as modules may or may not be physical modules, may be located in one position, or may be distributed on a plurality of network modules. Some or all of the modules may be selected based on an actual requirement to achieve the technical effects of the solutions provided in embodiments of this application.

In addition, functional modules in embodiments of this application may be integrated into one processing module, or each of the modules may exist alone physically, or two or more modules may be integrated into one module. The integrated module may be implemented in a form of hardware, or may be implemented in a form of a software functional module.

When the integrated module is implemented in the form of a software functional module and sold or used as an independent product, the integrated unit may be stored in a computer-readable storage medium. Based on such an understanding, the technical solutions of this application essentially, or the part contributing to the conventional technologies, or all or some of the technical solutions may be implemented in a form of a software product. The computer software product is stored in a readable storage medium and includes a plurality of instructions for instructing a computer device (which may be a personal computer, a server, or a network device, or the like) to perform all or some of the steps of the methods described in embodiments of this application. The readable storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An encoding method, wherein the method comprises:
obtaining an information bit sequence;
performing low-density parity-check LDPC encoding on the information bit sequence based on a parity-check matrix to obtain an encoded sequence, wherein a length of the encoded sequence is N₁, N₁ is n times 1944, n is an integer greater than or equal to 2, and the parity-check matrix has an expansion factor Z=81; and
outputting the encoded sequence.

2. A decoding method, wherein the method comprises:
obtaining to-be-decoded information, wherein a length of the to-be-decoded information is N₁, N₁ is n times 1944, and n is an integer greater than or equal to 2; and
performing low-density parity-check LDPC decoding on the to-be-decoded information based on a parity-check matrix to obtain an information bit sequence, wherein the parity-check matrix has an expansion factor Z=81.

3. The method according to claim 1 or 2, wherein a first column and a second column in a matrix corresponding to a parity bit in a matrix prototype of the parity-check matrix are obtained after diagonal extension or anti-diagonal extension is performed on both a first element and a last element in a first column in a matrix corresponding to the parity bit in a matrix prototype of a basic parity-check matrix, and a coding rate corresponding to the basic parity-check matrix is the same as a coding rate corresponding to the parity-check matrix.

4. The method according to any one of claims 1 to 3, wherein elements other than elements in the first column and the second column in the matrix corresponding to the parity bit in the matrix prototype of the parity-check matrix are obtained after diagonal extension is performed on an element 0 other than elements in the first column in the matrix corresponding to the parity bit in the matrix prototype of the basic parity-check matrix, and the coding rate corresponding to the basic parity-check matrix is the same as the coding rate corresponding to the parity-check matrix.

5. The method according to any one of claims 1 to 4, wherein a matrix corresponding to an information bit in the matrix prototype of the parity-check matrix is obtained after diagonal extension or anti-diagonal extension is performed on an element in an x^{th} row and a y^{th} column in a matrix corresponding to the information bit in the matrix prototype of the basic parity-check matrix, wherein the element in the x^{th} row and the j^{th} column is greater than or equal to 0, both x and y are positive integers, and the coding rate corresponding to the basic parity-check matrix is the same as the coding rate corresponding to the parity-check matrix.

6. The method according to any one of claims 1 to 5, wherein when a coding rate R of the information bit sequence is 1/2, the matrix prototype of the parity-check matrix is any one of the following matrices: 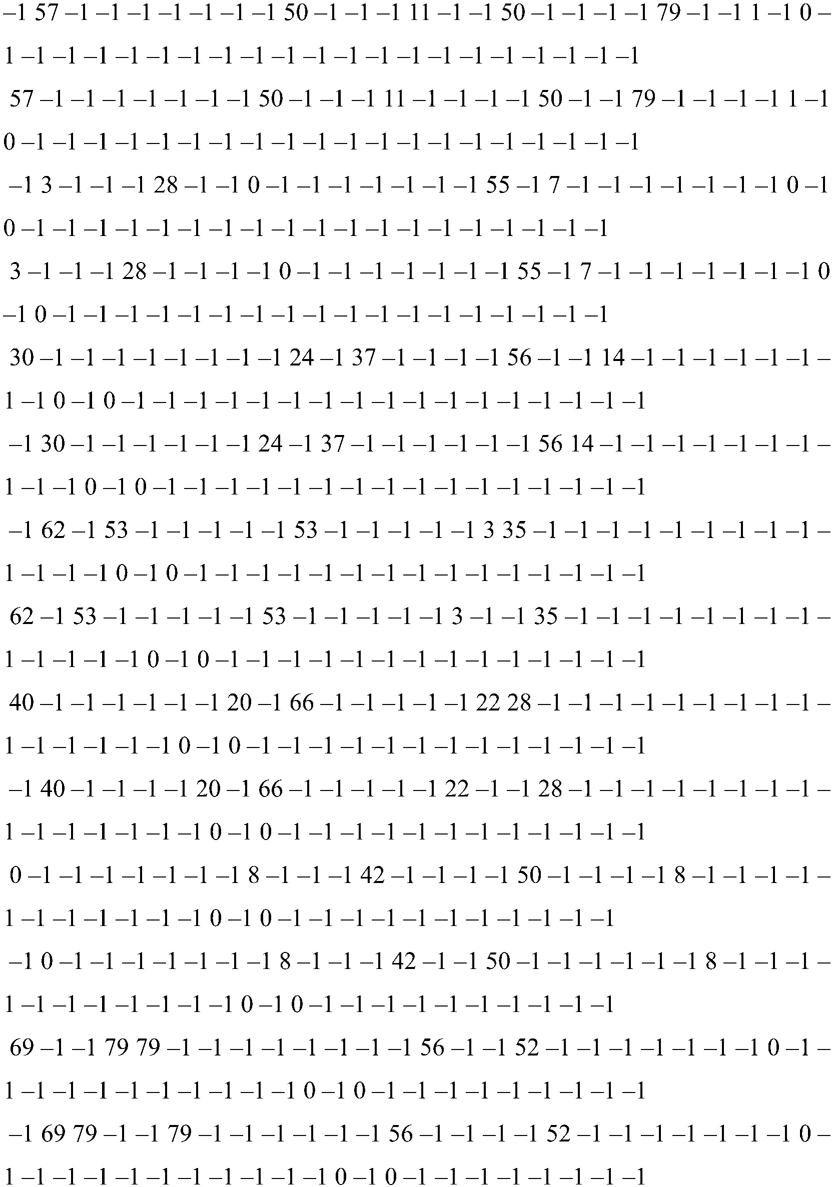 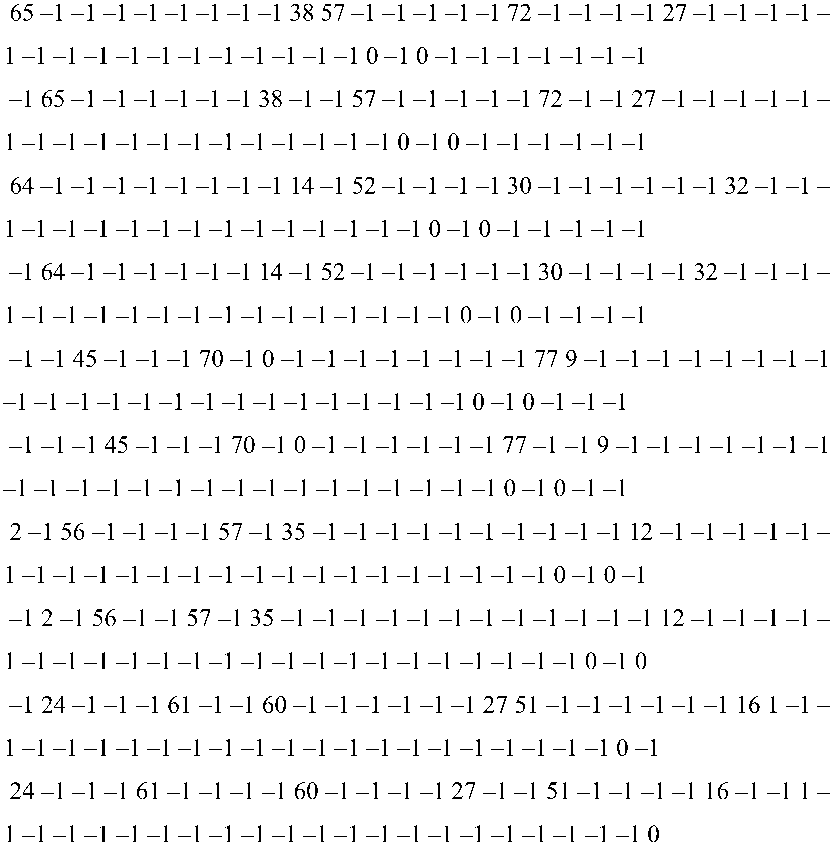 or, 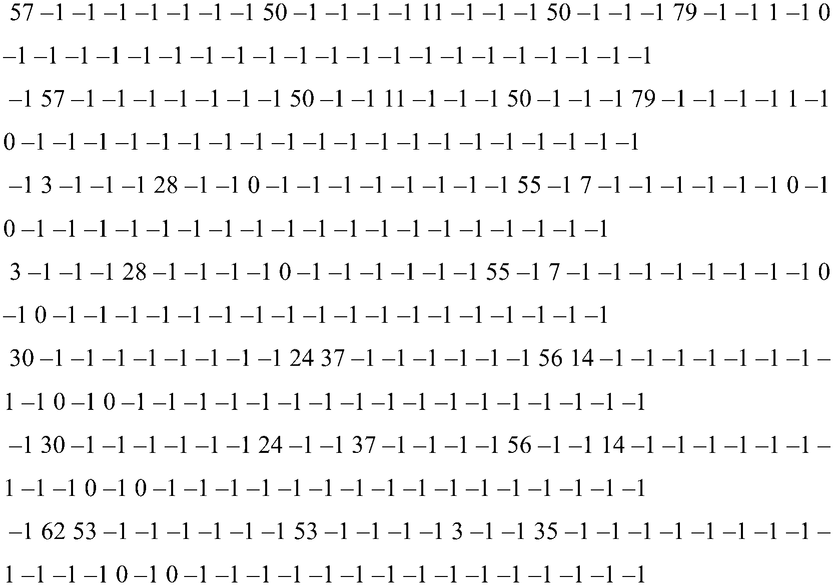 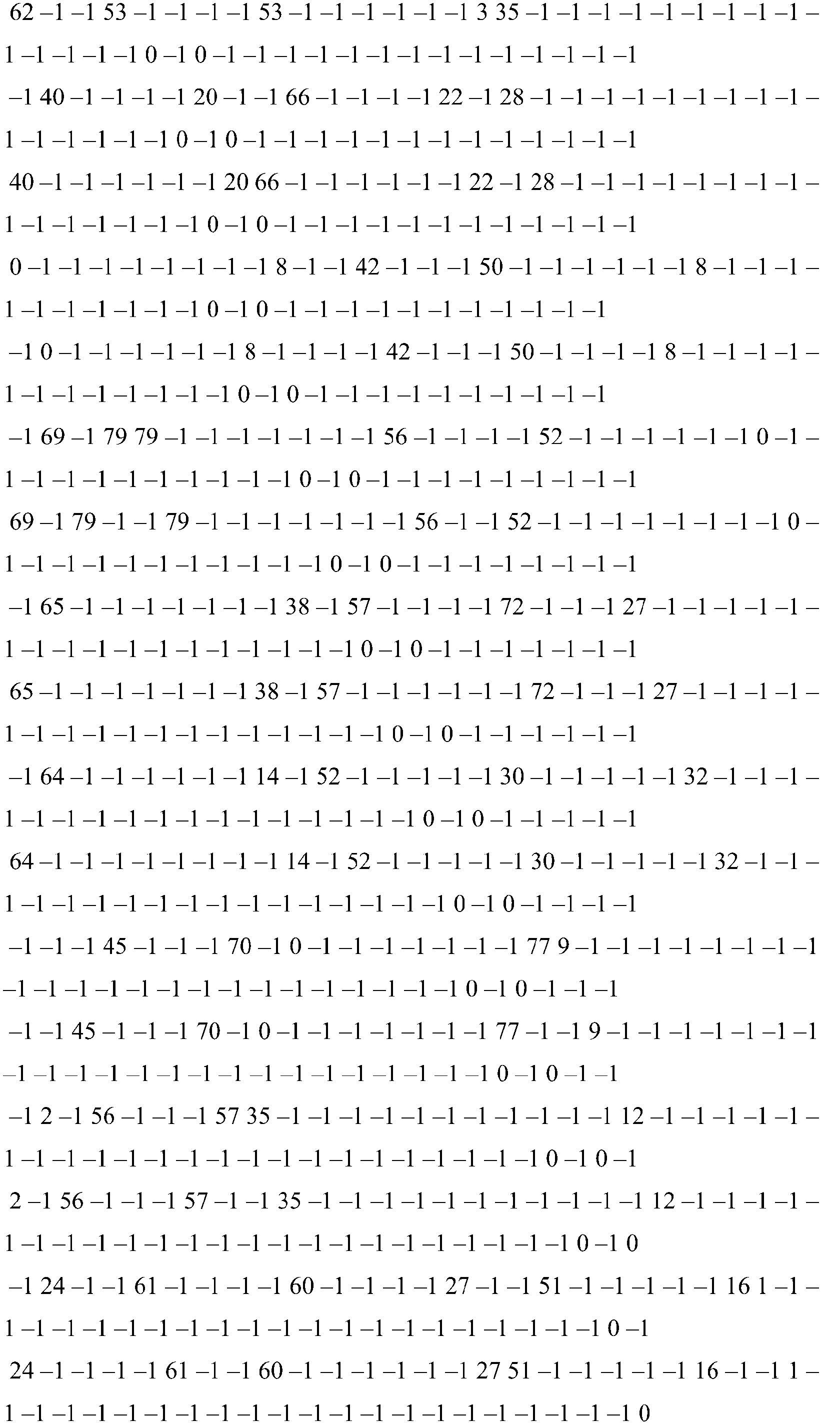 or, 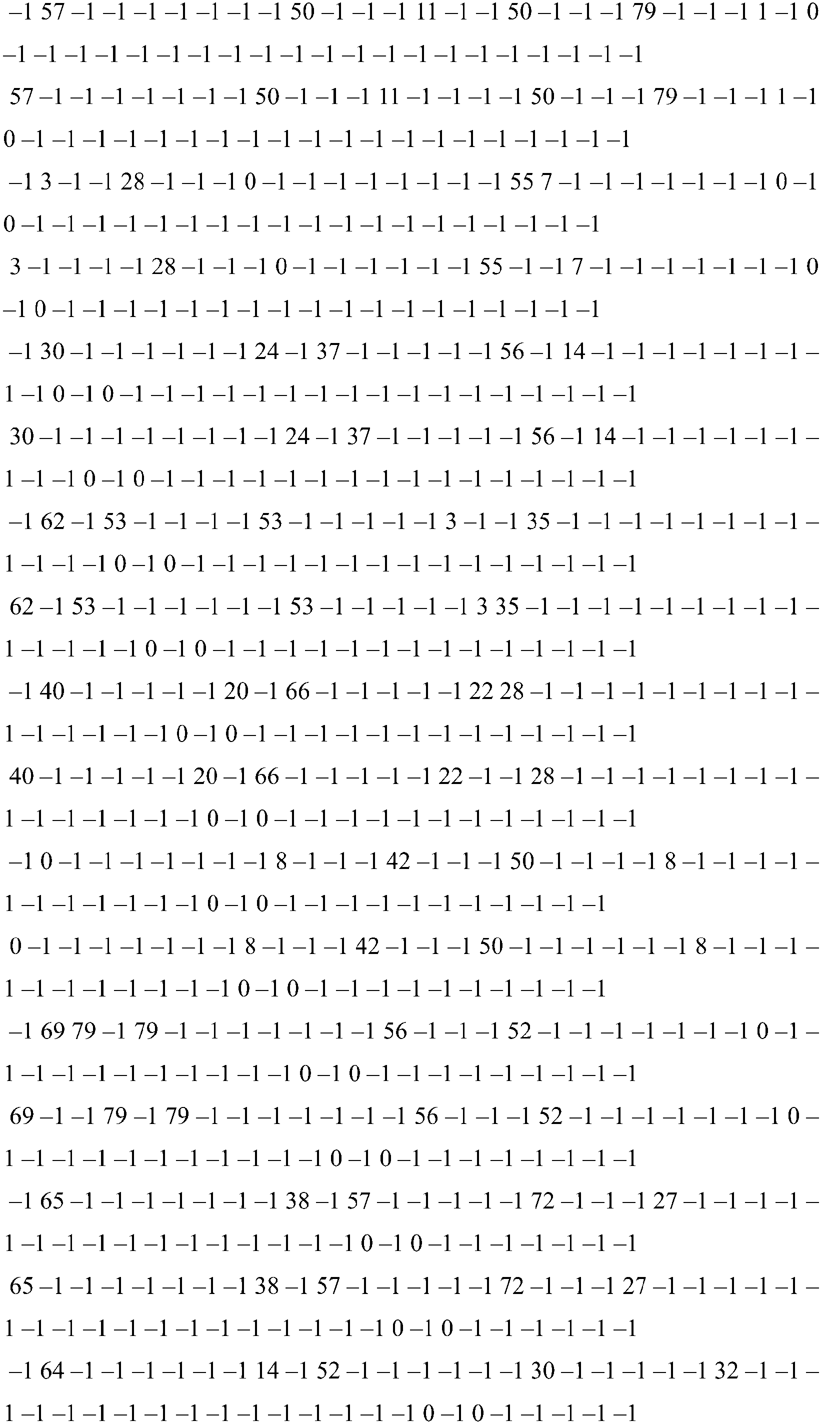 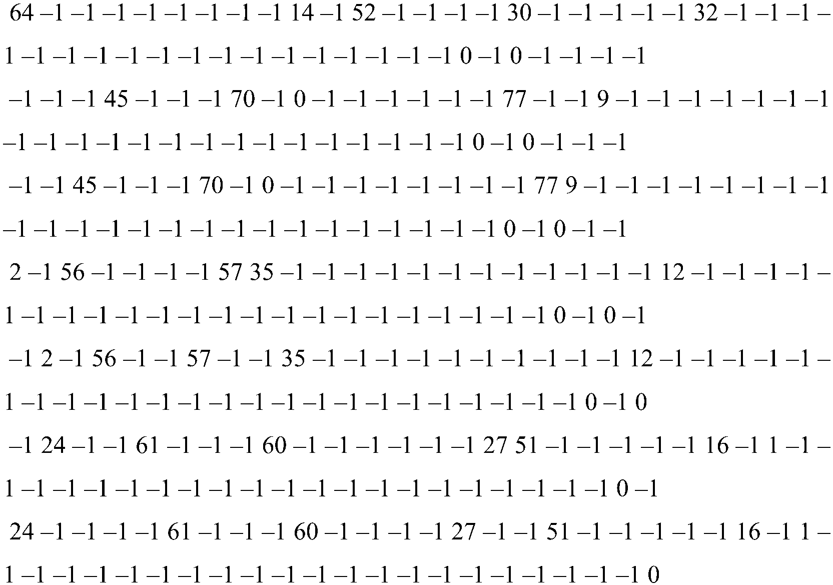 wherein -1 represents a Z*Z all-zero matrix, 0 represents a Z*Z unit matrix, and an element greater than 0 represents a circulant permutation matrix CPM of the Z*Z unit matrix.

7. The method according to any one of claims 1 to 5, wherein when a coding rate R of the information bit sequence is 2/3, the matrix prototype of the parity-check matrix is any one of the following matrices: 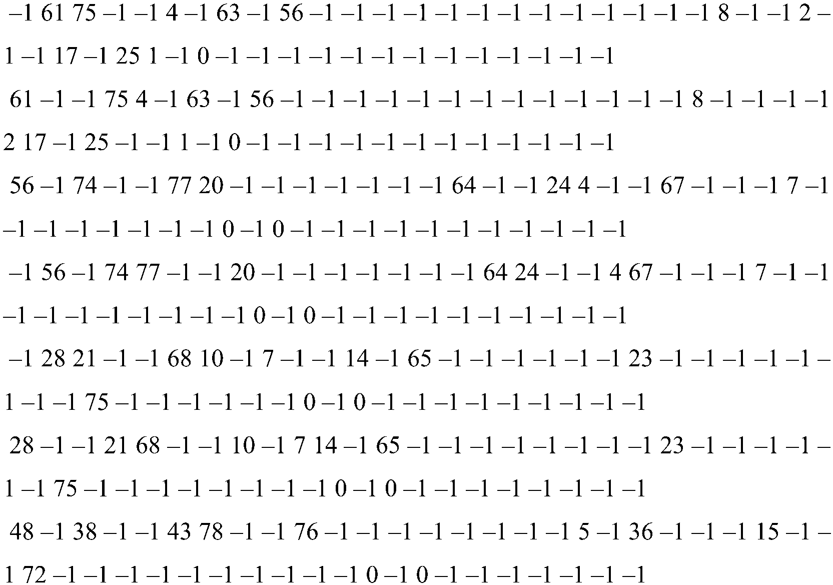 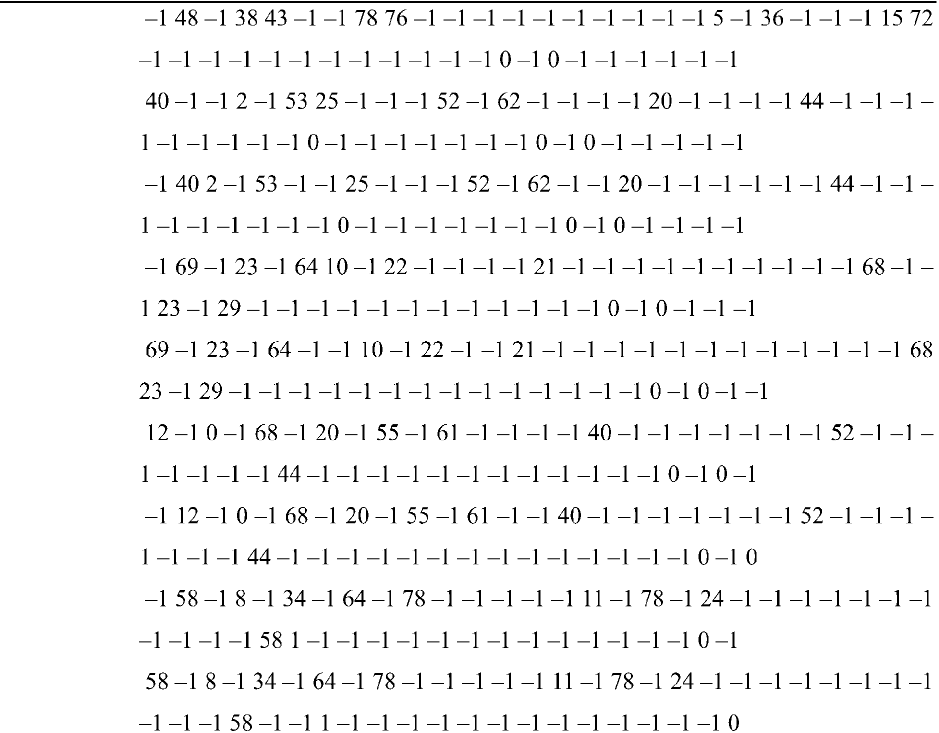 or, 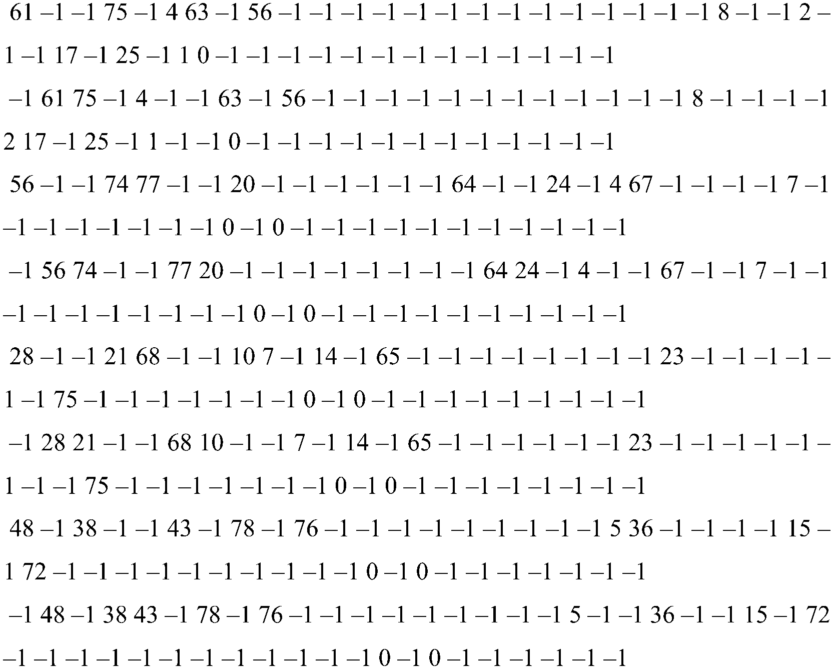 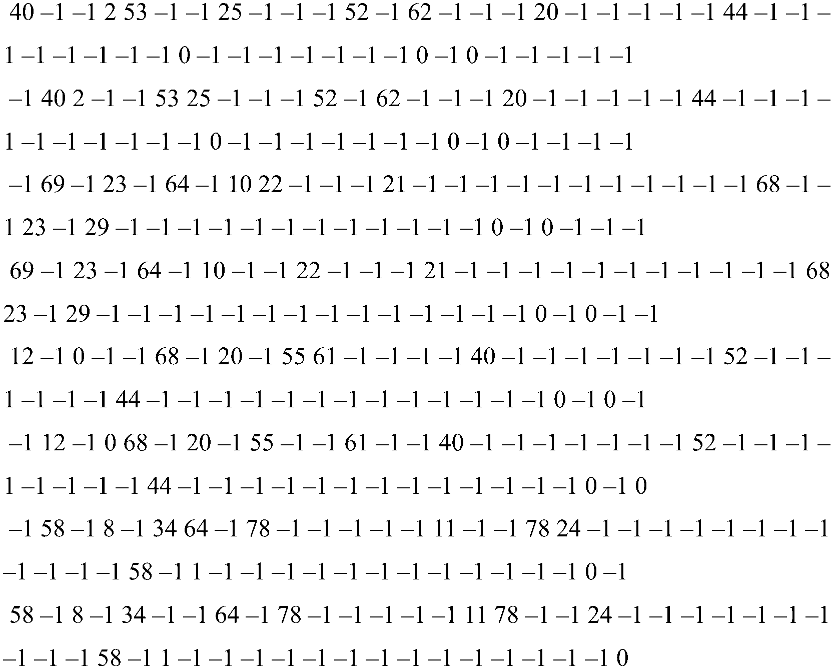 or, 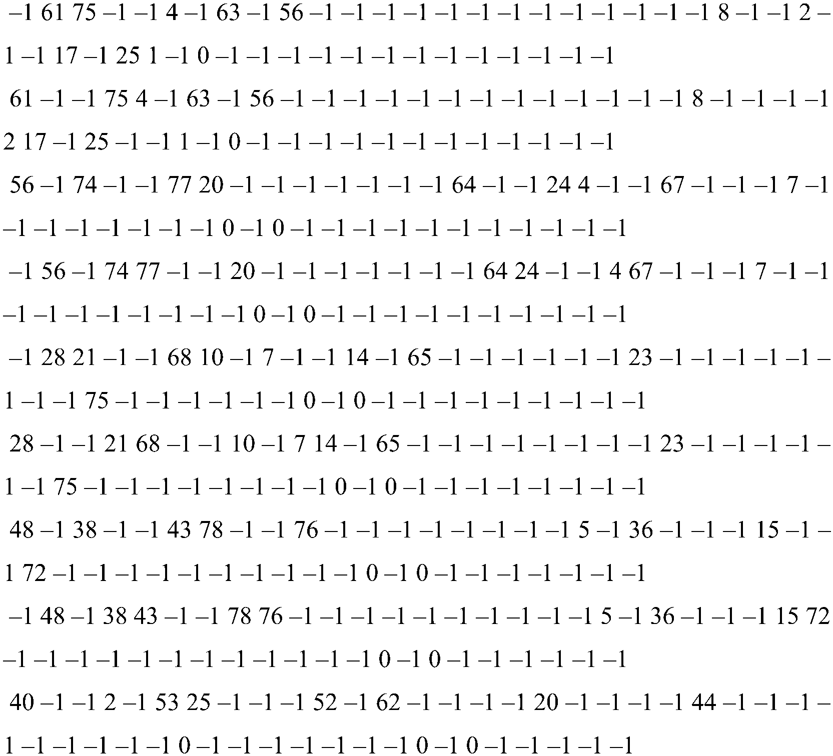 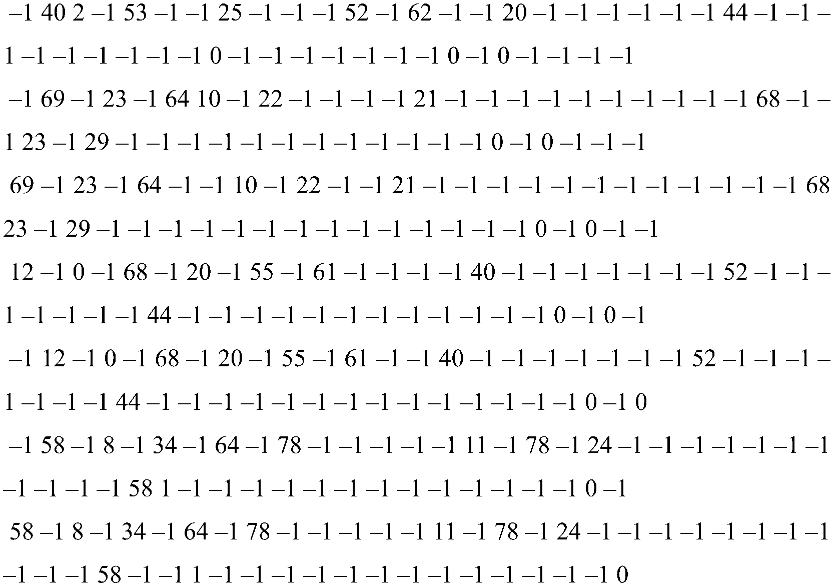 wherein -1 represents a Z*Z all-zero matrix, 0 represents a Z*Z unit matrix, and an element greater than 0 represents a circulant permutation matrix CPM of the Z*Z unit matrix.

8. The method according to any one of claims 1 to 5, wherein when a coding rate R of the information bit sequence is 3/4, the matrix prototype of the parity-check matrix is any one of the following matrices: 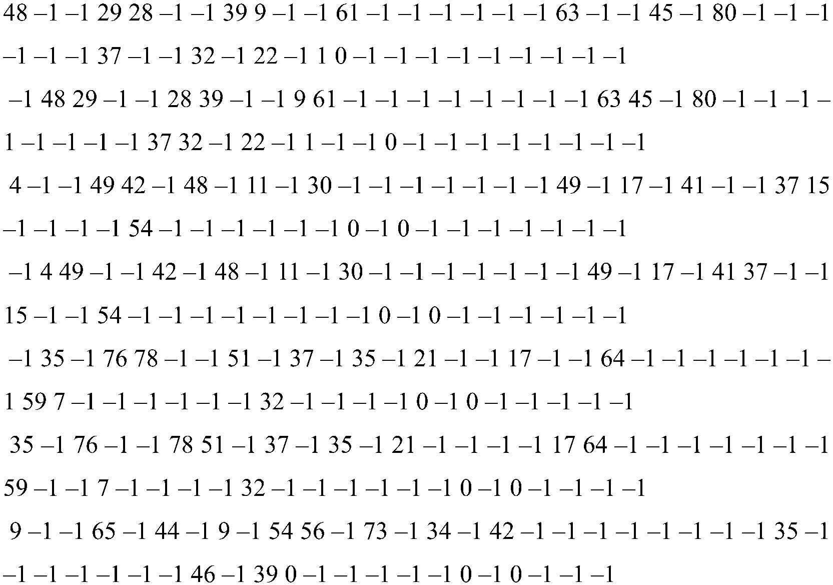 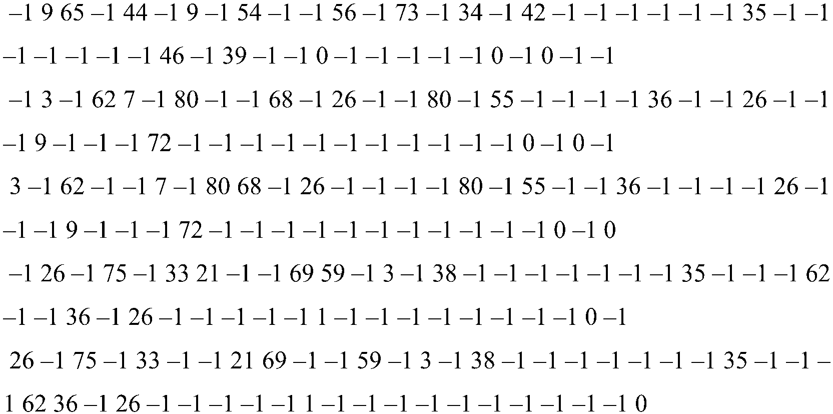 or, 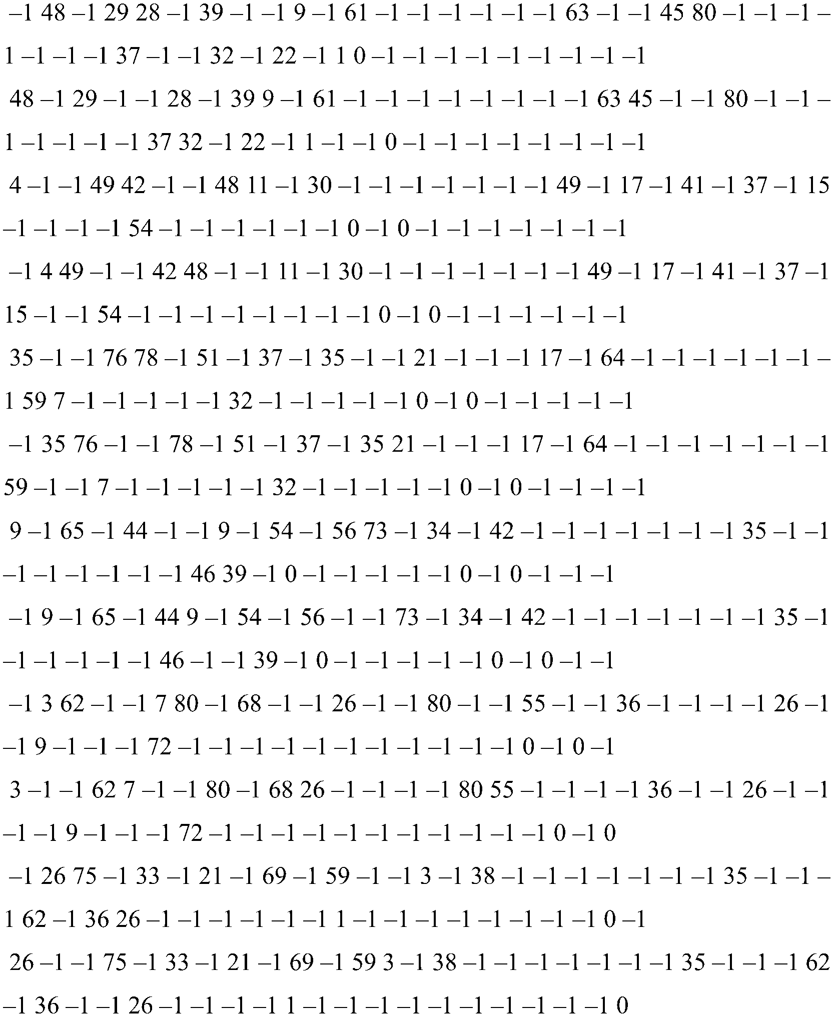 or, 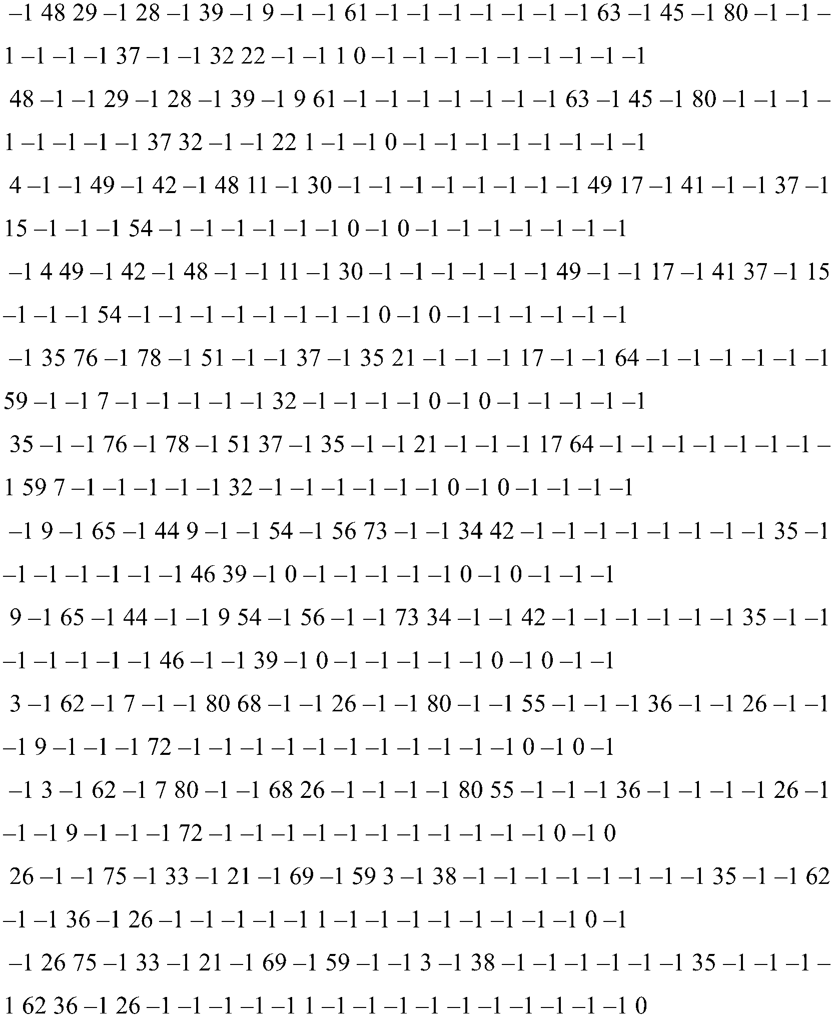 or, 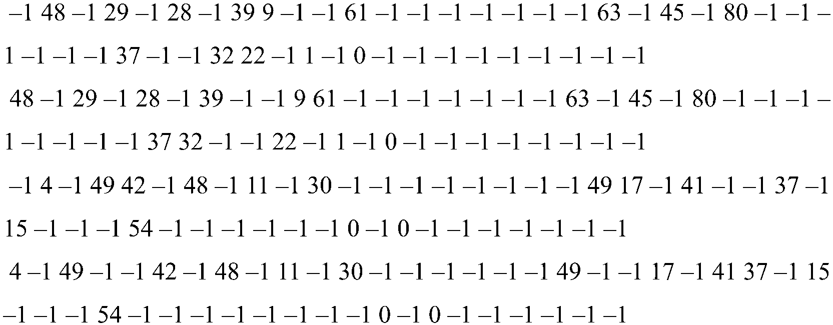 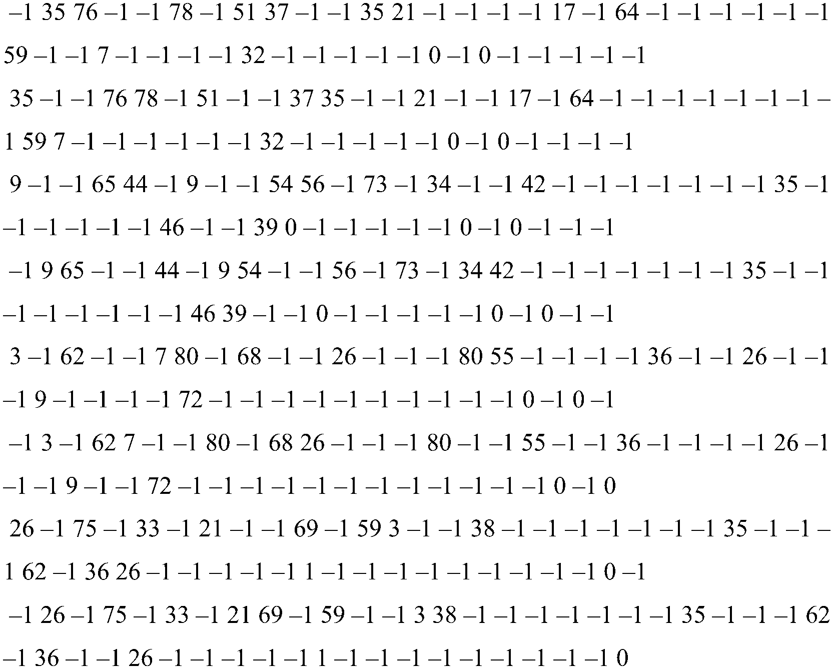 wherein -1 represents a Z*Z all-zero matrix, 0 represents a Z*Z unit matrix, and an element greater than 0 represents a circulant permutation matrix CPM of the Z*Z unit matrix.

9. The method according to any one of claims 1 to 5, wherein when a coding rate R of the information bit sequence is 5/6, the matrix prototype of the parity-check matrix is any one of the following matrices: 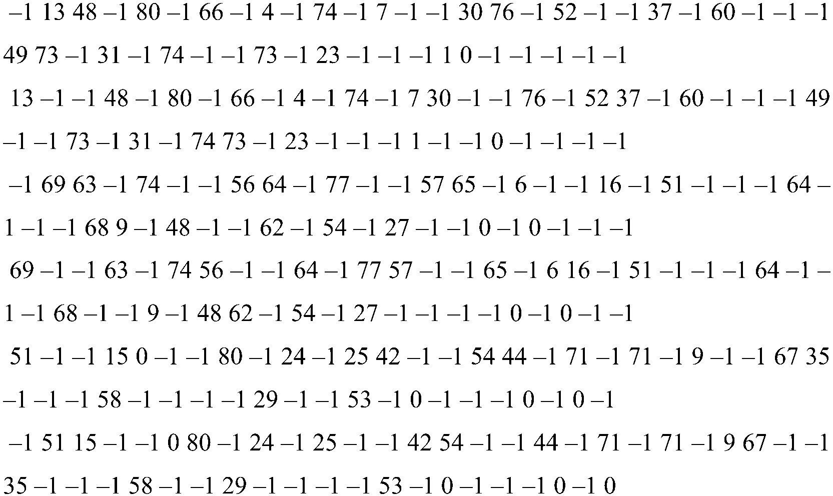 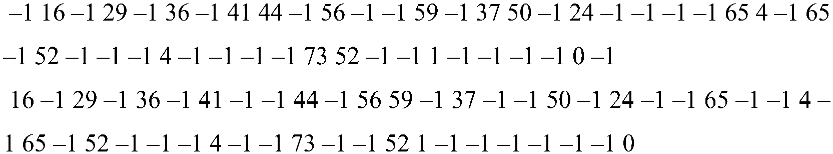 or, 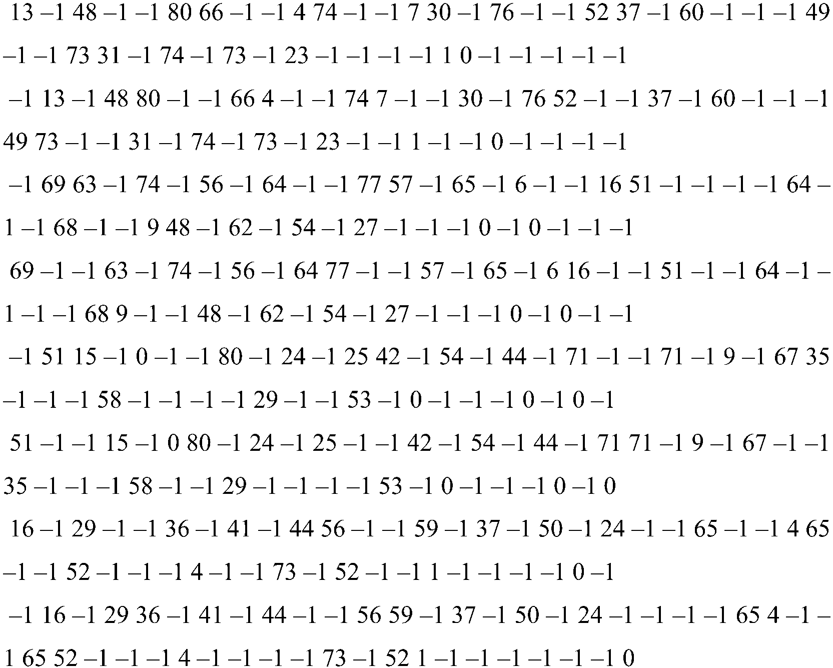 or, 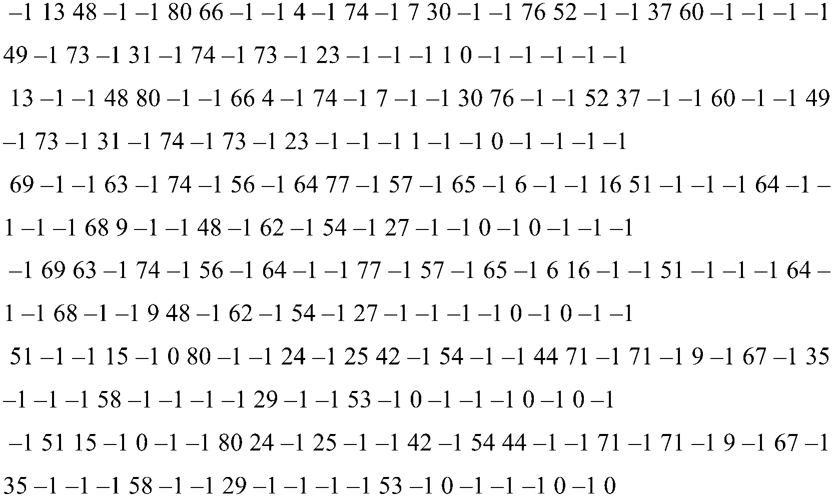 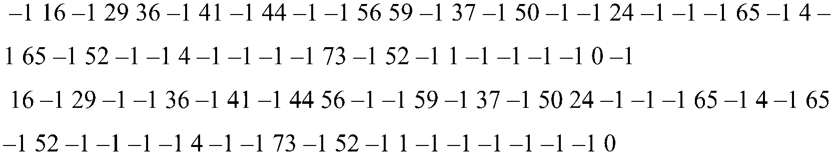 or, 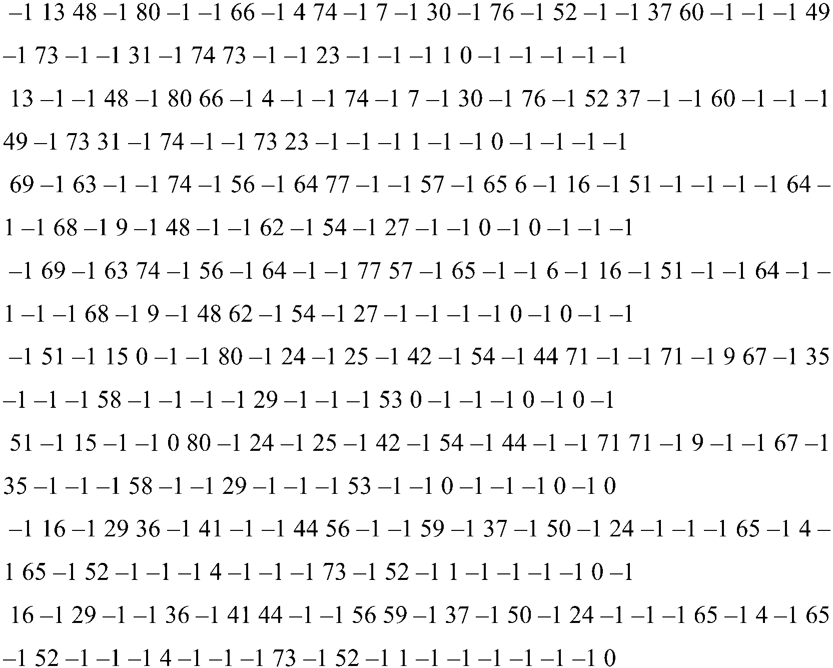 wherein -1 represents a Z*Z all-zero matrix, 0 represents a Z*Z unit matrix, and an element greater than 0 represents a circulant permutation matrix CPM of the Z*Z unit matrix.

10. The method according to any one of claims 1 to 5, wherein when a coding rate R of the information bit sequence is 1/2, the matrix prototype of the parity-check matrix is any one of the following matrices: 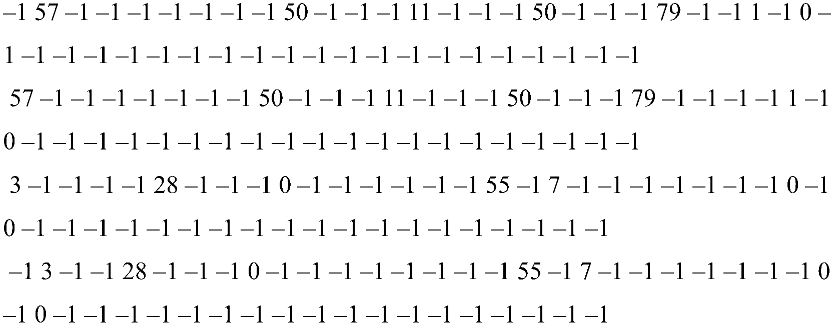 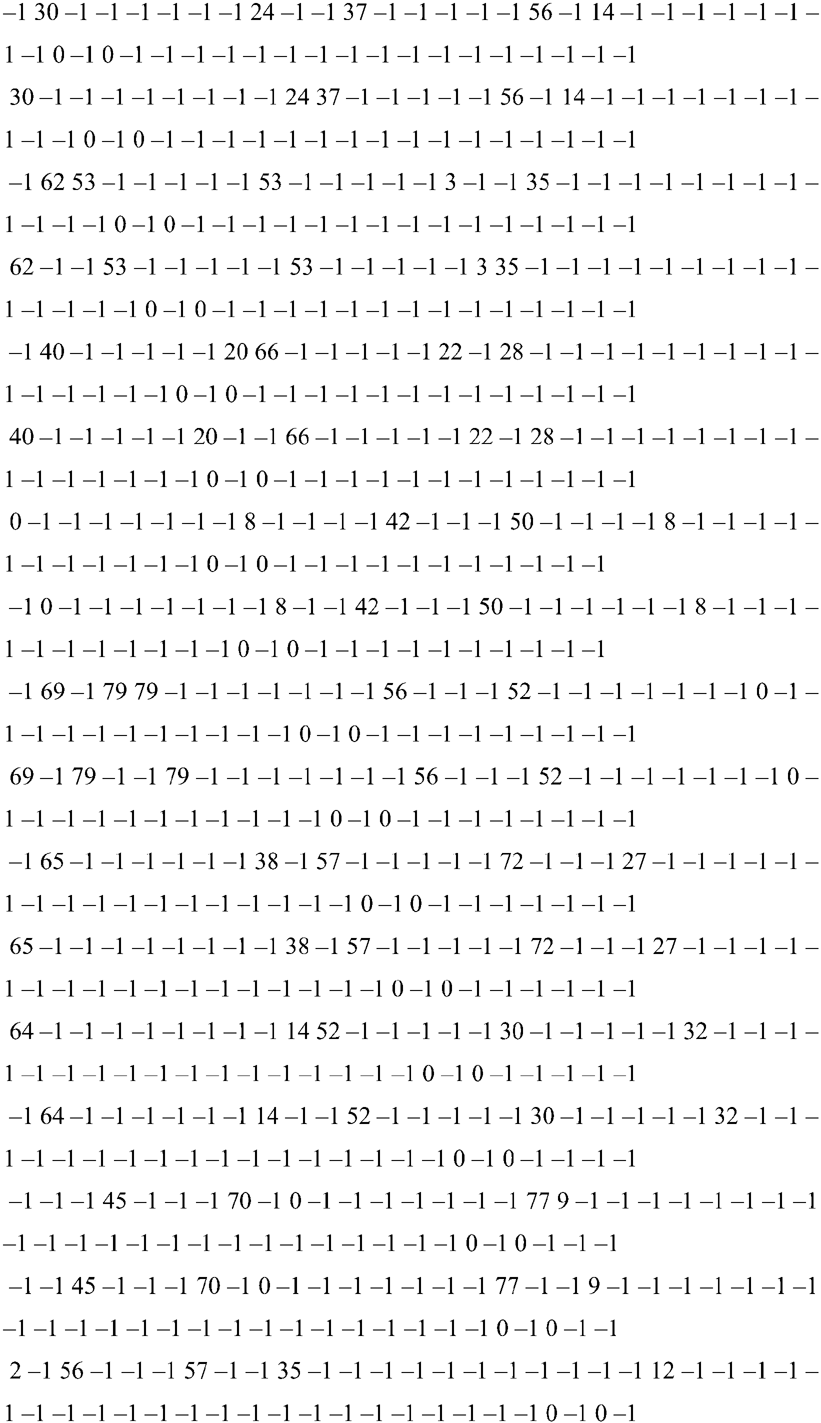 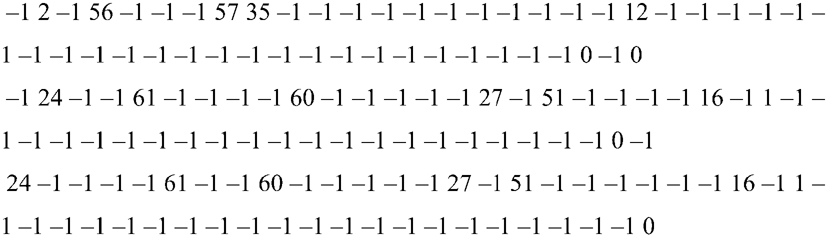 or, 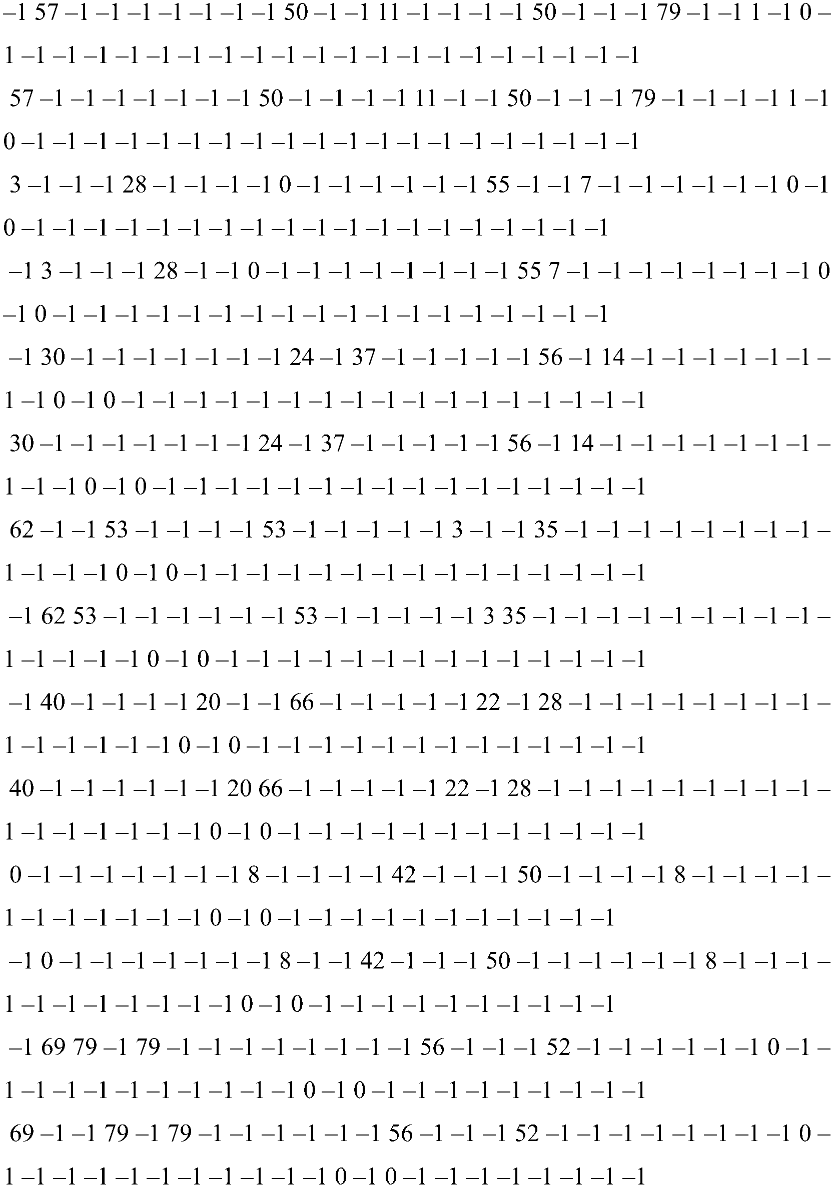 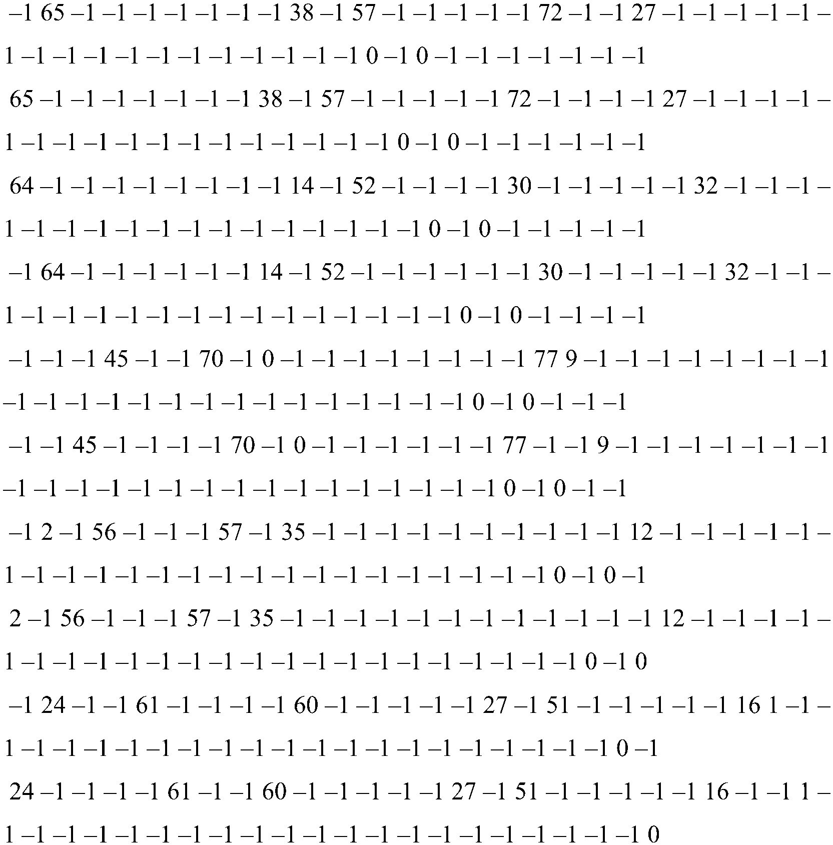 wherein -1 represents a Z*Z all-zero matrix, 0 represents a Z*Z unit matrix, and an element greater than 0 represents a circulant permutation matrix CPM of the Z*Z unit matrix.

11. The method according to any one of claims 1 to 5, wherein when a coding rate R of the information bit sequence is 2/3, the matrix prototype of the parity-check matrix is any one of the following matrices: 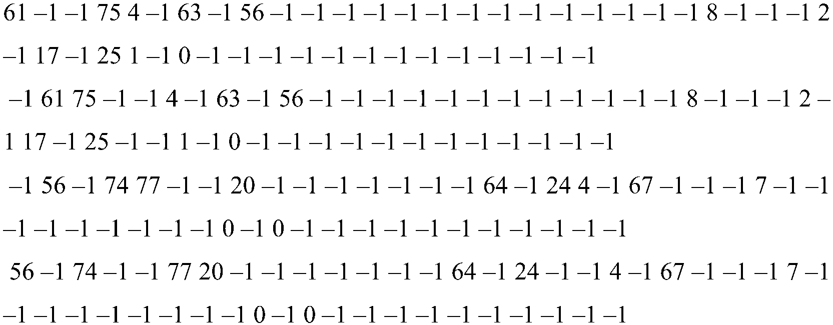 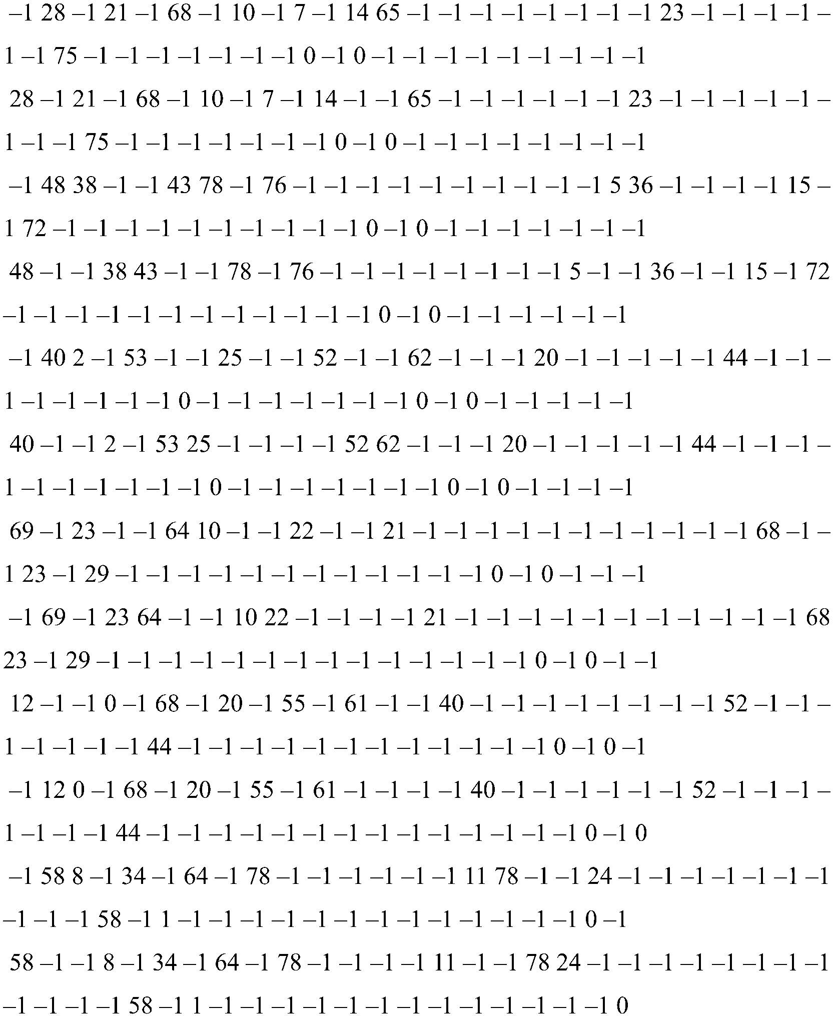 or, 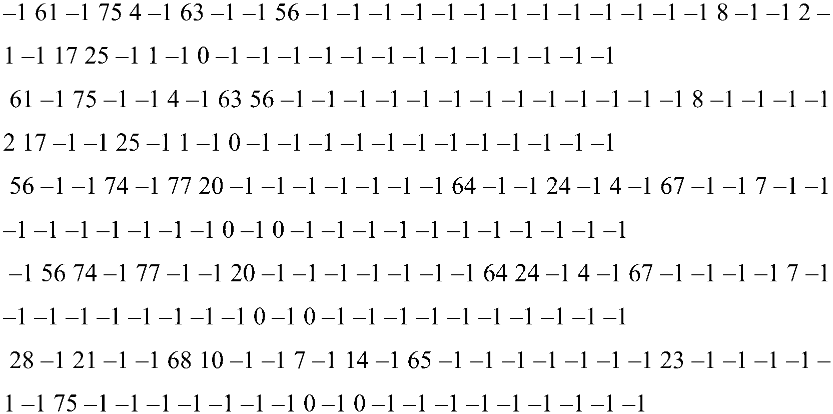 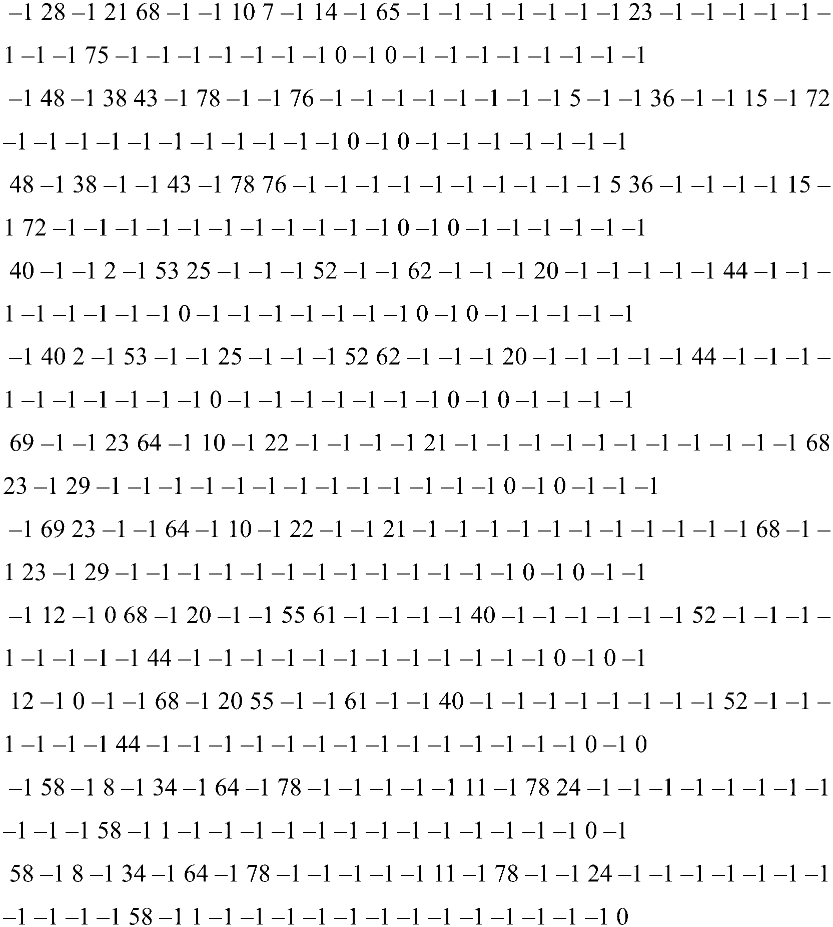 wherein -1 represents a Z*Z all-zero matrix, 0 represents a Z*Z unit matrix, and an element greater than 0 represents a circulant permutation matrix CPM of the Z*Z unit matrix.

12. The method according to any one of claims 1 to 5, wherein when a coding rate R of the information bit sequence is 3/4, the matrix prototype of the parity-check matrix is any one of the following matrices: 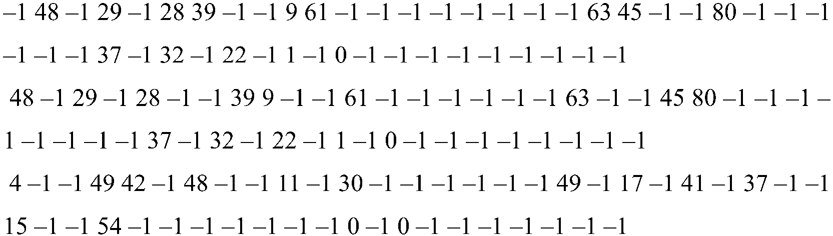 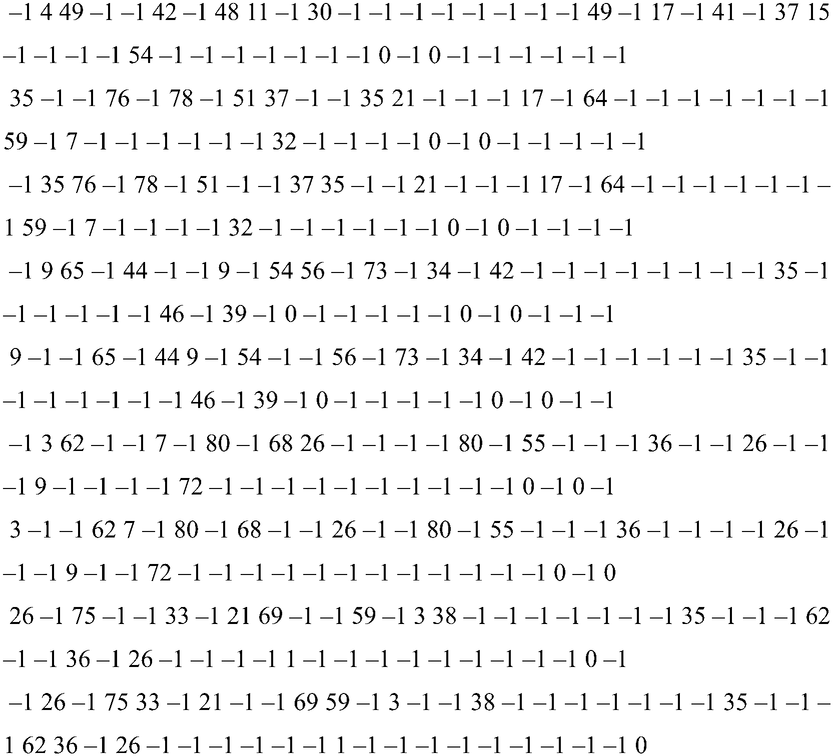 or, 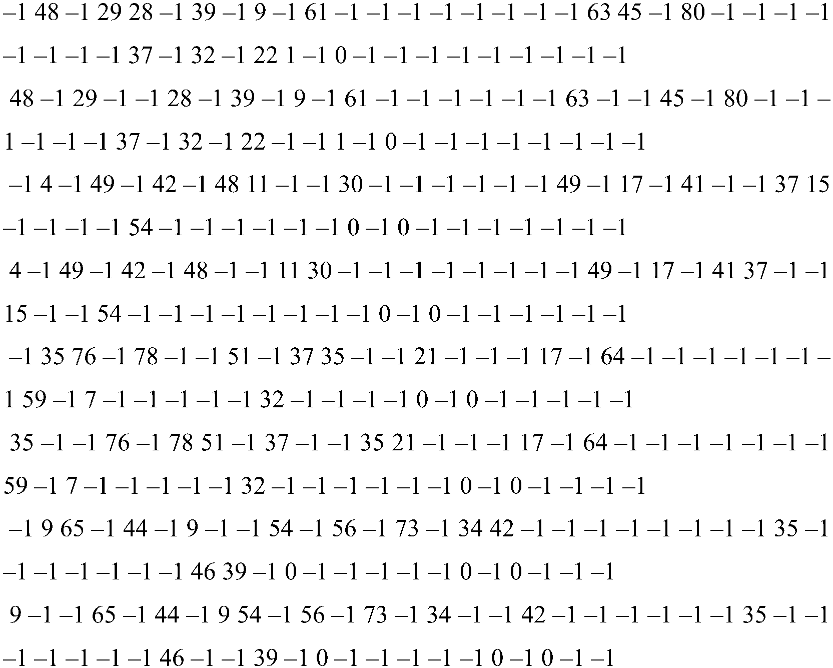 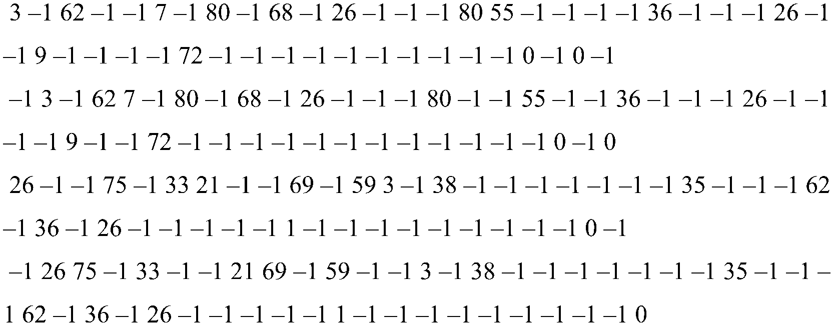 wherein -1 represents a Z*Z all-zero matrix, 0 represents a Z*Z unit matrix, and an element greater than 0 represents a circulant permutation matrix CPM of the Z*Z unit matrix.

13. The method according to any one of claims 1 to 5, wherein when a coding rate R of the information bit sequence is 5/6, the matrix prototype of the parity-check matrix is any one of the following matrices: 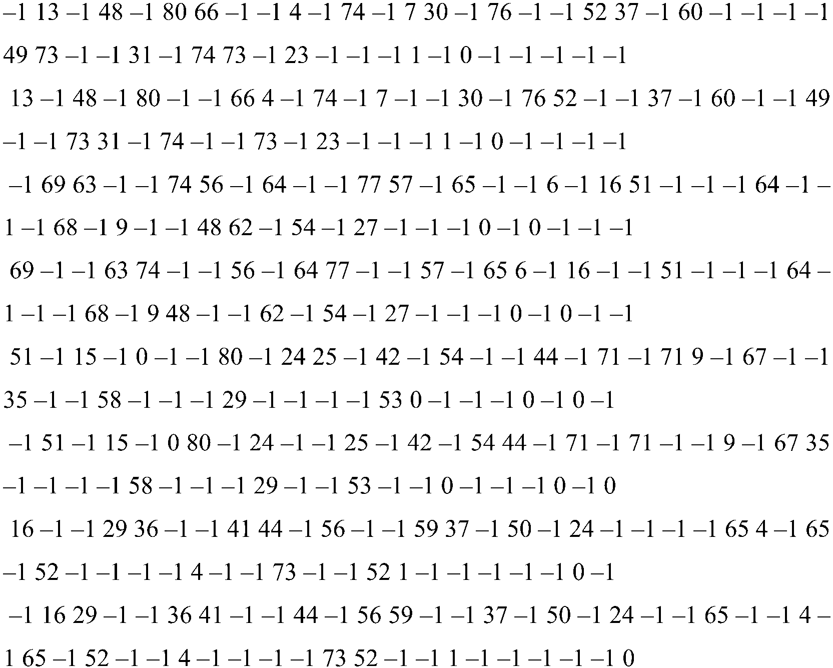 or, 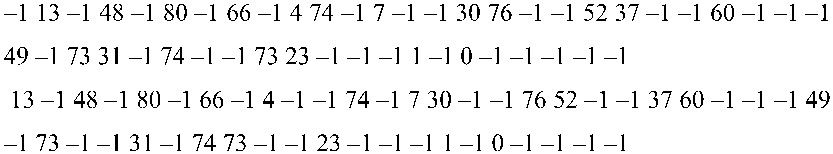 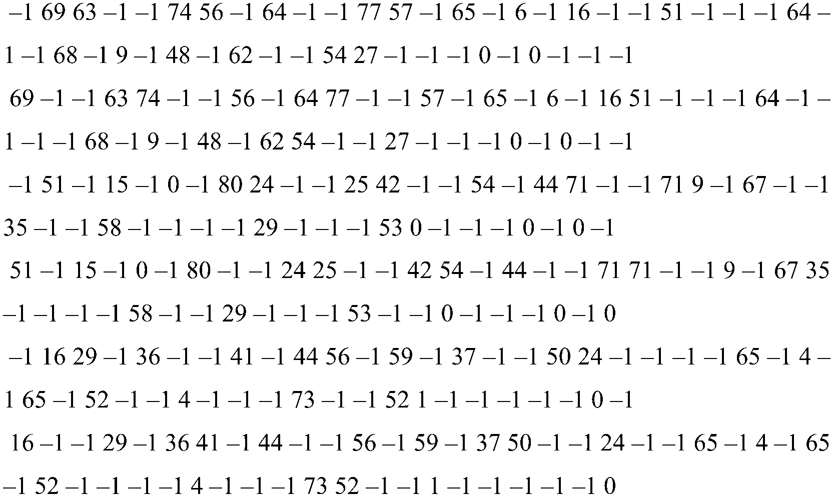 wherein -1 represents a Z*Z all-zero matrix, 0 represents a Z*Z unit matrix, and an element greater than 0 represents a circulant permutation matrix CPM of the Z*Z unit matrix.

14. A communication apparatus, comprising a module configured to perform the method according to any one of claims 1 to 13.

15. A communication apparatus, comprising a processor, wherein the processor is configured to perform the method according to any one of claims 1 to 13.

16. A communication apparatus, comprising a logic circuit and an interface, wherein
the logic circuit is coupled to the interface; and
the interface is configured to input and/or output information, and the logic circuit is configured to perform the method according to any one of claims 1 to 13.

17. A computer-readable storage medium, wherein the computer-readable storage medium is configured to store a computer program, and when the computer program is executed, the method according to any one of claims 1 to 13 is performed.

18. A computer program product, wherein when the computer program product is executed, the method according to any one of claims 1 to 13 is performed.

19. A communication system, wherein the communication system comprises a first communication apparatus and a second communication apparatus, the first communication apparatus is configured to perform the method according to any one of claims 1 and 3 to 13, and the second communication apparatus is configured to perform the method according to any one of claims 2 to 13.
